# EUROPEAN PATENT APPLICATION

(11) **EP 1 080 841 A2**
(43) Date of publication of application: **07.03.2001**
(21) Application number: 00118225.2
(22) Date of filing: 01.09.2000
(51) Int. Cl.: B24B 37/04, B24B 41/06, B24B 49/10, B24B 49/16

(54) **Carrier head, polishing apparatus using the carrier head, and method for sensing polished surface state**

(30) Priority: 02.09.1999 JP 24918899; 19.10.1999 JP 29746699; 02.11.1999 JP 31308499; 18.11.1999 JP 32881699; 14.03.2000 JP 2000071210; 15.03.2000 JP 2000073092; 15.03.2000 JP 2000073093; 29.03.2000 JP 2000092356
(71) Applicant: MITSUBISHI MATERIALS CORPORATION, Chiyoda-ku, Tokyo 100-8117 (JP)
(72) Inventor: Kobayashi, Tatsunori, Central Research Institute, Omiya-shi, Saitama-ken (JP); Tanaka, Hiroshi, Central Research Institute, Omiya-shi, Saitama-ken (JP); Rikita, Naoki, Central Research Institute, Omiya-shi, Saitama-ken (JP); Morita, Etsuro, Mitsubishi Materials Silicon Corp., Tokyo (JP); Harada, Seiji, Mitsubishi Materials Silicon Corp., Tokyo (JP)
(74) Representative: HOFFMANN - EITLE

(57) **Abstract**

The present invention provides a polishing head comprising a head body (62) having an upper mounting plate (bridge) (67) and a cylindrical circumference wall (68) provided at downward of the outer circumference of the upper mounting plate (67), a diaphragm (63) provided in the head body (62), a disk-shaped carrier (64) secured to the diaphragm (63), a first pressure adjustment mechanism (65) for adjusting the pressure of a liquid filled in a fluid chamber (73) formed between the carrier (64) and the head body (62), and a retainer ring (75) disposed in concentric relation between the lower face of the carrier (64) and the inner wall of the circumference wall (68), wherein the retainer ring is fixed to the carrier, an elastic membrane is disposed on the lower face of the carrier, the elastic membrane is secured by inserting its circumference edge between the retainer ring and the carrier, a fluid feed passage for feeding a pressure variable fluid between the elastic membrane and the carrier is provided in the carrier.

## Description

### BACKGROUND OF THE INVENTION

### Field of the Invention

The present invention relates to a polishing head that is applied for polishing the surface of a polishing object having a planar surface such as a virgin silicon wafer and a semiconductor wafer used in semiconductor manufacturing processes, or a heard disk substrate and a liquid crystal substrate, as well as to a polishing apparatus using the polishing head, and to a method for sensing the polished surface state.

The specification of the present invention is based on Japanese Patent Applications (Japanese Patent Application Nos. 11-249188, 11-297466, 11-313084, 11-328816, 2000-071210, 2000-073092, 2000-073093 and 2000-092356), and the descriptions thereof written in Japanese are incorporated herein as a part of the specification of the present invention.

### Description of the Related Art

It has been crucial to planarize the surface of a semiconductor wafer as much as possible in compliance with recent requirements of fine patterning accompanied by the advance of highly integrated semiconductor manufacturing apparatus. For example, while patterns are formed by photolithography, the depth of focus in photolithography is being shortened as the patterns are made fine. Consequently, it is also required to restrict the difference of the levels between the concave portion and convex portion on the surface of a wafer (or planarization) within the depth of focus in order to secure an accuracy of the pattern, or to facilitate focal adjustment during exposure. Bare wafers are also strictly required to be polished with high degree of planarity as the diameter of the wafer is increased (although the wafers are cited herein, the surface of polishing objects other than the wafers such as, for example, the hard disk substrate and liquid crystal substrate are also required to be polished with a high degree of planarity).

A chemical mechanical polishing (CMP) method has been highlighted for the purpose above from the viewpoint that the degree of planarity can be enhanced by polishing the surface membrane and thereby the membrane can be embedded in recesses on the surface.

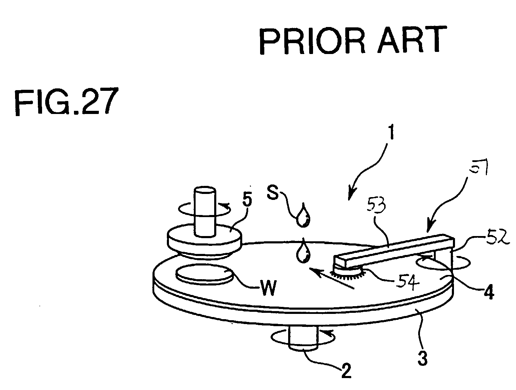

The surface of the wafer is planarized by chemical mechanical polishing using a slurry such as an alkaline slurry containing SiO₂, a neutral slurry containing CeO₂, an acidic slurry containing Al₂O₃ and a slurry containing abrasive particles in the CMP method. An example of the apparatus for polishing the surface of the wafer by the CMP method is shown in Fig. 27 as an enlarged perspective view of the main part of the polishing apparatus.

The polishing apparatus **1** illustrated in Fig. 27 comprises a polishing pad **4** made of, for example, a hard polyurethane provided on a circular platen **3** attached to a center axis **2**, and a polishing head **5**, which rotates by being driven by a head drive mechanism (not shown), opposing to the polishing pad **4** and disposed at a position being in eccentric relation to the center axis **2** of the platen **3**.

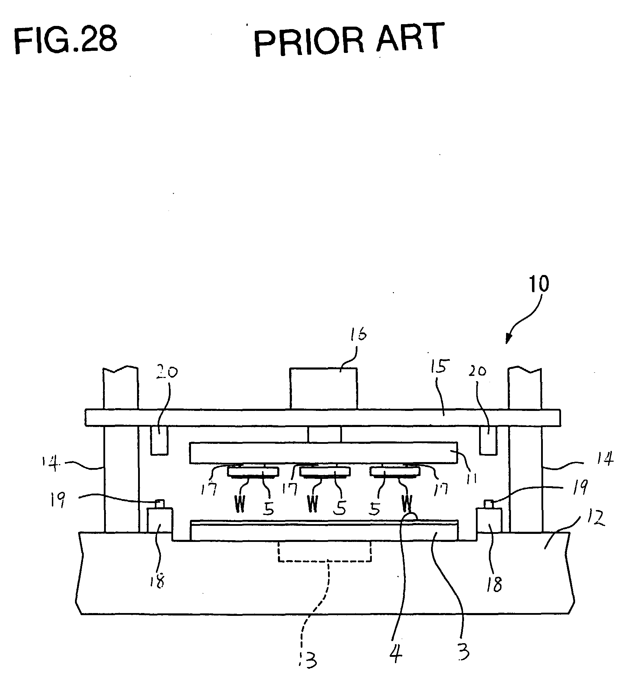

Fig. 28 also shows an another apparatus for polishing the surface of the wafer by the CMP method. The members in Fig. 28 configured to be approximately the same as those in the polishing apparatus **1** shown in Fig. 27 will be described hereinafter with reference to the same reference numerals.

The polishing apparatus **10** shown in Fig. 28 comprises a wafer polishing head **5** retaining the wafer **W** to be polished, and a polishing pad **4** adhered over the entire surface of a disk-shaped platen **3**. Each of plural wafer polishing heads **5** provided at the bottom of a carousel **11** is supported by a spindle **17** so as to be able to freely rotate, and allowed to undergo a planetary motion on the polishing pad **4**. It is also possible in this case to provide the center of the platen **3** to be in eccentric relation with respect to the center of rotation of the wafer polishing head **5**.

The platen **3** is horizontally placed at the center of a base **12**, and is allowed to rotate around its axis line by a platen drive mechanism **13** provided in the base **12**. A guide posts **14** is provided at each side of the base **12**, while an upper mounting plate **15** for supporting a carousel drive mechanism **16** is placed between the guide posts **14**. The carousel drive mechanism **16** functions for allowing the carousel **11** provided below it to rotate around the axis line.

A locking member **18** is provided so as to protrude out of the base **12**, and a space adjustment mechanism **19** is formed on the upper end of the locking member **18**. A stopper **20** is provided above the locking member **18** in opposed relation to the locking member. This stopper **20** is secured on the upper mounting plate **15** besides protruding downward out of the upper mounting plate **15**. The distance between the wafer polishing head **5** and the polishing pad **4** can be properly adjusted by allowing the locking member **18** to contact the stopper **20**. The wafer **W** is polished by bringing the wafer **W** retained on the wafer polishing head **5** in contact with the surface of the polishing pad **4** while the carousel **11** and the platen **3** are rotating.

Examples of this kind of polishing head include the polishing heads for polishing the surface of the semiconductor wafer cut from an silicon ingot. A floating type polishing head has been particularly proposed in recent years among the polishing heads described above, wherein the wafer is directly supported by an elastic membrane provided so as to be able to inflate and deflate along the direction of the head axis, whereby the back-pressure of the polishing head to the wafer polishing pad is made to be freely adjustable via the membrane.

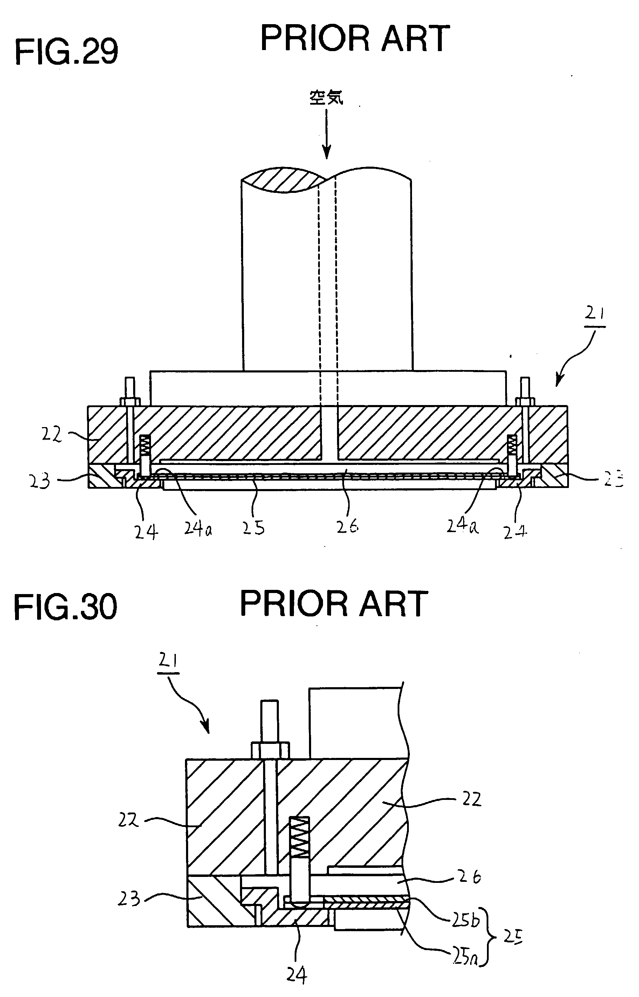

Figs. 29 and 30 show an example of a floating type polishing pad via a membrane. Figs. 29 and 30 represent a vertical cross section and an enlarged drawing thereof, respectively, of the polishing head **21** disclosed in Japanese Unexamined Patent Application Publication No. 10-294298. As shown in the drawings, the polishing head **21** is configured so that an annular top ring **23** is provided at the circumference of the lower face of the head body **22**, and a retainer ring **24** is provided at the inside of the top ring **23** in concentric relation to the top ring. A pressurizing plate **25** is loosely fitted on the upper face **24a** of the retainer ring **24**, and the space surrounded by the top ring **23**, retainer ring **24** and pressurizing plate **25** serves as an air chamber **26**.

The lower face side (not shown) of the polishing head **21** is pressed onto the polishing head while the wafer is absorbed on the lower face of the pressurizing plate **25**, when the wafer is polished using the polishing head **21**. The back-pressure for polishing may be optimized by adjusting the pressure of the wafer onto the polishing pad via the pressurizing plate **25**.

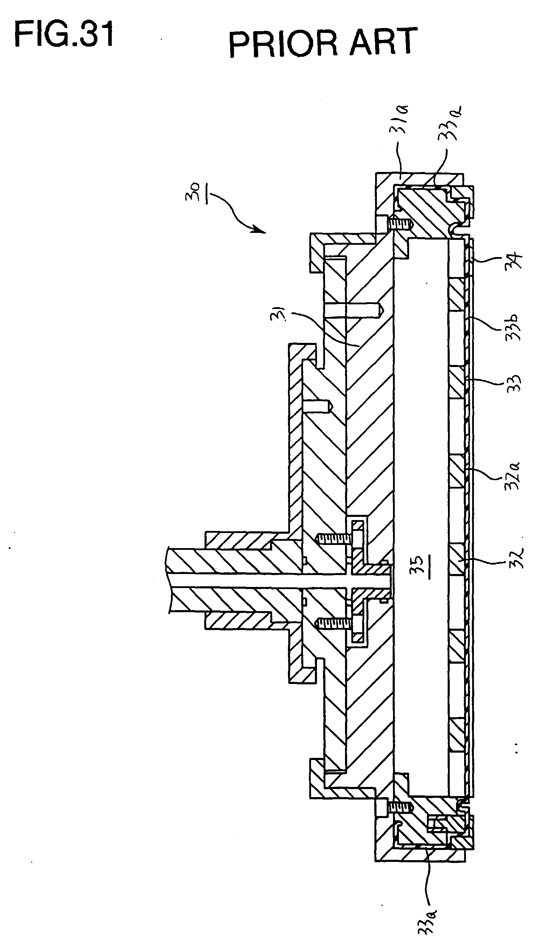

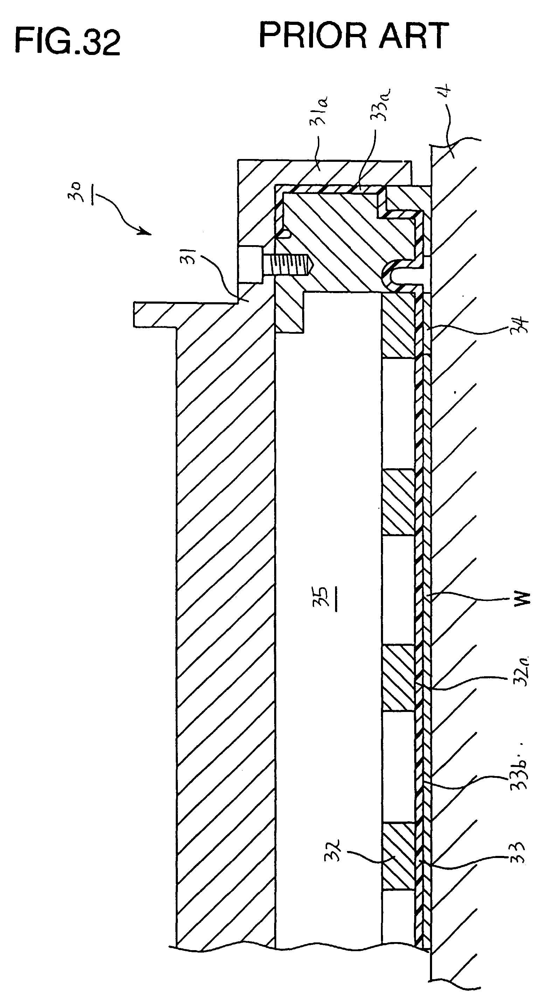

An another example of the floating type polishing head **30** via the membrane is shown in Figs. **31** and **32**, which are a vertical cross section and an enlarged drawing thereof, respectively, of the polishing head disclosed in USP No. 5,624,299. A porous plate **32** is placed so as to cover the lower face of a hollow tube type head body **31** having a closed upper face and open lower face, and a membrane **33** is provided so as to cover the lower face **32a** of the porous plate **32**. The peripheral edge **33a** of the membrane **33** is fixed to the inner wall **31** of the head body **31**, and a retainer ring **34** for retaining the circumference of the wafer to be retained is fixed on the lower face **33b** of the membrane **33**.

The wafer **W** (see Fig. 32) is retained on the area surrounded by the retainer ring **34** on the lower face **33b** of the membrane **33** while allowing the lower face of the polishing head **30** to contact the polishing pad **4** (see also Fig. 32), when the wafer is polished using the polishing head **30**. Simultaneously, an inner pressure of the chamber **35** is applied to the wafer via the membrane **33** by feeding air into the chamber **35** surrounded by the head body **31** and the membrane **33**, thereby adjusting the back-pressure of the polishing head **30** onto the polishing head.

The polishing heads **21** and **30** are configured so that the pressure in the air chamber **26** or the chamber **35** is applied on the wafer via the pressurizing plate **25** or the membrane **33** having a relatively small rigidity. Consequently, a back-pressure may be applied onto the wafer by allowing the pressurizing plate **25** or the membrane **33** to relax distortion of the wafer, even when the wafer has an uneven shape. Accordingly, it is made possible to polish the wafer under a low pressure.

Japanese Unexamined Patent Application Publication No. 8-229804 discloses a polishing head as shown in Fig. 33.

The wafer polishing head **40** (a polishing head) comprises a head body **43** composed of a top-plate **41** and a cylindrical circumference wall **42** fixed at the outer circumference of the top-plate **41**, a diaphragm **44** made of an elastic material such as rubber and expanded throughout the inside of the head body **43**, a pressure adjustment mechanism **46** for adjusting the pressure in a fluid chamber **48** formed between the head body **43** and the diaphragm **44**, a circular carrier **45** fixed on the lower face of the diaphragm **44**, and an annular retainer ring **47** placed at the outer circumference of the carrier **45** and disposed to be in concentric relation to the carrier.

The carrier **45** and the retainer ring **47** are secured to a carrier fixing ring **49** and a retainer ring fixing ring **50**, respectively, provided on the upper face of the diaphragm **44**, and the retainer ring **47** is arranged in concentric relation with a slight gap between the outer circumference face and circumference wall **42** of the carrier **45**. The slight gap is provided because the movable range of the retainer ring **47** may be prevented from being too large by elastic deformation of the diaphragm **44**.

The wafer **W** adheres onto a wafer adhesion sheet **P** provided on the lower face of the carrier **45** for polishing while the outer circumference of the wafer is blocked with the retained ring **47**. The surface of the wafer **W** contacts the polishing pad **4** adhered on the upper face of the platen **3**, and the surface of the wafer is polished by rotation of the wafer polishing head **40** while feeding the slurry as hitherto described.

The carrier **45** and the retainer ring **47** have a floating structure by which the two members are able to independently displace upward and downward by elastic deformation of the diaphragm **44**. In other words, the back-pressure of the carrier **45** and the retainer ring **47** onto the polishing pad **4** is made to be variable depending on the pressure inside of the fluid chamber **48** adjusted by the pressure adjustment mechanism **46**.

However, the polishing heads **21** and **30** as hitherto described involve the following problems.

Since the pressurizing plate **25** is loosely fitted on the retainer ring **24** in the polishing head **21** shown in Figs. 29 and 30, the pressurizing plate **25** has a double layer structure in which a metal plate **25a** and an elastic plate **25b** made of a rubber are laminated to one another to maintain its strength, in order to avoid deformation by the weight of the pressurizing plate **25** itself. However, adaptability of the pressurizing plate **25** to deformation such as distortion of configuration of the wafer to be retained is lost to consequently make it difficult to polish the wafer under a low pressure, when the pressurizing plate **25** is made to be so tough. In addition, the tough structure of the pressurizing plate **25** may cause a downward deformation of it into a dome-shape when compressed air is fed in the air chamber **26**, possibly making it difficult to press the planar-shaped wafer onto the polishing pad.

In the polishing head shown in Figs. 31 and 32, on the other hand, the membrane **33** should be firmly formed so as to be able to support the retainer ring **34**, because the retainer ring **34** is supported by the lower face **33b** of the membrane **33**. However, the firm configuration of the membrane causes the same problems as described in the polishing head **21**. Moreover, since configuration of the membrane in the polishing head **30** is so complicated particularly at its peripheral edge **33a** that service life of the membrane **33** may be adversely affected by this configuration.

The wiring width of LSI's are required to be narrow as compared with the conventional ones in compliance with the requirements of making the LSI's to be highly integrated and to be operated at high speed. However, it is difficult to polish the wafer while maintaining a high back-pressure of the wafer against the polishing pad, because the effects of dishing, thinning and erosion accompanied by polishing cannot be disregarded. Accordingly, the back-pressure should be suppressed to be lower than the conventionally applied pressure.

Since wiring resistance is increased as the wiring width is narrowed, it is required to use copper as a wiring material in place of conventionally used aluminum. It is also required to use a so-called Low-k material, a material having low rigidity, as a countermeasure of narrowing the wiring distance, in order to avoid generation of capacitor effect between two adjoining wiring lines. While use of a ceramics such as TaC, TaN and TiN is additionally required when a combination of copper and the low-K material is used, the polishing pressure should be more distinctly reduced for polishing the composite material as described above because rigidities largely differ among the materials.

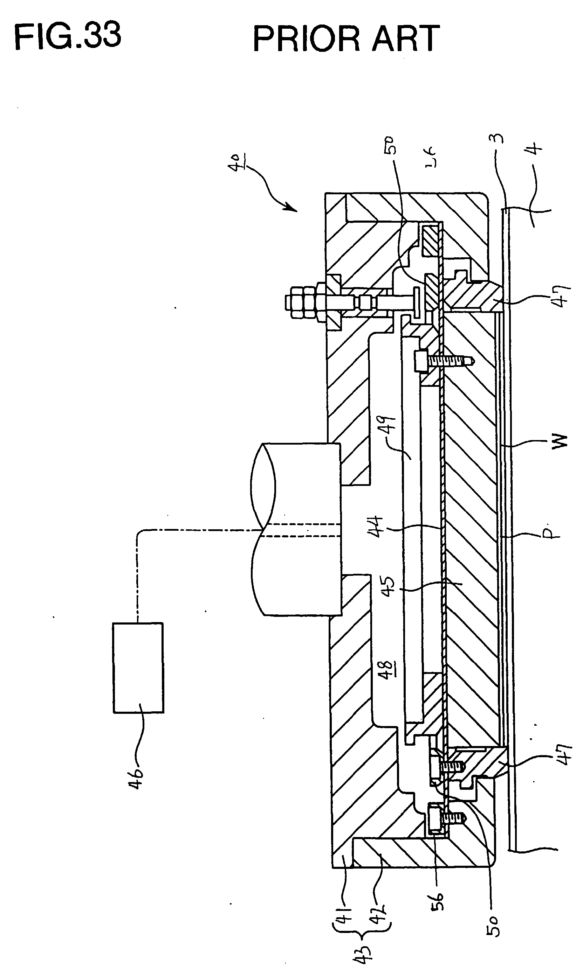

However, the wafer polishing head **40** having the floating structure as shown in Fig. 33 is so configured as to press the wafer **W** via the carrier **45** having a high rigidity. Consequently, low pressure polishing is difficult because undulation of the wafer **W** should be compensated by applying a high pressure in order to press the wafer with a uniform load.

In one polishing heads (not shown in the drawing; referred as the former polishing head hereinafter) known in the art, an opening is provided at the tip of the head. A pressure adjustment mechanism is provided in order to supply a fluid such as air within an open space in the opening, or to discharge the fluid from the space, while a wafer is placed at the end of the opening. In the polishing head so configured as described above, the inner pressure within the space in the opening is made to be higher than the atmospheric pressure using the pressure adjustment mechanism, and the wafer is directly pressed onto the polishing pad by the inner pressure. When the inner pressure is reduced below the atmospheric pressure, on the other hand, the wafer is directly absorbed at the end of the opening.

When the wafer is not properly retained on the polishing head (the wafer is displaced from or is out of the end of the opening), or when the wafer is cracked in the polishing head described above, however, air flows in or leaks through the gap between the wafer and the end of the opening, or through the cracks on the wafer. As a result, the inner pressure cannot be maintained at a prescribed level required for properly retaining the wafer. This type of the polishing head determines whether the wafer is properly retained on the polishing head or not by taking advantage of the phenomenon as described above, i.e., by comparing the attained inner pressure in the opening of the polishing head with the reference pressure.

The other polishing head (not shown in the drawing; referred as the latter polishing head hereinafter) comprises a flexible membrane expanded over the end of the opening. In the polishing head so configured as described above, the membrane is outwardly pressed by increasing the inner pressure in the space within the opening to be larger than the atmospheric pressure using the pressure adjustment mechanism to press the wafer onto the polishing pad via the membrane. The membrane also serves as a suction cup for absorbing the wafer by allowing the membrane to depress toward the inside of the opening as a result of reducing the inner pressure of the space below the atmospheric pressure. Alternatively, a hole is formed on the membrane to reduce the inner pressure within the space of the opening to absorbed the wafer on the membrane.

The polishing head, the former polishing head of the foregoing two polishing heads not shown in the drawing, is apt to be dirty due to suction of the slurry and the like used for polishing into the opening while the wafer is absorbed on the polishing head. The dirt may be a main cause of blocking the motion of movable portions of the polishing head.

A positioning notch is usually provided at the outer circumference of the wafer. Since the outer circumference edge of the wafer is chamfered, a gap is created between the end of the opening and the wafer to ventilate the fluid in the opening or the air in the atmosphere through this gap. Consequently, pressure distribution applied on the wafer has turned out to be irregular at the outer circumference of the wafer to make it difficult to ensure polishing accuracy of the wafer during polishing the wafer, besides the wafer has not been securely retained by absorption on the wafer in the former polishing head as hitherto described.

On the other hand, the wafer is indirectly pressed via the membrane in the latter polishing head. Accordingly, it has been also difficult to press the entire surface of the wafer with uniform pressure as in the polishing heads **21** and **39** to unable polishing accuracy of the wafer to be obtained.

When a hole is provided on the membrane, the slurry is also sucked into the polishing head as in the former polishing head.

When the polishing head is unable to retain the wafer, or when the wafer is not securely retained on the polishing head, polishing turns out to be meaningless to decrease work efficiency since no wafer is retained on the polishing head, or the wafer dropped out of the polishing head is thrown off from the rotating polishing pad or is knocked about by other members of the polishing apparatus to damaged the wafer. Consequently, the polishing head should be provided with a function for sensing whether the wafer is properly retained or not. However, since the space in the opening is made to be airtight by being isolated from the outer environment with the membrane in the latter polishing head, except when a hole is provided on the membrane, it is impossible to employ such a simple method by which the inner pressure is compared with a reference pressure as used in the former polishing head. Accordingly, it was difficult, particularly during polishing of the wafer, to sense whether the wafer is retained or not.

The same difficulty as described above may be encountered in the polishing apparatus using the latter polishing head when, for example, the wafer is transferred from and onto the polishing pad. For avoiding such drawbacks, a wafer detector has been provided in the conventional wafer polishing apparatus for sensing whether the wafer is retained on the polishing head or not.

Whether the wafer is properly retained by the polishing head or not (whether the wafer is tightly adhered on the membrane) may be sensed as follows. For example, a given amount of the fluid is discharged from the fluid chamber by the pressure adjustment mechanism to retain the wafer on the polishing head. Then, the attained pressure in the current fluid chamber is compared with the reference pressure, for example with the attained pressure in the fluid chamber when the wafer is properly retained on the polishing head (referred as a retaining state hereinafter).

When the wafer is not properly retained on the polishing head (referred as a non-retaining state hereinafter), for example, the inner pressure of the space comes close to the atmospheric pressure due to the air flowing into the space formed between the wafer and the membrane. As a result, the inner pressure is increased as compared with the pressure when the wafer is properly retained on the polishing head. Consequently, the membrane is depressed toward the inside of the recess since the difference of the inner pressure between the space and the fluid chamber comes to its maximum level as compared with the pressure when the wafer is in the retaining state. The inner pressure of the fluid chamber increases in proportion to the decreased amount of the volume of the fluid chamber. The wafer is sensed by taking advantage of this phenomenon in the wafer sensing device as described above.

However, when a prescribed amount of the fluid is discharged from the fluid chamber, the absorbing force to the wafer is weakened to cause malfunction of the device when a small amount of air is introduced into the space formed between the wafer and the membrane. While the membrane may be further depressed toward the inside of the recess to reduce the inner pressure of the space to a level necessary for absorbing the wafer when the wafer is retained by the polishing head by reducing the inner pressure of the fluid chamber to a given level, sensing of the wafer is impossible since the pressure in the fluid chamber is always kept constant.

The inner pressure of the fluid chamber actually corresponds to the inner pressure of the space including the passage for connecting the fluid chamber to the pressure adjustment device in addition to the space in the fluid chamber. Since the volume change of the fluid chamber, or the volume to be increased or decreased accompanied by deformation of the membrane is small, the difference between the inner pressure of the fluid chamber in the retaining state and that in the non-retaining state turns out to be very small, thereby it has been difficult to maintain the sensing accuracy of the wafer. While the structure of the polishing head should be made very complex for increasing the rate of change described above, this will result in increase of the manufacturing cost. Furthermore, adjustment of the pressure adjustment device will take much labor by the need of, for example, previous experimental determination of the pressure as a reference for judging whether the wafer is retained or not.

A number of fine foam layers for retaining the slurry **S** are provided on the polishing pad **4** in the polishing apparatus shown in the drawings, and the wafer is polished with the slurry **S** retained in these foam layers.

However, the polishing accuracy and polishing efficiency of the wafer **W** are decreased due to plugging and decreased planarity on the polishing face of the polishing pad **4** by repeated polishing of the wafer **W**.

For solving the above problems, a conditioner **51** for the polishing pad **4** as shown in Fig. 27 is provided in the conventional polishing apparatus. Usually, the surface condition of the polishing pad **4** is adjusted for every polishing to adjust the polishing ability against the wafer **W** within an appropriate range (this operation is referred as "dressing"). The conditioner **51** is also provided in the polishing apparatus **10** shown in Fig. 28, although it is not shown in the drawing.

This conditioner **51** comprises a dresser **54** provided via an arm **53** attached at the outside of the platen **3**. The arm **53** generate a reciprocating rocking motion of the dresser **54** on the polishing pad **4** by allowing the arm **53** to rotate around a rotation axis **52**. Planarity on the surface of the polishing pad **4** is recovered or maintained to solve the problem of plugging by polishing the surface of the polishing pad **4** (in a different example, the dresser **54** does not undergo a rocking motion but is maintained at the site denoted by the broken line on the polishing pad **4**). The dresser **54** itself is connected to a driving device (not shown) via a coupling axis (not shown) provided at the tip of the arm **53** and is allowed to rotate while making contact with the polishing pad **4**, or the dresser **54** is provided at the tip of the arm **53** so that it is permitted to rotate via the coupling axis on a face approximately parallel to the surface of the polishing pad **4**, thereby the dresser **54** rotates by the frictional force applied from the polishing pad **4**.

Since the dresser **54** is an expendable, and its dressing ability decreases by abrasion due to long term use. The dressing effect of the polishing pad **4** may be secured by a prolonged dressing when the dressing ability of the dresser **54** has been decreased. When the dressing ability has come to be out of an appropriate dressing level due to progressed abrasion, on the other hand, the dresser is replaced with fresh one to maintain a good work efficiency.

The following method, for example the method for judging whether the surface of the wafer **W** to be polished has been desirably polished or not, has been used for judging the polishing condition of the wafer **W**, when the wafer is polished using the polishing apparatus as hitherto described.

In one method known in the art, the polishing end point is sensed by observing the polishing resistance exerted on the wafer **W**, or by observing change of the force applied on the wafer during polishing. For example, change of the rotational drive force of a platen driving mechanism (not shown in Fig. 27) is observed. In other words, the polishing resistance generated between the polishing pad **4** and the wafer **W** is not stabilized but fluctuates when the surface of the wafer to be polished is insufficiently polished and, on the contrary, the polishing resistance is stabilized when the surface of the wafer to be polished attained a desired state. Since the platen **3** rotates at a given speed, the rotational driving force of the platen increases, for example, when the polishing resistance is large, and decreases when the polishing resistance is small.

The first method for sensing the polishing end point described above comprises observing the change of the rotational driving force of the platen driving mechanism, and judging the desired polishing state of the surface of the wafer **W** to be polished when the observed value is stabilized to sense the polishing end point.

The second method for sensing the polishing end point described above comprises providing an apparatus for measuring the frictional force of the polishing pad **4** at a free site on the polishing pad **4**, and calculating the polishing resistance from the frictional force on the polishing pad **4**.

However, these methods for sensing the polishing end point involve the following problems.

The platen **3** frequently idles while the wafer **W** does not contact the polishing pad **4**. When the wafer **W** comprises, for example, a material having naturally a small polishing resistance, for example, the difference of the rotational driving force when the wafer **W** is on the way of polishing and when polishing has been completed is so small that the rotational driving force is mingles with the rotational driving force of the platen **3** while it is idling. Consequently, it was a problem in the first method for sensing the polishing end point that the polishing end point of the wafer **W** can be hardly sensed with high accuracy. It was also a problem that responding property against the change of the frictional resistance is poor since a large inertia is applied to the platen **3**.

The driving force of the platen driving mechanism or the head driving mechanism for allowing the platen **3** and the polishing head to rotate has been sensed by measuring the amount of the electric current supplied to a motor (not shown) used for rotating the platen or the polishing head, or by sensing the torque applied to the member for connecting the motor to the platen **3**, or for connecting the motor to the polishing head, for example the torque applied to a pulley. Since the driving force of the platen driving mechanism or the head driving mechanism has been indirectly sensed, responding property turns out to be poor when the driving force is sensed at either the platen **3** or at the polishing head.

It was also a problem that the polishing end point cannot be accurately sensed since the polishing resistance sensed as described above involves the polishing resistance exerted on the portion where the polishing head **4** makes contact with a different position outside of the wafer **W** in the polishing head.

It was sometimes impossible to sense the polishing end point in the first method for sensing the polishing end point due to instability of the polishing resistance even after polishing of the wafer **W** had been progressed, because the polishing resistance is not stabilized depending on the surface state of the polishing pad **4** such as plugging of the polishing pad **4** with polishing debris or abrasion of the surface of the polishing pad **4**. However, it was impossible to judge whether the polishing end point cannot be sensed either by insufficient polishing of the wafer **W**, or by the change of the surface state of the polishing pad **4**, due to lack of sensing means of the surface state of the wafer **W**.

Lack of the means for sensing the surface state of the polishing pad **4** results in inability of sensing that the dressing ability has been decreased due to abrasion of the dresser for dressing the polishing pad **4**.

In the second method for sensing the polishing end point, on the other hand, the facility cost is considerably increased by additionally providing the detector to the polishing apparatus. It was also difficult to establish a condition close to the actual polishing conditions.

The polishing apparatus **10** shown in Fig. 28 comprises many polishing heads for simultaneously polishing many wafers **W** to reduce the manufacturing cost of the wafers **W**. However, much more polishing heads are required for further reducing the manufacturing cost. This requirement has turned out to be crucial since wafer size has been so increased in recent years that the number of the wafers **W** that can be simultaneously polished is decreasing.

However, a floating member **57** for retaining the wafer **W** is supported in a floating manner at the opening of the head body **43** via the diaphragm **44** in the conventional polishing head such as, for example, the wafer polishing head **40**, and the head body **43** is largely expanded over the outer circumference of the floating member **57**. Accordingly, it is currently difficult to increase the number of the polishing heads since the polishing heads requires a large installation area.

The method for connecting the diaphragm **44** to the head body **43**, and the manner for connecting the carrier **45** and retainer ring **47** to the diaphragm will be described with reference to the wafer polishing head **40** shown in Fig. 33.

The diaphragm **44** is bolted to the inner wall of the head body **43** together with a diaphragm fixing ring **56** while the outer circumference of the diaphragm is inserted between the inner wall of the head body **43** and the annular diaphragm fixing ring **56**. The carrier **45** and the retainer ring **47** are also bolted to the carrier fixing ring **49** and the retainer fixing ring **50**, respectively, provided on the upper face of the diaphragm **44**. The carrier **45** and the retainer ring **47** are so configured as to be able to independently displace to one another toward the ascending and descending directions by elastic deformation of the diaphragm **44** (the carrier **45** and the retainer ring **47** may be referred as a floating member **57** hereinafter).

The bolts for securing the diaphragm **44**, the carrier **45** and the retainer ring **47** are inserted from the top to the bottom of the diaphragm **44** through bolt insertion holes provided through the diaphragm **44**.

The slurry **S** invades, for example, between the carrier **45** and the retainer ring **47**, and between the retainer ring **47** and the circumference wall **42** of the head body **43** by continuous polishing using the polishing head **40**. The slurry **S** is denatured by drying or by the heat of friction generated by polishing forming a solid or a gel, or a solid or a semi-solid resembling the solid. When the solid or the semi-solid thus formed flows from the wafer polishing head **40** onto the polishing pad **4**, the wafer **W** may be damaged by scratching, the polishing rate may be deteriorated, or uniform polishing may be inhibited. Accordingly, the wafer polishing head **40** should be periodically cleaned.

The retainer ring **47** among the components constituting the wafer polishing head **40** is an expendable that is consumed by always making contact with the polishing pad during polishing.

The carrier **45** and the retainer ring **47** must be removed from the wafer polishing head **40** for maintenance such as cleaning and exchange of the wafer polishing head **40**, or adjustment of each component.

However, since the carrier ring **45** and the retainer ring **47** are affixed by screwing to the carrier fixing ring **46** and retainer ring fixing ring **47** disposed on the upper face of the diaphragm **44** as described previously, the wafer polishing head **40** should be once disassembled for taking them out of the wafer polishing head **40**. Consequently, the maintenance work has required much labor to restrict the serviceability ratio of the polishing apparatus. Although one may consider that the time required for maintenance may be shortened by replacing the entire wafer polishing head **40**, a spare wafer polishing head **40** should be provided in this case, and the polishing head provided with a plurality of the wafer polishing heads **40** may cause increased manufacturing cost.

Each bolt should be sufficiently tightened for preventing the fluid from flowing out of the bolt insertion hole when the floating member **57** is reassembled to the diaphragm **44**, in order to maintain the fluid chamber **24** airtight to keep floating support of the floating member **57** in a favorable condition.

However, since the diaphragm **44** is flexible, it may be distorted by tightening the bolts, or it may shift from the assembling site where the carrier **45** and the retainer ring **47** has been initially set. Since assembling accuracy of the carrier **45** and the retainer ring **47** differs depending on the workers and working conditions, it has been difficult to level the assembling accuracy as well as to stabilize machining accuracy of the wafer **W**.

While the conventional polishing head should be disassembled for maintenance, it is crucial to keep the assembling accuracy of the diaphragm **44** in assembling the polishing head, because the diaphragm **44** among the components constituting the wafer polishing head **40** plays an important role in the polishing head such as sealing of the fluid chamber **48** and floating support of the floating member **57** against the head body **43**.

It has been also required in the conventional polishing head to assemble the diaphragm **44** while the head body **43** and the floating member **57** is positioned with an exclusive use jig.

As hitherto described, the exclusive use jig has been required for maintenance of the conventional polishing head.

### SUMMARY OF THE INVENTION

Accordingly, it is an object of the present invention to provide a floating type polishing head that can uniformly press a polishing object such as a wafer onto a polishing pad by applying a smaller back-pressure as compared with the conventional one, while applying the pressure via an elastic membrane having better durability than the conventional membrane.

The present invention for attaining the foregoing object provides in one aspect a polishing head comprising: a head body comprising an upper mounting plate (bridge) and a cylindrical circumference wall provided at downward of the outer circumference of the upper mounting plate; a diaphragm vertically provided against a head axis line in the head body; a disk-shaped carrier secured to the diaphragm and provided to be able to displace toward the head axis line direction together with the diaphragm, one face of a polishing object to be polished being retained on the lower face of the carrier; a first pressure adjustment mechanism for adjusting the pressure of a liquid filled in a fluid chamber formed between the carrier and the head body; and a retainer ring disposed in concentric relation between the lower face of the carrier and the inner wall of the circumference wall, besides being provided at an approximately the same elevation as the lower face of the carrier to contact the polishing pad during polishing, the retainer ring being secured to the carrier, an elastic membrane being attached to the lower face of the carrier, and the elastic membrane being secured with its circumference edge being inserted between the retainer ring and the carrier, wherein the carrier comprises a fluid feed passage for feeding a pressure-variable fluid between the elastic membrane and the carrier.

According to the polishing head described above, the elastic membrane may be expanded while keeping its tension since the periphery of the elastic membrane is inserted between the retainer ring and the carrier, thereby eliminating the need of forming the elastic membrane itself tough in order to avoid the elastic membrane from being deformed by its own weight. Also, since the retainer ring is secured to the carrier, the elastic membrane is not required to support the weight of the retainer ring.

Consequently, a thin membrane having a good adaptability to deformation may be used for the elastic membrane, making it possible to permit the elastic membrane to inflate and deflate by feeding a fluid from the fluid feed passage while maintaining adhesive property to the polishing object. Therefore, the polishing object may be uniformly pressed onto the polishing pad at a low pressure even when the polishing object has an irregular surface, permitting the polishing pad to be polished at a lower pressure than the conventional pressure. Since attachment of the elastic membrane is simpler than in the conventional membrane, service life of the elastic membrane is not adversely affected. Moreover, securing the retainer ring to a carrier having higher rigidity allows planarity of the lower surface of the retainer ring making contact with the polishing pad may be improved, also permitting better planarity of the polished face of the polishing object than in conventional one. Since polishing is possible at low pressure, the polishing apparatus according to the present invention may be favorably used for polishing a semiconductor wafer having a fine pattern.

An another object of the present invention is to provide a polishing head that is able to uniformly press the polishing object with a lower pressure than in the conventional art.

For attaining the object above, the present invention provides in an another aspect a polishing head comprising: a head body comprising an upper mounting plate and a cylindrical circumference wall provided at downward of the outer circumference of the upper mounting plate; a diaphragm vertically expanded against a head axis line in the head body; a first pressure adjustment mechanism for adjusting the pressure of a liquid filled in a fluid chamber formed between the diaphragm and the head body; a carrier fixed to the diaphragm and provided to be able to displace toward the head axis line direction together with the diaphragm, one face of a polishing object to be polished being retained on the lower face of the carrier; and a retainer ring disposed in concentric relation between the inner wall of the circumference wall and the outer circumference of the carrier, besides being secured to the diaphragm and provided so as to be able to displace toward the head axis line direction together with the diaphragm, the retainer ring contacting the polishing pad during polishing, an elastic membrane being expanded over an area surrounded by the retainer ring on the lower surface of the carrier, and the carrier comprising a fluid feed passage for feeding a fluid between the lower face of the carrier and the elastic membrane, wherein a second pressure adjustment mechanism for adjusting the fluid pressure fed between the lower face of the carrier and the elastic membrane is connected to the fluid feed passage.

According to the polishing head of the present invention, the lower face of the carrier retains the polishing object via the elastic membrane. Accordingly, the polishing object may be retained on the lower face of the carrier via an air layer and the elastic membrane, when air is fed between the carrier and the elastic membrane to form an air layer between the carrier and the elastic membrane. When the polishing object retained as described above is pressed onto the polishing pad, irregularity of the surface of the polishing object may be relaxed by allowing the elastic membrane and the air layer to follow the planarity of the polishing object, making it possible to uniformly press the polishing object with good accuracy. Consequently, decrease of polishing accuracy due to irregular surface configuration of the polishing object may be prevented.

While the force for pressing the retainer ring onto the polishing pad is determined by the pressure of the fluid in the fluid chamber in the present invention, the force for allowing the elastic membrane to press the polishing object onto the polishing pad is determined by the pressure of the fluid fed to the air layer between the lower face of the carrier and the elastic membrane. Accordingly, the force for pressing the retainer ring onto the polishing pad, and the force for allowing the elastic membrane to press the polishing object onto the polishing pad may be independently adjusted o one another using a first pressure adjustment mechanism and a second pressure adjustment mechanism, respectively. As a result, the retainer ring may be pressed into the polishing pad with a high pressure, while maintaining the back-pressure of the polishing object against the polishing pad to be low using the first pressure adjustment mechanism. Consequently, the periphery contacting the polishing object on the polishing pad may be prevented from distortion of configuration by aggressively taking advantage of the retainer ring during polishing to further improve polishing accuracy.

A different object of the present invention is to provide a polishing head capable of sensing whether the polishing object is properly retained or not, while permitting the polishing head to operate under a good condition by blocking the slurry from invading into the polishing head. It is also an object of the present invention to securely retain the polishing object while improving machining accuracy of the polishing object.

For attaining the above object, the present invention provides in a different aspect a polishing head comprising: an elastic membrane expanded at the tip of the head for receiving the polishing object on its lower face; a pressure adjustment mechanism for adjusting the gas pressure by feeding or sucking a gas at the upper face side of the elastic membrane; a pressure gauge for measuring the gas pressure at the upper face side of the elastic membrane; and a detector for sensing that at least the polishing object is not properly retained or the polishing object is cracked based on the observation result that the measured pressure does not attain a reference pressure by comparing the measured pressure of the pressure gauge with respective reference pressures when the gas is fed and sucked by the pressure adjustment mechanism, wherein the elastic membrane comprises a gas permeable and water proof material that permits a gas to permeate but prohibits a liquid from permeating.

According to the polishing head of the present invention, the gas fed to the upper face side of the elastic membrane by the pressure adjustment mechanism passes through the elastic membrane to directly press the upper face of the polishing object during polishing.

When the polishing object is not properly retained on the polishing head (the polishing object is not adhered on the elastic membrane), or the polishing object is cracked, the gas pressure at the upper face side of the elastic membrane does not increase up to a pressure (a reference pressure) attainable when the polishing object is properly retained, because the gas fed from the pressure adjustment mechanism leaks out. Consequently, whether the polishing object is properly retained or not, or whether the polishing object is cracked or not, may be sensed by measuring the finally attained gas pressure at the upper face side of the elastic membrane using a pressure gauge to compare the measured value from the pressure gauge with the reference pressure for feeding the gas using a detector.

The air between the lower face of the elastic membrane and the upper face of the polishing object is sucked to the upper face side of the elastic membrane through the elastic membrane, thereby the polishing object is absorbed on the lower face of the elastic membrane, by reducing the pressure at the upper face side of the elastic membrane using the pressure adjustment mechanism. Invasion of the slurry into the polishing head is prohibited by the elastic membrane.

When the polishing objet is not properly retained on the polishing head, or when the polishing object is cracked, the atmospheric air flows into the upper face side of the elastic membrane through the elastic membrane. Accordingly, the pressure at the upper face side of the elastic membrane is not reduced to a pressure (reference pressure) expected when the polishing object is properly retained. Accordingly, whether the polishing object is properly retained or not, or whether the polishing object is cracked or not, may be sensed by measuring the finally attained gas pressure at the upper face side of the elastic membrane using a pressure gauge to compare the measured value from the pressure gauge with the reference pressure for feeding the gas using a detector.

As hitherto described, the polishing head according to the present invention permits whether the polishing object is properly retained or not, or the polishing object is cracked or not, to be sensed over the entire work area of transfer and polishing of the polishing object, while maintaining operation of the polishing head in good condition by blocking invasion of the slurry into the polishing head.

A different object of the present invention is to provide a polishing head that is able to sense whether the polishing object is retained or not.

For attaining the above object, the present invention provides in a further different aspect a polishing head comprising a carrier provided with a recess on the lower face as a face at the side for retaining a polishing object, and a flexible member provided on the lower face of the carrier for dividing the recess from the outside to form a space while receiving the polishing object on its lower face, wherein a pressure adjustment mechanism is connected to the recess of the carrier, the pressure adjustment mechanism adjusting the pressure in the space to reduce the pressure in the space to be lower than the atmospheric pressure for retaining the polishing object, thereby allowing the flexible member to depress toward the inside of the recess to serve as a suction cup for absorbing the polishing object, the carrier comprising a fluid feed passage for connecting the pressure adjustment mechanism and the recess provided at almost the center of the recess, and the flexible member being further depressed toward the inside of the recess by the suction pressure of the pressure adjustment mechanism when the polishing object is not adhered on the lower face of the flexible member to close the fluid feed passage while a space is remaining at the outer circumference of the recess, wherein the polishing head further comprising: a differential pressure measuring device for measuring the differential pressure between the suction pressure of the pressure adjustment mechanism and the inner pressure of the space at the outer circumference of the recess; and a detector for sensing whether the polishing object is retained or not by sensing the differential pressure with the differential pressure measuring device.

In the polishing head so configured as described above, the flexible member inwardly depress into the space to close the fluid feed passage provided at near the center of the recess of the carrier by reducing the inner pressure using the pressure adjustment mechanism, when the polishing object is not adhered onto the flexible member (non-retention state) in retaining the polishing object. A space is left behind at the circumference of the recess of the entire space. The inner pressure of this remaining space is not further reduced due to closed fluid feed passage, a differential pressure is generated between the inner pressure of this space and the pressure in the fluid feed passage, or the suction pressure of the pressure adjustment mechanism. This differential pressure may be increased to an extent to facilitate the measurement by the differential pressure measuring device, by sufficiently increasing the suction pressure of the pressure adjustment mechanism. When the differential pressure measuring device has sensed the differential pressure between them, the sensor decides that the polishing object is not retained on the polishing head. When the differential pressure has not been sensed, on the contrary, the sensor decides that the fluid feed passage is not closed, or the polishing is retained on the polishing head. Whether the polishing object is retained or not is thus sensed in the manner as described above.

According to the polishing head of the present invention, sensing whether the polishing object is properly retained on the polishing head is sensed by sensing whether a differential pressure has been generated between the inner pressure in the space at the outer circumference of the recess of the carrier and the suction pressure of the pressure adjustment mechanism. Since the differential pressure may be increased to an extent to facilitate sensing by increasing the suction pressure of the pressure adjustment mechanism, whether the polishing object is properly retained or not may be accurately sensed.

A different object of the present invention is to provide a polishing apparatus having a high sensing ability of information on the polished state of the polishing object, besides sensitively responding to the polished state. It is also an object of the present invention to provide a polishing apparatus that is able to sense information on the surface state of the polishing pad.

For attaining the above object, the present invention provides in a different aspect a polishing apparatus comprising a platen on the surface of which a polishing pad is adhered, a polishing head for retaining one face of the polishing object to allow the other face of the polishing object to contact the polishing pad, and a head drive mechanism for polishing the other face of the polishing object by driving the polishing head, the polishing head comprising a head body comprising an upper mounting plate and a cylindrical circumference wall provided at downward of the outer circumference of the upper mounting plate, a diaphragm expanded in the head body, and an approximately disk-shaped carrier secured to the diaphragm to displace toward the head axis line direction together with the diaphragm while retaining one face of the polishing object, the lower face of the carrier comprising a recess and an elastic membrane for forming a space by dividing the recess from the outside of the recess, a pressure adjustment mechanism being connected to the recess, the pressure adjustment mechanism adjusting the inner pressure of the space to adjust the back-pressure for allowing the elastic membrane to press the polishing object onto the polishing pad by receiving the inner pressure, the carrier comprising a retainer ring integrally attached at the outer circumference by allowing its lower end to protrude out of the lower face of the carrier, the outer circumference of at least one of the carrier or the retainer ring and the inner face of the head body comprising an engage member for allowing the carrier or the retainer ring to engage with the head body so as to restrict relative rotation between the carrier or the retainer ring and the head body around the head axis line as a center of rotation caused by the frictional resistance suffering from the polishing pad, the polishing apparatus further comprising: a sensor provided between the engage members for measuring the force along the direction of rotation applied among the engage members; and a computing unit for calculating the polishing resistance received by the retainer ring from the measured value by the censor while the back-pressure of the polishing object is released by reducing the inner pressure of the space.

According to the polishing apparatus of the present invention, the carrier retaining the polishing object and the retainer ring is forced to rotate toward the head axis line direction by the polishing resistance applied from the polishing pad, when the polishing object is polished by allowing the polishing head to contact the polishing pad. This rotation is received by engage members provided at either one of the carrier or the retainer ring, and on the inner face of the head body. The force along the direction of rotation acting on these engage members is measured by the sensor.

When the back-pressure on the polishing object via the elastic membrane is released by decreasing the inner pressure of the space below, for example, the atmospheric pressure using the pressure adjustment mechanism, the polishing resistance received by the retainer ring may be calculated using a computing unit based on the measured value of the sensor, since only the retainer ring is pressed onto the polishing pad.

The level of the polishing resistance acting on the retainer ring may be directly determined under the same condition as in polishing the polishing object in the polishing apparatus according to the present invention. Since the polishing resistance applied on the retainer ring remains within a given range so far as the surface state of the polishing pad is not changed, the surface state of the polishing pad may be sensed based on fluctuations of the polishing resistance. The state of abrasives for dressing the polishing pad may be also sensed from the surface state of the polishing pad.

Since the polishing resistance acting on the retainer ring is measured by merely reducing the inner pressure of the space by the pressure measuring mechanism, it may be readily carried out at any timing even when the polishing object is being polished. Also, the polishing resistance may be measured at an appropriate timing from the initial state of polishing to obtain information on variation of the polishing resistance from the initial state.

Since the surface state of the polishing pad may be sensed in the polishing apparatus according to the present invention, the timing for adjustment of the surface of the polishing pad may be determined. A countermeasure may be also selected depending on circumstances when the polishing ability of the polishing pad has been deteriorated.

The state of the dresser to be used for dressing the polishing pad may be simultaneously determined to enable the exchange time of the dresser to be sensed. Alternatively, selection of countermeasures depending on the circumstances is possible when the dressing ability of the dresser has been deteriorated. Consequently, the polishing object may be polished under an appropriate polishing conditions.

Twist of the diaphragm is also restricted to enable the diaphragm to protect from deterioration and damage to make maintenance of the polishing head easy.

A different object of the present invention is to provide a method for sensing information on the polished state with high sensitivity besides having a good responding ability on the polished state of the polishing object. It is also an object of the present invention to provide a sensing method of the polished state that is able to sense the surface state of the polishing pad.

For attaining the object above, the present invention provides in a different aspect a method for sensing polished state using a polishing apparatus comprising a platen on the surface of which a polishing pad is adhered, a polishing head for retaining one face of a polishing object to allow the polishing pad to contact the other face of the polishing object, and a head drive mechanism for polishing the other face of the polishing object by allowing the polishing head to drive, the polishing head comprising a head body comprising an upper mounting plate and a cylindrical circumference wall provided at downward of the outer circumference of the upper mounting plate, a diaphragm expanded in the head body, and an approximately disk-shaped carrier secured to the diaphragm to displace toward the axis line direction together with the diaphragm while retaining one face of the polishing object, the lower face of the carrier comprising a recess, and an elastic membrane for forming a space by dividing the recess from the outside of the recess, a pressure adjustment mechanism being connected to the recess, the pressure adjustment mechanism adjusting the inner pressure to adjust the back-pressure for allowing the elastic membrane to press the polishing object onto the polishing pad by receiving the inner pressure, the outer periphery of the carrier comprising an integrated retainer ring with its lower end protruding out of the lower face of the carrier, the polishing apparatus further comprising: an engage member, at the outer circumference of either the carrier or the retainer ring and on the inner face of the head body, for allowing the carrier or the retainer ring to engage with the head body so as to restrict relative rotation around the head axis line as a center of rotation; and a sensor provided among the engage members to measure the force along the direction of rotation acting among the carrier or the retainer ring and the head body, wherein the polishing resistance received by the retainer ring is calculated with a computing unit using the measured value from the sensor while the back-pressure of the polishing object is released by reducing the inner pressure of the space using the pressure adjustment mechanism, thereby sensing the surface state of the polishing pad.

In the method for sensing the polished sate according to the present invention, the polishing object is polished by allowing the polishing head to contact the polishing pad, and the back-pressure on the polishing object via the elastic membrane is released by reducing the inner pressure below, for example, the atmospheric pressure using the pressure adjustment mechanism while continuing polishing. Since only the retainer ring is pressed onto the polishing pad by the procedure above, the polishing resistance applied on the retainer ring is calculated from the value of the force along the direction of rotation acting on the engage member measured by the sensor.

Since the polishing resistance level applied on the retainer ring under the same condition as polishing the polishing object may be directly determined in the method for sensing the polished state according to the present invention, the timing for adjusting the surface of the polishing pad may be determined. A countermeasure depending on the circumstances may be also selected when the polishing ability of the polishing pad has been deteriorated.

Since the level of the polishing resistance applied on the retainer ring remains within a given range so long as the surface state of the polishing pad is not changed, the surface state of the polishing pad may be sensed based on fluctuation of the polishing resistance. The state of the dresser for dressing the polishing pad may be also sensed from the surface state of the polishing pad. Since the state of the dresser to be used for dressing the polishing pad is simultaneously sensed as described above, the timing of exchanging the dresser may be sensed while selecting a countermeasure depending on the circumstances when the dressing ability of the dresser has been deteriorated. As a result, the polishing object may be polished under an appropriate polishing condition.

Since the polishing resistance applied on the retainer ring is measured merely by decreasing the inner pressure of the space using the pressure adjustment mechanism in the method for sensing the polished state according to the present invention, the measurement may be readily carried out even when the polishing object is being polished. Variation of the polishing resistance from the initial state may be also determined by a measurement of the polishing resistance at an appropriate timing from the initial state of polishing.

A different object of the present invention is to provide a polishing head having a small mounting space.

For attaining the above object, the present invention provides in a different aspect a polishing head to be used for a polishing apparatus for polishing a polishing object by allowing one face of the polishing object to contact a polishing pad adhered on a platen followed by a relative movement between the polishing pad and the polishing object, and for retaining the polishing object to allow it to contact the polishing pad, comprising: a head body comprising an upper mounting plate and a cylindrical circumference wall provided at downward of the outer circumference of the upper mounting plate, a diaphragm expanded in the head body, a floating member for retaining the polishing object provided on the diaphragm so as to be able to displace toward the head axis line direction together with the diaphragm, and a first pressure adjustment mechanism for adjusting the inner pressure of a fluid chamber formed by being divided from the outside by the diaphragm provided between the head body and the floating member, wherein the floating member is provided to be approximately in concentric relation to the head body and formed into an approximate disk-shape having an outer diameter larger than the outer diameter of the head body.

In the polishing head so configured as described above, the floating member retaining the polishing object has a larger outer diameter than the outer diameter of the head body. Consequently, the mounting space of the polishing head may be reduced by eliminating an overhang of the polishing head outside of the polishing object.

A gap communicating with the outside is formed between the floating member and the head body in the conventional polishing head, for the convenience of supporting the floating member with the diaphragm in a floating manner relative to the head body (a gap is also formed between the carrier and the retainer ring when the floating member is composed of the carrier and the retainer ring to independently attach them on the diaphragm). Abrasive particles and other foreign substances on the polishing pad may be sucked into the gap since the inner pressure changes due to volume changes caused by deformation of the diaphragm, when the floating member travels relative to the head body. Abrasive particles and other foreign substances may be also sucked into the gap by a capillary phenomenon. Solids and semi-solids may be formed due to deterioration of abrasives while polishing is going on, and the abrasive and other foreign substances are discharged on the polishing pad again to generate damages such as scratches on the polishing object, to worsen polishing rate, or to cause inhibition of uniform polishing. Consequently, a periodic disassembling and cleaning have been necessary in the conventional polishing head.

In the polishing head according to the present invention, on the other hand, the gap formed by the floating structure (a gap caused by volume change accompanied by travel of the floating member) is formed between the upper face of the floating member and the head body, and is located a distance apart from the polishing pad. Since the gap between the opening of the gap and the polishing pad is blocked by the periphery of the floating member, foreign substances are hardly sucked into the gap.

The procedure above makes the polishing object to be rarely damaged by scratches and the like, while enabling serviceability ratio of the polishing apparatus to be improved since the cleaning frequency of the polishing head after removing the floating member from the head body may be reduced.

According to the polishing head so configured as described above, and the polishing apparatus using the polishing head, the mounting space of the polishing area may be reduced by eliminating overhang of the polishing head outside of the polishing object, because the floating member retaining the polishing object has a larger outer diameter than the outer diameter of the head body.

The gap formed by the floating structure is formed between the upper face of the floating member and the head body, and is located with a distance apart from the polishing pad. Since the gap between the opening of the gap and the polishing pad is blocked with the periphery of the floating member, foreign substances are hardly sucked into the gap.

Consequently, the polishing object is scarcely damaged by scratches and the like, while enabling serviceability ratio of the polishing apparatus to be improved since the cleaning frequency of the polishing head after removing the floating member from the head body may be reduced.

A different object of the present invention is to provide a polishing head being easy in maintenance and being able serviceability ratio to be improved. It is also the object of the present invention to provide a polishing head that is able to assure machining accuracy of the polishing object.

For attaining the object above, the present invention provides in a different aspect a polishing head to be used for a polishing apparatus for polishing a polishing object by allowing one face of the polishing object to contact a polishing pad adhered on a platen followed by a relative movement between the polishing pad and the polishing object, and for retaining the polishing object to allow it to contact the polishing pad, comprising: a head body comprising an upper mounting plate and a cylindrical circumference wall provided at downward of the outer circumference of the upper mounting plate; a diaphragm expanded in the head body; a floating member provided on the diaphragm to be able to displace along the head axis line direction together with the diaphragm for retaining the polishing object; and a first pressure adjustment mechanism for adjusting the inner pressure of a fluid chamber formed by being divided from outside between the head body and the floating member, a rigid intermediate member being inserted between the diaphragm and the floating member, and the floating member being attached to be attachable to and detachable from the intermediate member.

According to the polishing head so configured as described above, the floating member is attached to the diaphragm via an intermediate member, and the floating member is attached to the intermediate member so as to be attachable and detachable. Accordingly, the floating member may be attached and detached without disassembling the entire polishing head.

Since the intermediate member is rigid, assembling accuracy of the floating member may be improved as compared with the conventional floating member directly attached to the flexible diaphragm. Assembling accuracy of the floating member can be secured by a simple adjustment in reassembling the floating member, by assuring assembling accuracy of the intermediate member to the diaphragm.

When the space between the head body and the intermediate member is divided from the outside with the diaphragm to form a fluid chamber, for example, and the floating member is configured not to participate in forming the fluid chamber, it is made possible to emphasize the air-tight property of the fluid chamber in assembling the intermediate member to the diaphragm, and to emphasize assembling accuracy of the floating member in assembling the floating member to the intermediate member.

The intermediate member may be also utilized as a spacer for positioning the floating member toward the head axis line direction. In other words, the position of the floating member for retaining the polishing object may be adjusted by changing the position of the floating member relative to the head body along the head axis line direction with reference to the thickness of the polishing object to be polished by replacing the intermediate member with an another intermediate member having a different thickness. Consequently, a polishing object having a different thickness may be readily positioned for polishing.

According to the polishing head of the present invention, the floating member may be easily attached and detached without disassembling the entire polishing head. Consequently, maintenance of the polishing head is easy to enable serviceability ratio of the polishing apparatus to be improved.

Since assembling accuracy of the floating member is assured, the assembling accuracy of the floating member may be secured by a simple adjustment in re-assembling the floating member, also allowing machining accuracy to be assured.

Since the position of the floating member for retaining the polishing object may be adjusted by replacing the intermediate member with an another intermediate member having a different thickness, positioning of a polishing object having a different thickness is made easy.

A different object of the present invention is to provide a polishing head to which the diaphragm is easily assembled.

For attaining the object above, the present invention provides in a different aspect a polishing head to be used for a polishing apparatus for polishing a polishing object by a relative movement between the polishing pad and the polishing object by allowing one face of the polishing object to contact the polishing pad adhered on a platen, and for retaining the polishing object to allow it to contact the polishing pad, comprising: a head body comprising an upper mounting plate and a cylindrical circumference wall provided at downward of the upper mounting plate; a diaphragm expanded in the head body; a floating member provided on the diaphragm so as to be able to displace along the head axis line direction together with the diaphragm for retaining the polishing object; and a pressure adjustment mechanism for adjusting the inner pressure formed by being divided from the outside with the diaphragm between the head body and the floating member, wherein the head body and the floating member comprise reference faces for positioning the head body and the floating member in assembling the diaphragm by allowing one reference face to contact the other reference face provided on the head body and the floating member, respectively.

According to the polishing head of the present invention, the head body and the floating member may be easily positioned for assembling the diaphragm without using any jigs.

### BRIEF DESCRIPTION OF THE DRAWINGS

Fig. 1 is a vertical cross section illustrating the polishing head according to the first embodiment of the present invention;
Fig. 2 is an enlarged vertical cross section in the vicinity of the lower face of the wafer showing the wafer retained on the polishing head shown in Fig. 1;
Fig. 3 is an enlarged vertical cross section in the vicinity of the lower face of the wafer when the wafer is polished using the polishing head shown in Fig. 1;
Fig. 4 is a vertical cross section illustrating an example of an another configuration of the polishing head according to the first embodiment of the present invention;
Fig. 5 is a vertical cross section illustrating the wafer polishing head according to the second embodiment of the present invention;

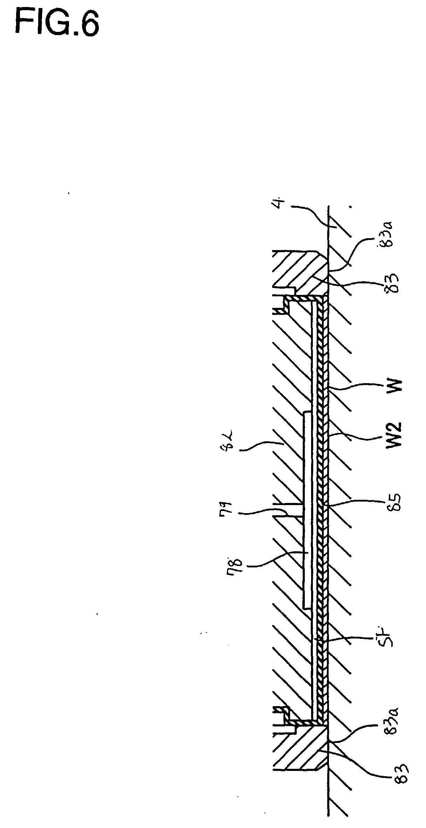

Fig. 6 is an enlarged vertical cross section in the vicinity of the lower face of the wafer when the wafer is polished using the wafer polishing head shown in Fig. 5;
Fig. 7 is a vertical cross section showing the polishing head according to the third embodiment of the present invention;

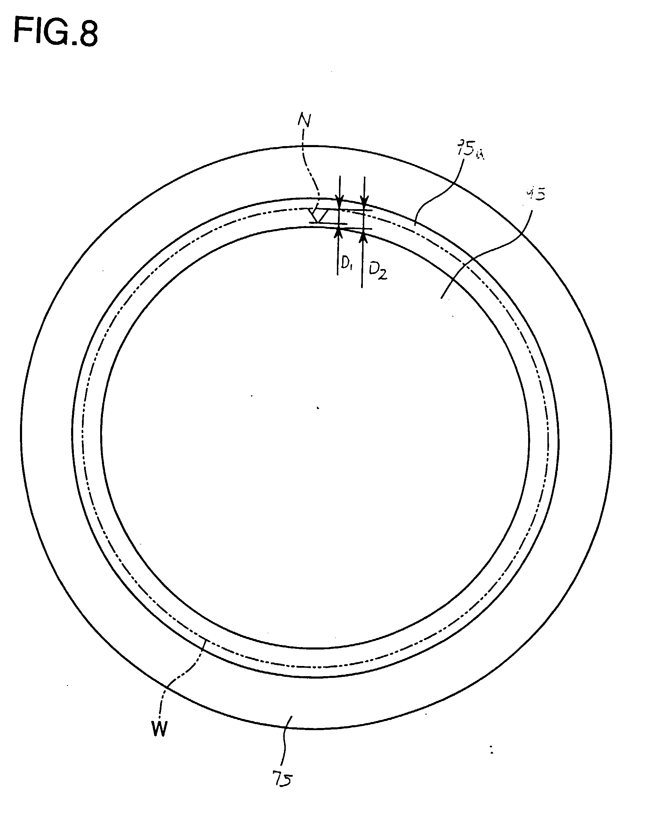

Fig. 8 is a drawing of the tip face of the wafer polishing head illustrating the relation between the elastic membrane of the polishing head and the wafer in the third embodiment of the present invention;
Fig. 9 is a vertical cross section of the polishing head according to the fourth embodiment of the present invention;
Fig. 10A is an enlarged vertical cross section of the main part showing the method for sensing the wafer (retained) by the polishing head according to the fourth embodiment of the present invention;
Fig. 10B is an enlarged vertical cross section of the main part showing the method for sensing the wafer (not retained) by the polishing head according to the fourth embodiment of the present invention;
Fig. 11 is a vertical cross section showing an another configuration of the polishing head according to the fourth embodiment of the present invention;
Fig. 12A is a drawing of the tip face showing an another configuration of the polishing head according to the fourth embodiment of the present invention;
Fig. 12B is a drawing of the tip face showing an another configuration of the polishing head according to the fourth embodiment of the present invention;
Fig. 13 is a vertical cross section showing the configuration and construction of the polishing head according to the fourth embodiment of the present invention;
Fig. 14 shows the configuration and construction of the polishing head according to the fifth embodiment of the present invention, and is an enlarged drawing of Fig. 13;
Fig. 15 shows the configuration and construction of the polishing head according to the fifth embodiment of the present invention, and is a cross section viewed along the line A-A in Fig. 14;
Fig. 16 is a vertical cross section showing the polishing head according to the sixth embodiment of the present invention;
Fig. 17 is a vertical cross section showing the polishing head according to the seventh embodiment of the present invention;
Fig. 18 shows the polishing head according to the seventh embodiment of the present invention, and is an enlarged drawing of the main part in Fig. 17;
Fig. 19 is an enlarged vertical cross section of the main part showing an another example of the assembled configuration to the intermediate member according to the seventh embodiment of the present invention;
Fig. 20 is a vertical cross section showing the polishing head according to the eighth embodiment of the present invention;
Fig. 21 is a vertical cross section showing the polishing head according to the ninth embodiment of the present invention;
Fig. 22A is a partially enlarged vertical cross section showing the method for assembling the diaphragm in the polishing head according to the ninth embodiment of the present invention;
Fig. 22B shows an enlarged drawing of Fig. 22A;
Fig. 23 is a vertical cross section showing an another example of the polishing head according to the ninth embodiment of the present invention;
Fig. 24A is a partially enlarged vertical cross section showing the construction of the polishing head and the method for assembling the diaphragm according to the tenth embodiment of the present invention;
Fig. 24B is a partially enlarged vertical cross section showing the construction of the polishing head and the method for assembling the diaphragm according to the tenth embodiment of the present invention;
Fig. 25 is a perspective view showing the configuration of the rotation piece to be used for the polishing head according to the tenth embodiment of the present invention;
Fig. 26A is a partially enlarged vertical cross section showing an another example of the structure of the polishing head according to the tenth embodiment of the present invention, and the diaphragm assembled in the polishing head;
Fig. 26B is a partially enlarged vertical cross section showing an another example of the structure of the polishing head according to the tenth embodiment of the present invention, and the diaphragm assembled in the polishing head;
Fig. 27 is an enlarged vertical cross section of the main part showing the conventional polishing apparatus;
Fig. 28 is a front view illustrating the conventional polishing apparatus;
Fig. 29 shows a related art according to the present invention, and is a vertical cross section showing one example of the floating type polishing head via the membrane;
Fig. 30 is an enlarged vertical cross section of the main part in Fig. 30;
Fig. 31 shows a related art according to the present invention, and is a vertical cross section showing an another example of the floating type polishing head via the membrane;
Fig. 32 is an enlarged vertical cross section of the main part in Fig. 31; and
Fig. 33 shows a related art according to the present invention, and is a vertical cross section showing one example of the wafer polishing head having a floating structure.

### DESCRIPTION OF THE PREFERRED EMBODIMENTS

### [First Embodiment]

The polishing head according to the first embodiment of the present invention will be described with reference to the drawings.

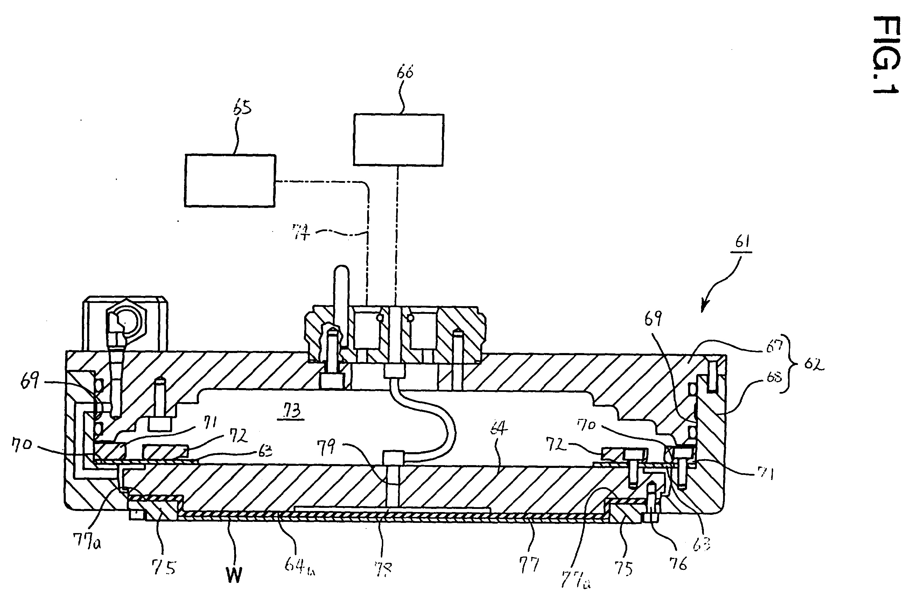

Fig. 1 shows a vertical cross section showing the polishing head **61** according to the first embodiment of the present invention.

The polishing head **61** according to the present invention is applied for a polishing apparatus for polishing the surface of a semiconductor wafer (simply referred as a wafer **W** hereinafter) cut from a silicon ingot.

A plurality of the polishing heads **61** are provided at the lower part of a carousel **11** as a head drive mechanism in the polishing apparatus **10** shown, for example, in Fig. 28, and is allowed to undergo a planetary motion on a polishing pad **4** provided on a platen **3** (the polishing heads **61** may be provided in the polishing apparatus **1** shown in Fig. 27).

As shown in Fig. 1, the polishing heads **61** mainly comprises a head body **62**, a diaphragm **63**, a carrier **64**, and a first and second pressure adjustment mechanisms **65** and **66**.

The head body **62** comprises an upper mounting plate **67** and a cylindrical circumference wall **68** provided downward of the outer circumference of the upper mounting plate **67**. The lower end of the head body **62** is open forming a hollow space, and the upper mounting plate **67** is secured in a coaxial relation to a shaft (not shown) coupled to the carousel **11**.

A step **70** is provided over the entire circumference of the inner wall **69** of the circumference wall **68** and the diaphragm **63** is secured with a diaphragm fixing ring **71** on the step **70**. The diaphragm **63** is formed into an annular disk using an elastic material such as a fiber-reinforced rubber, and vertically disposed against the head axis line in the head body **62**.

A carrier **64** comprising a highly rigid material such as a ceramic is formed into a disk with a given thickness, and is secured to the diaphragm **63** by means of a carrier fixing ring **72** provided on the upper face of the diaphragm **63**.

A fluid chamber **73** is formed between the carrier **64** and the head body **62**. This fluid chamber **73** communicates with the first pressure adjustment mechanism **65** via a fluid passage **74**. The inner pressure of the fluid passage is controlled by feeding a fluid such as air from the first pressure adjustment mechanism **65**.

An annular retainer ring **75** is disposed in concentric relation to the carrier **64** between the lower face **64a** of the carrier **64** and the inner wall **69** of the circumference wall **68**. The retainer ring **75** is placed at an approximately the same elevation as the lower face **64a** of the carrier **64**, and is secured to the carrier **64** with screws **76**.

An elastic membrane **77** is placed on the lower face **64a** of the carrier **64**. The elastic membrane **77** is secured by allowing its circumference edge **77a** to be sandwiched between the retainer ring **75** and the carrier **64**, and is expanded with a given tension on the lower face **64a** of the carrier **64**.

A pressurizing pocket **78** is formed on the lower face **64a** of the carrier **64**. The pressurizing pocket **78** is configured so that its lower end is covered with the elastic membrane **77**, and communicate with a fluid feed passage **79** formed in the carrier **64**. The fluid feed passage **79** is connected to the second pressure adjustment mechanism **66**. The elastic membrane **77** is able to inflate and deflate toward the vertical direction by feeding a fluid such as pressure variable air between the elastic membrane **77** and the carrier **64** via the fluid feed passage **79** by means of the second pressure adjustment mechanism **66**.

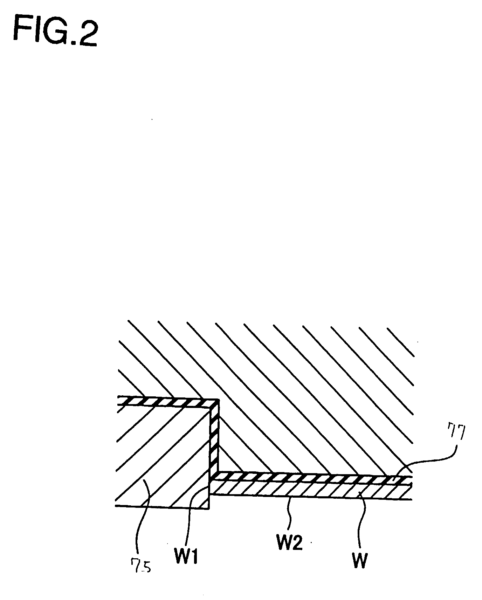

The lower face of the elastic membrane **77** is possible to absorb the wafer **W** as shown in Fig. 1 using a vacuum absorption device (not shown) in the polishing head **61**. The wafer **W** is secured by absorption so that its outer circumference **W1** is blocked with the retainer ring **75** as shown in the enlarged drawing shown in Fig. 2. The lower face **75a** of the retainer ring **75** is located at slightly downward (0.05 to 1.00 mm) from the lower face **W2** of the absorbed wafer **W**.

For polishing the wafer **W** using the polishing head **61** (see Fig. 1), the wafer **W** is at first absorbed on the lower face of the elastic membrane **77** by means of a vacuum absorption device (not shown), and then the lower face of the polishing head **61** is allowed to contact the polishing pad **4**. Only the lower face **75a** of the retainer ring **75** contact the polishing pad **4** in this step, and the lower face **W2** of the wafer **W** still remains a distance apart from the polishing pad **4**.

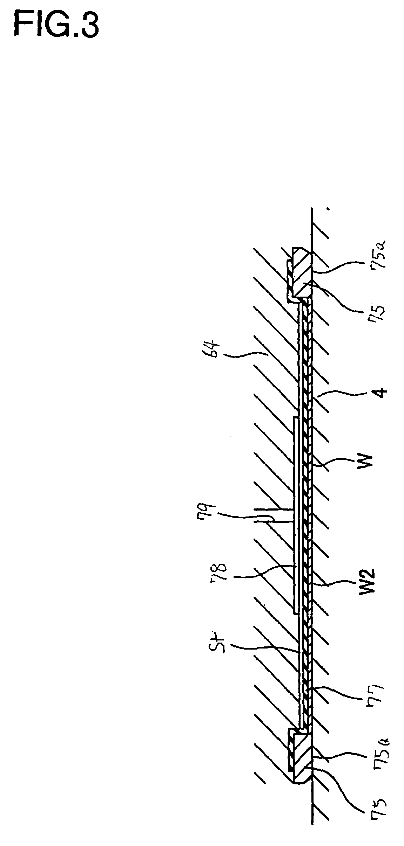

Then, compressed air is fed into the fluid chamber **73** by driving the first pressure adjustment mechanism **65**. A pressure by the compressed air is applied onto the carrier **64** from upward, and the retainer ring **75** secured on the carrier **64** is pressed onto the polishing pad **4** with a given back-pressure. The second pressure adjustment mechanism **66** is simultaneously driven to send the compressed air between the elastic membrane **77** and the carrier **64**. A space **SP** is formed between the elastic membrane **77** and the carrier **64** as shown in Fig. 3. The lower face **W2** of the wafer **W** is pressed onto the polishing pad **4** by the pressure of the compressed air in the space **SP**.

Then, the platen **3** is allowed to rotate and the polishing head **61** is allowed to undergo a planetary motion to polish the wafer **W**, while independently adjusting the back-pressure of each of the retainer ring **75** and the wafer **W** onto the polishing pad **4** to an appropriate level by adjusting the inner pressures of the fluid chamber **73** and the space **SP** by means of the first and second pressure adjustment mechanisms **65** and **66**, respectively.

Since the circumference edge **77a** of the elastic membrane **77** is secured by being sandwiched between the retainer ring **75** and the carrier **64** in the polishing head **61** described above, the elastic membrane **77** may be placed on the lower face **64a** of the carrier **64** with a given tension. Accordingly, the elastic membrane **77** itself is not required to be tough for avoiding deformation by the weight of the elastic membrane **77** itself, as has been seen in the conventional art. Since the retainer ring **75** is secured to the carrier **64**, the elastic membrane **77** does not support the weight of the retainer ring **75**, as has been also seen in the conventional art. Consequently, a thin membrane (for example about 0.1 to 2.0 mm in thickness) having an excellent adaptability to deformation may be used for the elastic membrane **77**, making it possible to inflate and deflate the elastic membrane **77** while maintaining adhesive property to the wafer **W**. Accordingly, the wafer **W** can be uniformly pressed onto the polishing pad **4** at a low pressure even when the wafer has an irregular surface configuration, making it possible to polish at a lower pressure than the conventional pressure. Since the elastic membrane **77** can be placed with a simple configuration as described above, the service life of the elastic membrane **77** itself is not adversely affected as in the conventional art. Moreover, since the retainer ring **75** is secured to the carrier **64** having a high rigidity, planarity of the lower face **75a** of the retainer ring **75** making contact with the polishing pad **4** may be improved. Since the polishing accuracy around the wafer **W** is in general largely influenced by the planarity of the lower face of the retainer ring, a better planarity of the polished surface of the wafer **W** can be favorably assured as compared with the conventional art in this embodiment, because planarity of the lower face **75a** of the retainer ring **75** is improved.

Since the space **SP** between the elastic membrane **77** and the carrier **64** is connected to the second pressure adjustment mechanism **66** via the fluid feed passage **79** formed on the carrier **64** in the polishing head **62**. described above, the pressure in the space **SP** can be independently controlled from the pressure in the fluid chamber **73**. Accordingly, the force for pressing the wafer **W** onto the polishing pad **4** and the force for pressing the retainer ring **75** onto the polishing pad **4** may be independently controlled during polishing, thereby enabling the polishing pad **4** to be pressed with a high pressure by the retainer ring **75** when the back-pressure for pressing the wafer **W** onto the polishing pad **4** is lowered. Consequently, the periphery of the wafer **W** contacting the polishing pad **4** is prevented from being distorted during polishing to enable the polishing work to be carried out in good condition.

While one embodiment according to the present invention has been hitherto described, the present invention is not restricted to the embodiment above, but any configurations may be employed in its construction.

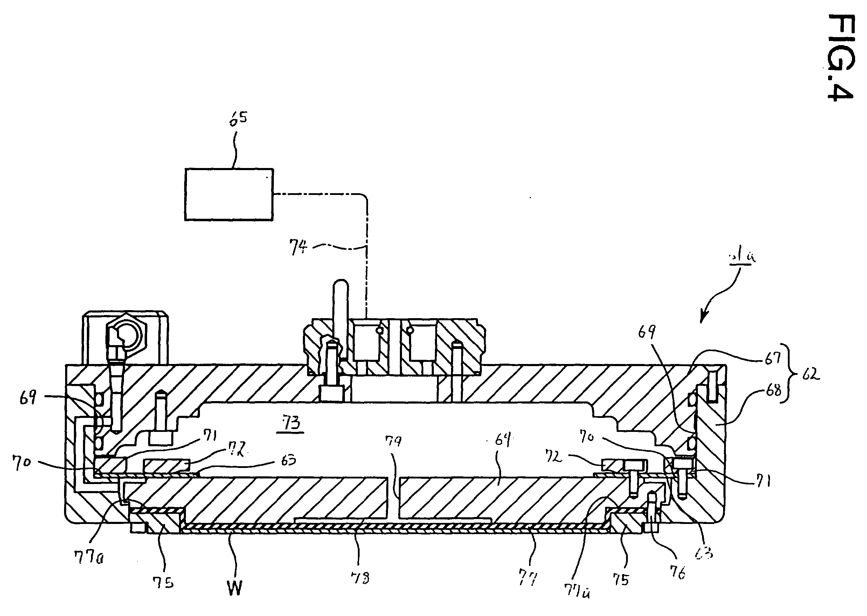

For example, the force for pressing the wafer **W** onto the polishing pad **4**, and the force for pressing the retainer ring **75** onto the polishing pad **4** have been separately controlled to one another by connecting the fluid feed passage **79** to the second pressure adjustment mechanism **66** in the embodiment above. Otherwise, the fluid feed passage **79** may communicate with the fluid chamber **73** as in the polishing head **61a** shown in Fig. 4, thereby controlling both of the force for pressing the wafer **W** onto the polishing pad **4** and the force for pressing the retainer ring **75** onto the polishing pad **4** by the first pressure adjustment mechanism **65**.

Alternatively, the polishing head **61** according to the embodiment above or its modification **61a** may be used for polishing the semiconductor wafer in the semiconductor manufacturing process.

As described previously, semiconductor patterns has been made fine in compliance with high integration of the apparatus in the semiconductor manufacturing process in the recent years. This trend in particular requires fine patterns of a multilayer structure to be easily and securely formed. Consequently, an art for polishing the semiconductor wafer under a low back-pressure has been desired.

When a semiconductor wafer comprising a multilayer structure formed by a combination of various materials such as copper as a wiring material, a Low-k material, and a ceramic such as TaC, Ta and TiN (a barrier metal) is polished by the CMP method while the wiring width is narrowed as described above, polished state inevitably changes during polishing due to difference of rigidity among the materials. Consequently, the effect of change of the polished state should be minimized by reducing the back-pressure against the semiconductor wafer.

However, polishing at a low pressure is made possible using the polishing head **61** or **61a** as described above. Therefore, the polishing head may be favorably used in the semiconductor manufacturing process since it can comply with the requirement of lowering the polishing pressure.

### [Second Embodiment]

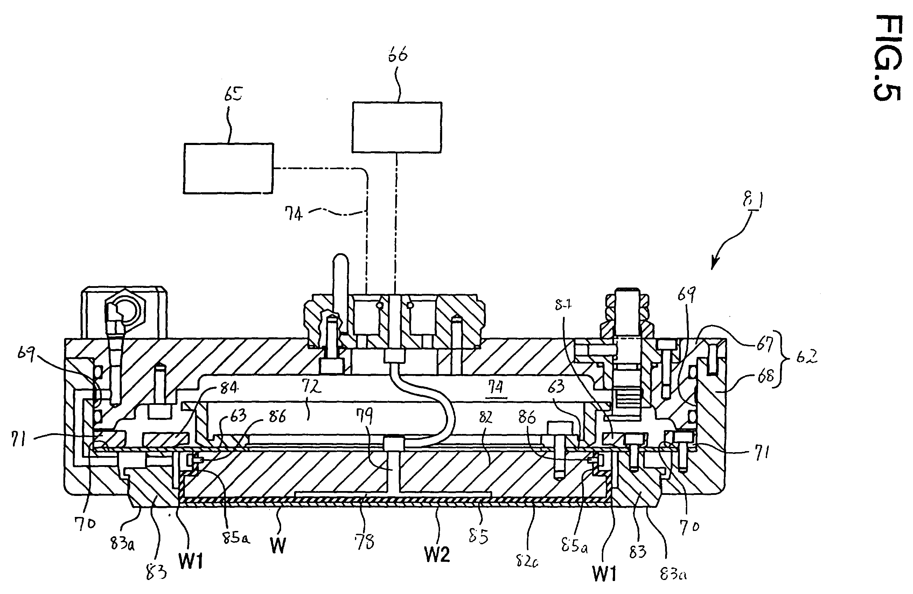

While the second embodiment according to the present invention is described hereinafter with reference to the drawings, the same reference numerals as used in the first embodiment are assigned to the same or similar elements in the second embodiments, and their explanations are omitted. Fig. 5 shows a vertical cross section of the polishing head **81** according to the second embodiment of the present invention.

As shown in Fig. 5, the polishing head **81** is mainly comprises a head body **62**, a diaphragm **63**, a carrier **82**, and first and second pressure adjustment mechanisms **65** and **66**.

The head body **62** comprises an upper mounting plate **67**, and a cylindrical circumference wall **68** provided at downward of the outer circumference of the upper mounting plate **67**. The upper mounting plate **67** I secured in concentric relation to a shaft (not shown) is coupled to a carousel **11** (see Fig. 28; the polishing head **81** may be provided on the polishing apparatus **1** shown in Fig. 27).

A step **70** is provided over the entire circumference on the inner wall **69** of the circumference wall **68**, and a diaphragm **63** is secured with a diaphragm fixing ring **71** on the step **70**.

A carrier **82** comprising a rigid material such as a ceramic is formed into a disk with a given thickness. The carrier **82** is secured to the diaphragm **63** with a diaphragm fixing ring **72** provided on the upper face of the diaphragm **63**.

A fluid chamber **73** is formed between the diaphragm **63** and the head body **62**. The fluid chamber **73** communicates with the first pressure adjustment mechanism **65** via a fluid passage **74** so as to adjust the inner pressure by feeding a fluid such as air.

An annular retainer ring **83** is disposed in a concentric relation to the carrier **82** between the outer circumference of the carrier **82** and the inner wall **69** of the circumference wall **68**. The retainer ring **83** is secured to the diaphragm **63** with a retainer fixing ring **84**.

An elastic membrane **85** is placed in the area surrounded by the retainer ring **83** on the lower face **82a** of the carrier **82**. The circumference edge **85a** of the elastic membrane **85** is adhered and secured to the side face of the carrier **82** with screws **86**, and is expanded over the lower face **82a** of the carrier **82** with a given tension.

A pressurizing pocket **78** is formed on the lower face **82a** of the carrier **82**. The pressurizing pocket **78** is configured so that its lower end is covered with the elastic membrane **85**, and communicate with a fluid feed passage **79** formed in the carrier **82**. The fluid feed passage **79** is connected to the second pressure adjustment mechanism **66**, and the elastic membrane **85** is allowed to vertically inflate and deflate by feeding a fluid such as pressure variable air between the elastic membrane **85** and the carrier **82** via the fluid feed passage **79** using the second pressure adjustment mechanism **66**.

The wafer **W** is able to be absorbed on the lower face of the elastic membrane **85** as shown in Fig. 5 by means of a vacuum absorption device (not shown) in the polishing head **81**. The wafer **W** is absorbed while its outer circumference **W1** is blocked with the retainer ring **83**. The lower face **83a** of the retainer ring **83** is located a slightly downward (0.05 to 1.00 mm) of the lower face **W2** of the absorbed wafer **W**.

For polishing the wafer **W** using the polishing head **81**, the wafer **W** is at first absorbed on the lower face of the elastic membrane **85** using a vacuum absorption device (not shown), and then the lower face of the polishing head **81** is allowed to contact the polishing pad **4**. Only the lower face **83a** of the retainer ring **83** contacts the polishing pad **4** in this step, and the lower face **W2** of the wafer **W** remains a distance apart from the polishing pad **4**.

Then, compressed air is fed into the fluid chamber **73** by driving the first pressure adjustment mechanism **65**. As a result, a pressure from the compressed air is applied from upward of the diaphragm **63** to press the retainer ring **83** secured to the diaphragm **63** onto the polishing pad **4** with a given back-pressure. Simultaneously, the compressed air is sent between the elastic membrane **85** and the carrier **82** by driving the second pressure adjustment mechanism **66**, thereby forming a space **SP** between the elastic membrane **85** and the carrier **82**. The lower face **W2** of the wafer **W** is pressed onto the polishing pad **4** by the pressure of the compressed air in the space **SP**.

The wafer **W** is polished by allowing the platen **3** to rotate and the polishing head **81** to undergo a planetary motion while independently adjusting the back-pressures of the retainer ring **83** and the wafer **W** onto the polishing pad **4** to an appropriate level, respectively, by adjusting the inner pressure of the fluid chamber **73** and the space **SP** with the first and second pressure adjustment mechanisms **65** and **66**, respectively.

The elastic membrane **85** is expanded over the area surrounded by the retainer ring **83** on the lower face **82a** of the carrier **82** in the polishing head **81** described above. The fluid passage **79** for feeding a fluid between the lower face **82a** of the carrier **82** and the elastic membrane **85** is provided in the carrier **82**, and the second pressure adjustment mechanism **66** for adjusting the pressure of the fluid fed between the lower face **82a** of the carrier **82** and the elastic membrane **85** is connected to the fluid feed passage **79**. Consequently, the wafer **W** retained on the lower face of the elastic membrane **85** can be pressed onto the polishing pad **4** by feeding the air (a fluid) between the carrier **82** and the elastic membrane **85** to form the space **SP**, and by adjusting the inner pressure of the space **SP** with the second pressure adjustment mechanism **66**. Since the elastic membrane **85** and the space **SP** are deformed following the planar configuration of the wafer **W**, irregularity of the surface of the wafer **W** is relaxed by the space **SP** to press the wafer onto the polishing pad, thereby allowing the wafer to be accurately pressed. Consequently, decrease of the polishing accuracy due to irregular configuration of the surface of the wafer **W** can be prevented.

While the force for pressing the wafer **W** onto the polishing pad **4** is determined by the fluid pressure in the space **SP**, the force for pressing the retainer ring **83** onto the polishing pad **4** is determined by the fluid pressure in the fluid chamber **17**. Accordingly, the force for pressing the retainer ring **83** onto the polishing pad **4**, and the force for pressing the wafer **W** onto the polishing pad **4**, may be independently controlled with the first pressure adjustment mechanism **65** and the second pressure adjustment mechanism **66**, respectively.

Therefore, the retainer ring **83** can be pressed onto the polishing pad **4** with a higher pressure using the first pressure adjustment mechanism **65**, while the pressure for pressing the wafer **W** onto the polishing pad **4** is remained low. Consequently, the periphery of the wafer **W** contacting the polishing pad **4** is protected from being distorted during polishing by aggressively utilizing the retainer ring **83** to further improve polishing accuracy.

### [Third Embodiment]

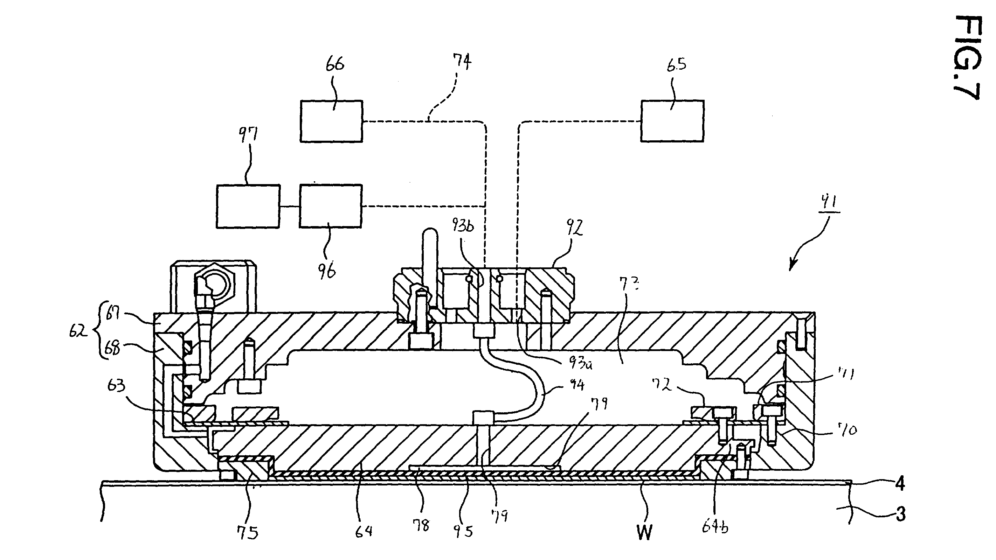

While the third embodiment according to the present invention is described hereinafter with reference to the drawings, the same reference numerals as used in the first and second embodiments are assigned to the same or similar elements in the third embodiments, and their explanations are omitted. Fig. 7 shows a vertical cross section of the polishing head according to the third embodiment of the present invention.

The polishing apparatus according to the present invention comprises almost the same configuration as the conventional polishing apparatus **1** shown in Fig. 27, wherein the polishing head **91** according to the present invention is used in the polishing apparatus (the polishing head **91** may be used in the polishing apparatus **10** shown in Fig. 28).

The polishing head **91** shown in Fig. 7 comprises a head body **62** comprising an upper mounting plate **67** and a cylindrical circumference wall **68**, a diaphragm **63** expanded in the head body **62**, an approximately disk-shaped carrier **64** secured on the lower face of the diaphragm **63**, and an annular retainer ring **75** provided by being located between the lower part of the outer circumference of the carrier **64** and inner wall of the circumference wall **68**. These carrier **64** and retainer ring **75** assumes a floating structure that is made movable toward the head axis line direction by elastic deformation of the diaphragm **63**.

The upper mounting plate **67** of the head body **62** is secured to a shaft **92** as a coupling part for coupling to an arm (not shown) in the polishing apparatus, and first and second fluid passages **93a** and **93b** are vertically formed in the shaft **92**. A step **70** is formed over the entire circumference on the lower part of the inner wall of the circumference wall **68**. The diaphragm **63** is secured on the step **70** formed on the inner wall of the circumference wall **68** with a diaphragm fixing ring **71**.

A fluid chamber **73** is formed upward of the diaphragm **63** in the head body **62**, and communicates with the first fluid passage **93a** formed in the shaft **92**. The pressure in the fluid chamber **73** is adjusted by feeding a fluid such as air from the first pressure adjustment mechanism **65** through the first fluid passage **93a** into the fluid chamber **73**.

A tubing **94** for connecting the second fluid passage **93b** formed in the shaft **92** and the fluid feed passage **79** provided in the carrier **64** are provided in the fluid chamber **73**. The tubing **94** comprises a flexible material, and is provided with an appropriate looseness to permit deformation of the carrier **64** along the head axis line direction accompanied by deformation of the diaphragm **63**.

The carrier **64** is formed of an approximately disk-shaped material, and is secured on the diaphragm **63** with a carrier fixing ring **72** provided on the upper face of the diaphragm **63**. A flange **64b** is provided over the entire outer circumference of the carrier **64**, a pressurizing pocket **78** as an approximately circular recess is provided at the center of the carrier, and the remaining portion of the carrier has a constant thickness. The fluid passage **79** communicating from the pressurizing pocket **78** to the carrier **64** is formed in the carrier **64**. The fluid passage **79** is connected to the second pressure adjustment mechanism **66** through the tubing **94** provided in the fluid chamber **73**, the second fluid passage **93b** on the upper mounting plate **67** of the head body **62**, and a fluid passage **74** to be described hereinafter.

The retainer ring **75** is a member formed into an approximately annular shape, and is attached on the lower face of the flange **64b** of the carrier **64** in concentric relation to the circumference wall **68** and carrier **64** with a slight gap between the inner wall of the circumference wall **68** and the outer circumference of the carrier **64**. The upper end face and the lower end face of the retainer ring **75** is horizontally formed, and the lower face is provided by projecting out of the lower face of the carrier **64** so that it contact the polishing pad **4** during polishing. The degree of projection of the retainer ring **75** relative to the lower face of the carrier **64** is made to be adjustable by, for example, inserting a shim between the retainer ring and the flange **64b** of the carrier **64**.

The elastic membrane **95** forming the space **SP** by dividing the pressurizing pocket **78** from the outside is expanded on the lower face of the carrier **64**. The elastic membrane **95** is made of an approximately circular member such as GORETEX (trade name) comprising a gas-permeable and water proof material that permits permeation of a gas but prohibits permeation of a liquid. The membrane is attached to be airtight to the carrier **64** by inserting its outer circumference edge between the lower face of the flange **64b** of the carrier **64** and the upper face of the retainer ring **75**.

The outer circumference portion of the elastic membrane **95** is formed to be an airtight portion **95** including the portion receiving the outer circumference portion of the wafer **W**. Suppose the depth **D1** of the positioning notch **N** provided on the wafer **W** be, for example, about 1.5 to 2.0 mm, then an overlapping width **D2** of about 3.0 mm is secured between the airtight portion **95** and the outer circumference portion of the wafer **W**. The method for forming the airtight portion **95a** on the elastic membrane **95** comprises applying a filling processing on the outer circumference portion of the elastic membrane **95** by rubber or a resign coating, adhering a sheet comprising an airtight material on the outer circumference portion (a lamination processing), or constructing only the inner circumference portion of the elastic membrane **95** with a gas-permeable and waterproof material while constructing the outer circumference portion with an airtight material.

The second pressure adjustment mechanism **66** is connected to the second fluid passage **93b** formed in the shaft **92** of the head body **62** through the fluid passage **74**, and adjusts the inner pressure by feeding or sucking a gas into or from the space (the upper face side of the elastic membrane **95**) including the space **SP** between the carrier **64** and the elastic membrane **95**.

A pressure gauge **96** for measuring the inner pressure of the fluid passage **74** (substantially, the inner pressure of the space **SP**) is provided in the fluid passage **74**.

A wafer sensing device **97** is connected to the pressure gauge **96**. The wafer sensing device **97** compares the measured value V of the pressure gauge **96** with reference pressures Vs and Vv measured when the second pressure adjustment mechanism **66** is supplying to and sucking from the air, respectively. Whether the wafer **W** is at least either not properly retained or the wafer **W** is cracked is sensed by deciding that the measured value V is not attained to the respective reference pressures. The reference pressure as used herein is the attained inner pressure of the space **SP** when the wafer **W** is at least properly retained and the wafer **W** is not cracked. The reference pressure Vs corresponds to the pressure when the gas is being fed, and the reference pressure Vv corresponds to the pressure when the gas is being sucked. These reference pressures may be either experimentally determined, or by a an analysis method from the minimum attainable pressure for absorbing or pressing the wafer **W**.

The polishing head **91** so configured as described above is coupled to the polishing apparatus by attaching its shaft **92** to a spindle (not shown).

The wafer **W** is polished using the polishing head **91** as follows.

At first, the wafer **W** is brought into contact with the elastic membrane **95** provided on the lower face of the carrier **64** by means of a loading apparatus (not shown), and then the inner pressure of the space **SP** is reduced below the atmospheric pressure using the second pressure adjustment mechanism **66**. Since the elastic membrane **95** permits gas permeation, the air between the wafer **W** and the elastic membrane **95** is sucked through the elastic membrane **95** to allow the wafer **W** to be absorbed on the lower surface of the elastic membrane **95**.

When the wafer **W** is not properly retained on the polishing head **91**, the atmospheric air flows into the space **SP** through the gap formed between the elastic membrane **95** and the wafer **W**. Consequently, the inner pressure is not decreased to the reference pressure Vv when the second pressure adjustment mechanism **66** is sucking. Accordingly, the wafer **W** is decided to be properly retained on the polishing head **91** when the measured value V does not attain the reference pressure Vv, after measuring the attained inner pressure of the space **Sp** with the pressure gauge **96** followed by comparing the measured value V of the pressure gauge **96** with the reference pressure Vv by means of the wafer detector **97**. When the wafer **W** is not properly retained, retention of the wafer **W** on the polishing head **91** is corrected to a proper level by repeating the absorption operation again so that the wafer **W** is not polished without properly retaining it, or so that the wafer **W** is not dropped during transfer of the wafer.

Since the airtight portion **95a** is provided at the outer circumference of the elastic membrane **95**, leak of the gas (air) from the portion receiving the outer circumference portion of the wafer **W** is prevented or reduced when the wafer **W** is properly retained, permitting favorable retention of the wafer **W**. Since the attainable inner pressure in the space **SP** largely differs when the wafer **W** is properly retained or when it is not retained, more accurate sensing whether the wafer **W** is properly retained or not is enabled.

Then, the wafer **W** is transferred onto the polishing pad **4** by allowing the wafer polishing pad **91** to travel with an arm (not shown) to allow the wafer **W** to contact the polishing pad **4**. The wafer **W** comes in contact with the polishing pad **4** whose surface is adhered on the platen **3** while the periphery of the wafer **W** is blocked by the retainer ring **75**.

Any materials that has been used for polishing the wafer may be also used for the polishing pad **4**. The materials available comprises, for example, a velour type pad prepared by impregnating a non-woven fabric comprising polyester with a soft resign such as a polyurethane resign, a suede type pad prepared by forming a resign foam layer comprising polyurethane foam on a base non-woven fabric made of polyester, and a resign foam sheet comprising isolated polyurethane foams.

The platen **3** is allowed to revolve and the polishing head **91** is allowed to rotate while controlling the pressure for pressing the wafer **W** onto the polishing pad **4** by the back-pressure of the carrier **64** and the retainer ring **75** onto the polishing pad **4**, and by the gas pressure applied on the upper face of the wafer **W** by means of the second pressure adjustment mechanism **66**. Simultaneously, the wafer is polished by feeding a slurry **S** on the surface of the polishing pad **4** and on the surface of the wafer **W** to be polished.

The pressing force by the second pressure adjustment mechanism **66** is generated by allowing the gas fed into the space including the space **SP** between the elastic membrane **95** and the carrier **64** to directly press the upper face of the wafer **W** through the elastic membrane **95**. Since the airtight portion **95a** is provided at the circumference of the elastic membrane **95**, leak of the gas from the portion receiving the outer circumference of the wafer **W** is blocked or reduced to allow the entire surface of the wafer **W** to be pressed with a uniform pressure onto the polishing pad **4**.

When the wafer is out of the polishing head **91**, or when the wafer **W** is cracked, during polishing the wafer **W**, the gas fed from the second pressure adjustment mechanism **66** leaks out through the gap between the wafer **W** and the elastic membrane **95**, or through the crack on the wafer **W**. As a result, the inner pressure in the space **SP** does not increase to the reference pressure Vs during feed of the gas. Consequently, the wafer **W** is decided whether it is not properly retained on the polishing head **91**, or the wafer **W** is cracked, when the measured value V has not attained the reference pressure Vs by comparing the measured value V by the pressure gauge **96** with the reference pressure Vs using the wafer detector **97** after measuring the attained inner pressure in the space **SP** with the pressure gauge **96**. When the measured value V has not attained the reference pressure Vs, operation of the polishing apparatus is halted to prevent the wafer **W** fallen down from the polishing pad **91** from being thrown off from the polishing pad **4**, or the debris of the cracked wafer **W** from scattering.

The polishing work is resumed after allowing the wafer **W** to be properly retained on the polishing head **91** when the wafer **W** has been decided not to be properly retained. When the wafer **W** is cracked, the polishing work is resumed starting from the step for allowing a fresh wafer **W** to absorb after removing the debris of the wafer **W** on the polishing apparatus.

The wafer **W** is absorbed by the polishing head **91** for carrying the wafer that has been polished out of the polishing pad **4** as described previously. The wafer **W** may be sensed whether it is properly retained or not as described above. Accordingly, the operation of the polishing pad is halted when the wafer **W** has been detected to be left behind on the polishing pad **4**, in order to prevent the wafer **W** that has come out of the polishing head **91** from being thrown off from the polishing pad **4**. The transfer operation of the wafer **W** is resumed after allowing the wafer **W** to be properly retained on the polishing head **91**.

The atmospheric air is sucked by the pressure adjustment mechanism **66** through the elastic membrane **95** while the tip of the head and the wafer **W** contact the polishing head **4**. However, since the elastic membrane **95** only permits the air to pass through, foreign substances such as the slurry **S** are not sucked into the polishing head **91**, irrespective of whether the wafer **W** is properly retained or not.

According to the polishing head **91** and the polishing apparatus using the polishing head so configured as described above, whether the wafer **W** is properly retained or not, or whether the wafer **W** is cracked or not, may be sensed over the entire work area for transferring the wafer **W**, and for polishing the wafer **W**, while polishing head **91** operates under a good condition by blocking the slurry from invading into the polishing head **91**.

When the wafer **W** is properly retained, leak of the gas (including air) at the portion receiving the periphery of the wafer **W** is prevented or reduced. Therefore, the entire surface of the wafer **W** may be pressed onto the polishing pad **4** during polishing the wafer to improve machining accuracy of the wafer **W**. Also, the wafer **W** is securely retained by allowing the suction pressure of the second pressure adjustment mechanism **66** to effect during absorption of the wafer **W**.

Whether the wafer **W** is properly retained or not can be more accurately sensed from the large difference of the attained inner pressure of the space **SP**.

The effects as described above may be realized without providing complex mechanisms in the polishing head **91** to enable the facility cost to be reduced.

In the embodiment as set forth above, the pressurizing pocket **78** connected to the second pressure adjustment mechanism **66** via the fluid feed passage **79** is provided at near the center of the carrier **64**, and the space **SP** is formed between the pressurizing pocket **78** and the elastic membrane **95**. However, the present invention is not restricted to the embodiment as set forth herein, but the position and configuration of the pressurizing pocket **78** may be arbitrarily selected, or the pressurizing pocket **78** may be removed. Alternatively, the air may be directly fed to and sucked from the entire lower face of the carrier **64** by providing a shunt at the lower end of the fluid feed passage **79** after eliminating the pressurizing pocket **78**.

### [Fourth Embodiment]

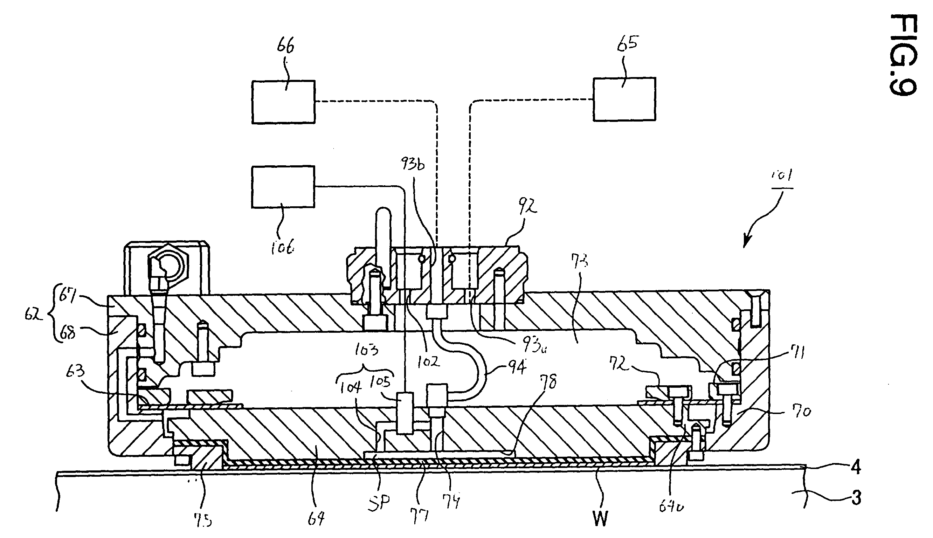

While the fourth embodiment according to the present invention is described hereinafter with reference to the drawings, the same reference numerals as used in the first to third embodiments are assigned to the same or similar elements in the fourth embodiments, and their explanations are omitted. Fig. 9 shows a vertical cross section of the polishing head according to the fourth embodiment of the present invention. The polishing apparatus according to the present invention is constructed to be approximately similar to the conventional polishing apparatus **1** shown in Fig. 27, and the polishing head **101** according to the present invention is also used herein (the polishing head **101** may be used in the polishing apparatus **10** shown in Fig. 28).

In Fig. 9, the polishing head **101** according to the present invention comprises a head body **62** comprising an upper mounting plate **67** and a cylindrical circumference wall **68**, a diaphragm **63** expanded in the head body **62**, an approximately disk-shaped carrier **64** secured on the lower face of the diaphragm **63**, and an annular retainer ring **75** located between the circumference wall **68** and the inner wall. The carrier **64** and the retainer ring **75** has a floating structure movable toward the head axis line direction by elastic deformation of the diaphragm **63**.

The upper mounting plate **67** of the head body **62** is secured in concentric relation to the shaft **92** as a coupling member for coupling with an arm (not shown) of the polishing apparatus. First and second fluid passages **93a** and **93b**, and a wiring insertion passage **102** are formed along the vertical direction in the shaft **92**. An exterior thread is formed, for example, on the outer circumference of the shaft **92**, which is coupled to the arm by screwing into a spindle (not shown) provided on the arm (connection between the shaft **92** and the arm is not restricted to the structure above, but they may be coupled to one another by arbitrary methods). A step **70** is formed over the entire circumference on the lower part of the inner wall of the circumference wall **68**.

The diaphragm **63** is secured on the step **70** formed on the lower part of the inner wall of the circumference wall **68** with a diaphragm fixing ring **71**.

A fluid chamber **73** is formed upward of the diaphragm **63** in the head body **62**, and communicates with the first fluid passage **93a** and the wiring insertion passage **102** formed in the shaft **92**. The pressure in the fluid chamber **73** is adjusted by feeding a fluid such as air into the fluid chamber **73** from the first pressure adjustment mechanism **65** through the first fluid passage **93a**.

A tubing **94** for connecting the second fluid passage **93b** formed in the shaft **92** to the fluid feed passage **79** provided in the carrier **64** is provided in the fluid chamber **73**.

The carrier **64** is secured to the diaphragm **63** with a carrier fixing ring **72** provided on the upper face of the diaphragm **63**. A pressurizing pocket **78** as an approximately circular recess is provided at the center of the lower face of the carrier **64**. A fluid feed passage **79** communicating with the carrier **64** is formed at near the center of the pressurizing pocket **78**. The fluid feed passage **79** is connected to the second pressure adjustment mechanism **66** through the tubing **94** provided in the fluid chamber **73** and the second fluid passage **93b** of the upper mounting plate **67** in the head body **62**.

An elastic membrane **77** (a flexible member) for forming a space **SP** by dividing a pressurizing pocket **78** from the outside is expanded over the lower face of the carrier **64**.

The elastic membrane **77** is attached to be airtight to the carrier **64** by inserting its outer circumference edge between the lower face of a flange **64b** of the carrier **64** and the upper face of the retainer ring **75**.

A differential pressure measuring device **103** for measuring the differential pressure between the inner pressure of the space **SP** at the outer circumference of the pressurizing pocket **78** and the inner pressure in the fluid feed passage **79** is provided on the carrier **64**.

The differential pressure measuring device **103** comprises a communication hole **104** for connecting the outer circumference side of the pressurizing pocket **78** to the fluid feed passage **79**, and a differential pressure gauge **105** for measuring the differential pressure between the two compartments formed by dividing the communication hole **104** into the fluid feed passage **79** side from the outer circumference side of the pressurizing pocket **78**.

A wafer sensing device **106** is connected to the differential pressure gauge **105** through the wiring insertion passage **102** provided on the upper mounting plate **67** of the head body **62**. The wafer sensing device **106** decides that the wafer **W** is not retained on the polishing head **101** by receiving a signal indicating that the differential pressure gauge sensed a differential pressure, and that the wafer **W** is retained on the polishing head **101** by receiving a signal indicating that the differential pressure gauge did not sensed a differential pressure.

The second pressure adjustment mechanism **66** adjusts the inner pressure of a space by feeding or withdrawing a fluid to the space between the carrier **64** including the space **SP** and the elastic membrane **77**.

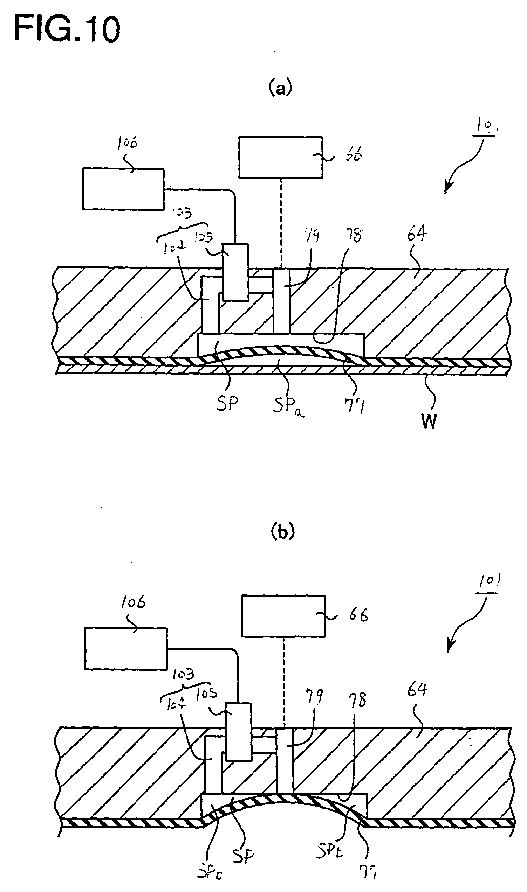

The second pressure adjustment mechanism **66** depresses the elastic membrane **77** toward the pressurizing pocket **78** as shown in Fig. 10A by lowering the inner pressure of the space **SP** below the atmospheric pressure while the lower face of the membrane **36** is allowed to be adhered on the wafer **W**. A space **Spa** having a lower inner pressure than the atmospheric pressure is created between the elastic membrane **77** and the wafer **W** to allow the elastic membrane **77** to serve as a suction cup.

Elasticity of the elastic membrane is adjusted so that the elastic membrane **77** is only deformed to an extent not to close the fluid feed passage **79** as shown in Fig. 10A when the wafer **W** is adhered on the lower face of the membrane (wafer retaining state) for retaining the wafer **W**; and the fluid feed passage **79** at the center of the pressurizing pocket **78** is closed while leaving a closed space **SPb** at the outer circumference of the pressurizing pocket **78** as shown in Fig. 10B, by allowing the membrane to further depress toward the inside of the pressurizing pocket **78** when the space **Spa** communicates the outer space (the non-retaining state).

The amount or the suction pressure for allowing the second pressure adjustment mechanism to withdraw a fluid from the space **SP** for retaining the wafer **W** is not absolutely specified, provided that the fluid in the fluid feed passage **79** is further sucked while the fluid feed passage **79**, formed at the center of the pressurizing pocket **78** for forming the space **SP** by the elastic membrane **77**, is closed. Since the volume of the space **SPa** formed between the elastic membrane **77** and the wafer **W** is extremely smaller than the volume of the space **SP**, the air in the space **SPa** does not inflate at a suction pressure as described above to an extent to permit the elastic membrane **77** to close the fluid feed passage **79**, eliminating the possibility of closing the fluid feed passage **79**.

The polishing head **101** so configured as described above is coupled to the polishing apparatus by coupling the shaft **92** to an arm (not shown). When the wafer **W** is polished using the polishing head **101**, the wafer **W** is at first allowed to contact the elastic membrane **77** provided on the lower face of the carrier **64** by means of a loading device (not shown). The inner pressure of the space **SP** is lowered with the second pressure adjustment mechanism **66** while the wafer **W** is contacting to retain the wafer **W**.

Then, the wafer **W** is transferred onto the polishing pad **4** by allowing the polishing head **101** to travel by an arm.

The wafer **W** then comes in contact with the polishing pad **4** whose surface is adhered on the upper face of the platen **3**, while the periphery of the wafer **W** is blocked by the retainer ring **75**.

The wafer **W** is polished by the steps comprising: adjusting the pressure for pressing the wafer **W** onto the polishing pad **4** by the back-pressure applied on the polishing pad **4** from the carrier **64** and the retainer ring **75**, and by the back-pressure applied on the elastic membrane **77** from the second pressure adjustment mechanism **66**; allowing the platen **3** to revolve while allowing the polishing head **101** to rotate; and simultaneously feeding the slurry **S** on the surface of the polishing pad **4** and on the surface of the wafer **W** to be polished from a slurry feed device (not shown).

Whether the wafer **W** is properly retained or not is sensed as follows using the polishing head **101** so configured as described above.

At first, the inner pressure of the space **SP** provided on the lower face of the carried **64** is lowered below the atmospheric pressure using the second pressure adjustment mechanism **66**, thereby allowing the elastic membrane **77** to depress as a recess toward the inside of the pressurizing pocket **78** to retain the wafer **W**.

When the wafer is retained, the degree of deformation of the elastic membrane **77** is very small since air scarcely flows from the outside into the space **SPa** formed between the wafer **W** and the elastic membrane **77** (see Fig. 10A).

When the wafer is not retained, on the contrary, air flows into the space **SPa** formed between the wafer **W** and the elastic membrane **77**. Consequently, the inner pressure of the space **SPa** comes close to the atmospheric pressure and becomes larger than the pressure when the wafer **W** is retained. As a result, the difference of the inner pressures between the space **SPa** and the space **SP** turns out to be larger than the difference when the wafer **W** is retained, and the elastic membrane **77** depresses toward the inside of the space **SP** as shown in Fig. 10B to close the fluid feed passage **79** provided at near the center of the space **SP**. A closed space **SPb** is left behind at the outer circumference of the pressurizing pocket **78** of the space **SP**. Since the inner pressure of the closed space **SPb** is not further reduced because the fluid feed passage **79** is closed, a differential pressure is created between the inner pressure of the closed space **SPb** and the pressure in the fluid feed passage **79**, or the suction pressure of the second pressure adjustment mechanism **66**. This differential pressure may be increased to an extent to facilitate measurement by the differential pressure measuring device **103**, by sufficiently increasing the suction pressure of the second pressure adjustment mechanism **66**.

The wafer sensing device **106** decides that the polishing head **101** does not retain the wafer **W** when the differential pressure measuring device **103** receives a signal generated by sensing the differential pressure between them. Alternatively, wafer sensing device **106** decides that the fluid feed passage **79** is not closed, or the polishing head **101** retains the wafer **W**, when the differential pressure is not sensed, thus sensing whether the wafer **W** is retained or not.

According to the polishing head **101** so configured as described above or the polishing device using the polishing head, whether the wafer is properly retained on the polishing head **101** or not is determined by sensing whether a differential pressure is created between the inner pressure of the space **SP** at the outer circumference of the pressurizing pocket **78** of the carrier **64** and the suction pressure of the second pressure adjustment mechanism **66**. Since this differential pressure can be increased to an extent to facilitate sensing by increasing the suction pressure of the second pressure adjustment mechanism **66**, whether the wafer **W** is properly retained or not may be accurately sensed.

The operation of the sensor is assured by ensuring the absorption force of the wafer **W** by, for example, keeping the suction pressure of the second pressure adjustment mechanism **66** constant.

Since the differential pressure between the inner pressure of the space **SP** and the suction pressure of the second pressure adjustment mechanism **66** is used as a criteria for deciding whether the wafer **W** is properly retained or not, the reference pressure for deciding whether the wafer **W** is properly retained or not is not required to be experimentally determined, enabling the adjustment work to be simple.

Since the effects as described above is realized without making the construction of the polishing head complex, the manufacturing cost and maintenance cost of the polishing head may be reduced.

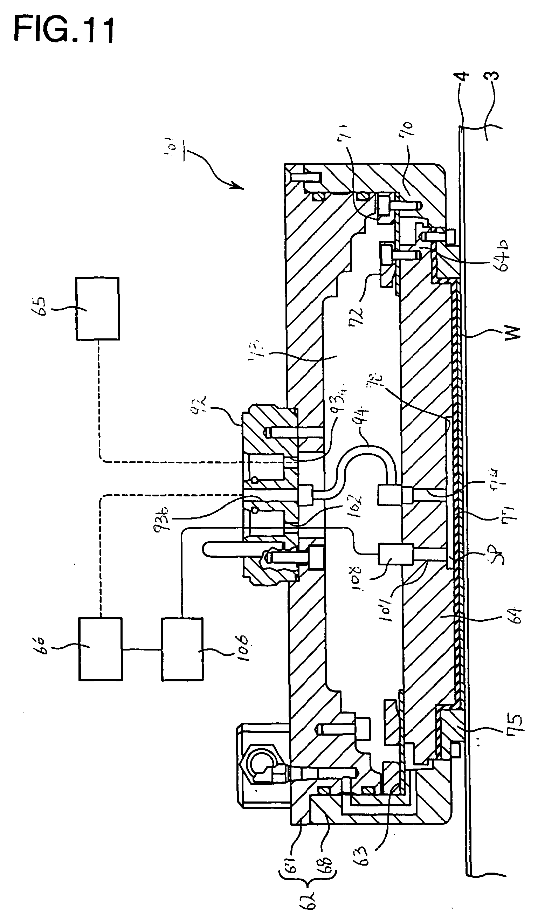

A communication hole **104** communicating the fluid feed passage **79** with outer circumference of the pressurizing pocket **78** of the space **SP**, and a differential pressure gauge **105** provided at the communication holes **104** were used for the differential pressure measuring device **103** in the foregoing embodiment. However, the device is not restricted thereto, but a pressure gauge **108** is connected to the outer circumference of the pressurizing pocket **78** of the space **SP** via the communication hole **107** in place of providing the differential pressure measuring device **103** as shown in Fig. 11. The wafer sensing device **106** also serves as a differential pressure measuring device in this case for measuring the differential pressure by comparing the measured value of the pressure gauge **108** with the suction pressure of the second pressure adjustment mechanism **66**.

Either the setting pressure of the second pressure adjustment mechanism **66**, or the measured value of the pressure gauge provided at either the second pressure adjustment mechanism **66** or the fluid passage **33** may be used for the suction pressure of the second pressure adjustment mechanism **66**.

The differential pressure gauge **105** or the pressure gauge **108** may be provided at outside of the head body **62**, by extending the communication hole **104** or the communication hole **107** to outside of the head body **62** using a tubing.

The pressurizing pocket **78** forming the space **SP** is not always provided at the center of the lower face of the carrier **64**, but may be provided at the lower face of the carrier **64** as an annular groove. The elastic membrane **77** also deforms in this case in the cross section of the pressurizing pocket **78** as shown in Figs. 10A and 10B.

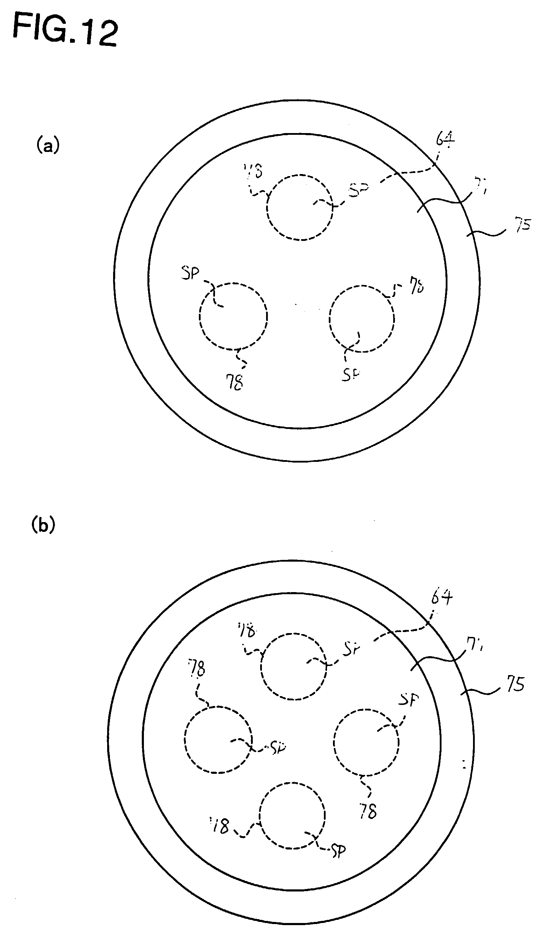

A plurality of the pressurizing pockets **78** may be provided on the lower face of the carrier **64** as shown in Figs. 12A and 12B to form a plurality of the spaces **SP** on the lower face of the carrier **64** utilizing this pressurizing pockets **78** and the elastic membrane **77**. Figs. 12A and 12B show the tip of the polishing head **101** (only the inner circumference side of the retainer ring is illustrated). Any number of the spaces **SP** may be provided herein, and the second pressure adjustment mechanism **66** is naturally connected to each pressurizing pocket **78** through respective fluid feed passages **79** while providing the differential pressure measuring devices **103**.

The wafer sensing device **106** may be so configured as to sense whether the wafer **W** is retained or not, by the number of the spaces **SP** of these plural spaces **SP** where the differential pressure between the suction pressure of the second pressure adjustment mechanism **66** and the inner pressure of the space **SP** at the outer circumference of the pressurizing pocket **78** is sensed by the differential pressure measuring devices **103**.

The retention state of the wafer **W** may be decided in detail based on the number of the spaces **Sp** where the differential pressure is sensed during retaining the wafer. In other words, when the number of the spaces **SP** where the differential pressure is sensed has attained the prescribed number, for example when the differential pressure is sensed at about a half of the spaces **SP**, retention of the wafer is decided to be insufficient or the wafers are not retained at all.

The wafer sensing device **106** may be configured such that whether the wafer **W** is retained or not is sensed by considering the positional relation among the spaces **SP** of the plural spaces **SP** where the differential pressure between the suction pressure of the second pressure adjustment mechanism **66** and the inner pressure of the space **SP** at the outer circumference of the pressurizing pocket **78** is sensed by the pressure measuring device **103**.

The retention state of the wafer **W** may be precisely decided by the positional relation among the spaces **SP** where the differential pressure has been sensed. When a differential pressure is sensed between the adjoining spaces **SP**, it shows that a bias is generated in the balance of retention of the wafer **W**. Accordingly, the wafer is insufficiently retained to decide that the wafer is not retained. When a differential pressure is sensed among plural spaces **SP** not adjoining to one another, retention of the wafer **W** may be balanced. Therefore, whether the wafer **W** is retained or not is decided depending on the number of the spaces **SP** where a differential pressure has been sensed.

The decision criteria of the wafer sensing device **106** may be arbitrarily determined, if necessary.

### [Fifth Embodiment]

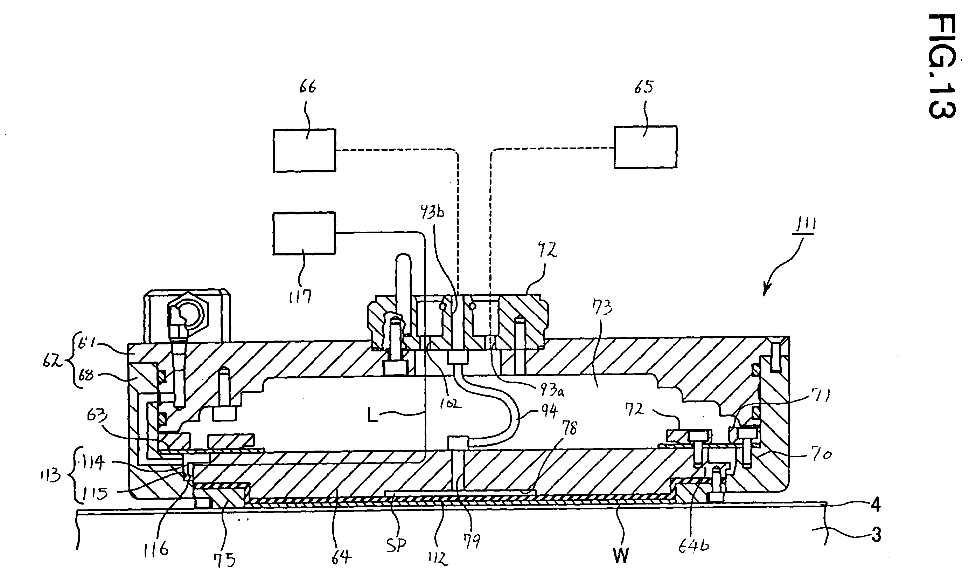

While the fifth embodiment according to the present invention is described hereinafter with reference to the drawings, the same reference numerals as used in the first to forth embodiments are assigned to the same or similar elements in the fifth embodiments, and their explanations are omitted. The fifth embodiment according to the present invention is described hereinafter with reference to the drawings. The polishing apparatus according to the present invention is constructed to be approximately similar to the conventional polishing apparatus **1** shown in Fig. 27, and the polishing head **111** in the vertical cross section shown in Fig. 13 is also used herein (the polishing head **111** may be used in the polishing apparatus **10** shown in Fig. 28).

The polishing head **111** shown in Fig. 13 comprises a head body **62** comprising an upper mounting plate **67** and a cylindrical circumference wall **68**, a diaphragm **63** almost vertically expanded, for example, against the head axis line, an approximately disk-shaped carrier **64** secured on the lower face of the diaphragm **63**, and an annular retainer ring **75** located between the lower portion of the outer circumference of the carrier **64** and the inner wall of the circumference wall **68** and integrated with the carrier **64**.

The carrier **64** and the retainer ring **75** assumes a floating structure movable toward the head axis line direction by elastic deformation of the diaphragm **63**.

The upper mounting plate **67** of the head body **62** is secured in concentric relation to a shaft **92** as a coupling member for coupling to an arm (not shown) in the polishing apparatus, and first and second fluid passage **93a** and **93b**, and a wiring insertion passage **102** are formed along the vertical direction in the shaft **92**. A step **70** is formed over the entire circumference on the lower part of the inner wall of the circumference wall **68**.

The diaphragm **63** is secured on the step **70** formed on the inner wall of the circumference wall **68** with a diaphragm fixing ring **71**. The diaphragm **63** is not necessarily expanded to be approximately vertical to the head axis line.

A fluid chamber **73** is formed above the diaphragm **63**. The fluid chamber **73** communicates with a first fluid passage **93a** and a wiring insertion passage **102** formed in the shaft **92**.

A tubing **94** for connecting the second fluid passage **93b** formed in the shaft to the fluid feed passage **79** provided in the carrier **64** is provided in the fluid chamber **73**.

The carrier **64** is secured to the diaphragm **63** by a sub-carrier fixing ring **72** provided on the upper face of the diaphragm **63**. A pressurizing pocket **78** as an approximately circular recess is provided at the center of the carrier **64**, and a fluid feed passage **79** communicating from the pressurizing pocket **78** to the upper face of the carrier **64** is also formed.

The fluid feed passage **79** is connected to a second pressure adjustment mechanism **66** through the tubing **94** provided in the fluid chamber **73** and the second fluid passage **93b** on the upper mounting plate **67** of the head body **62**.

The retainer ring **75** is secured on the lower face of a flange **64b** of the carrier **64** in concentric relation to the circumference wall **68** and the carrier **64**.

An elastic membrane **112** (a flexible member) for forming a space **SP** by dividing the pressurizing pocket **78** from the outside is expanded over the lower face of the carrier **64**. The elastic membrane **112** is a sheet member comprising, for example, a flexible material such as a fiber reinforced rubber as in the diaphragm **63**, and is attached to be airtight to the carrier **64** by inserting its outer circumference edge between the lower face of the flange **64b** of the carrier **64** and the upper face of the retainer ring **75**. The elastic membrane **112** may be so configured as to permit ventilation of a gas between the space **SP** and its outside, by providing an opening for communicating the space **SP** with the outside, or by constructing the elastic membrane **112** with a flexible and gas-permeable material such as GORETEX (a trade name).

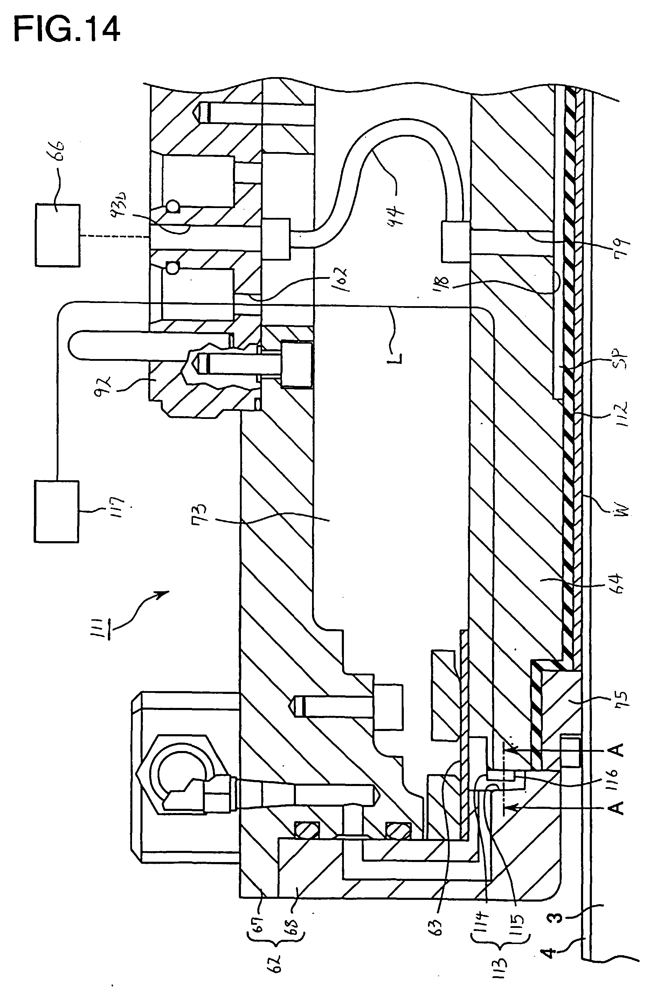

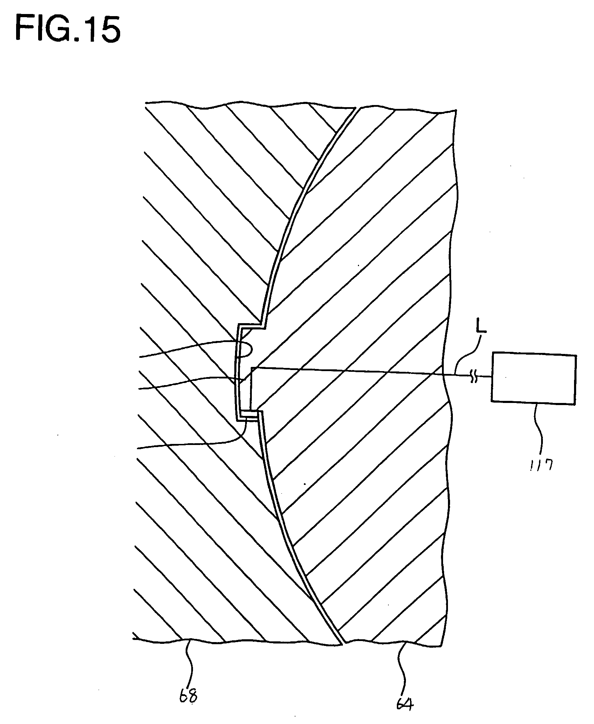

As shown in Figs. 14 and 15, an engage member **113** is provided between the outer circumference of the flange **64b** of the carrier **64** and the inner face of the head body **62**, in order to prevent the carrier **64** from being rotated by suffering a polishing resistance during polishing.

Fig. 14 is an enlarged drawing of the main part in Fig. 13, and Fig. 15 is a cross section viewed along the arrow A-A in Fig. 14. An engaging projection **114** is provided at the outer circumference of the flange **64b** of the carrier **64**, and an engaging groove **115** is provided at the inner face side of the head body **62** as the engaging members **113** in this embodiment. It is desirable that the engaging members **113** are disposed at two or more sites with a symmetrical relation to the center of rotation of the carrier **64**, if possible, in order to be able to securely support the carrier **64**.

A sensor **116** is provided between the engaging projection **114** and the engaging groove **115** for measuring the force along the direction of rotation acting between them. A computing unit **117** provided at outside of the head body **62** is connected to the sensor **116**. A pressure sensing type sensor such as a piezoelectric element and a distortion gauge, or a shear force sensing type sensor, provided by bridging between the engaging projection **114** and engaging groove **115** and sensing the force along the direction of rotation from the shear force received by a relative movement between the carrier **64** and the head body **62**, is used for the sensor **116**.

The computing unit **117** calculates the polishing resistance acting on the wafer **W** or the retainer ring **75** retained on the carrier **64** based on the measured value of the sensor **116**, or from the difference between the total polishing resistance and the polishing resistance received by the retainer ring **75**. The computing unit also controls each part of the polishing unit based on information as described above so that the wafer is polished under an optimum condition.

When a plurality of the engage members **113** and sensors **116** are provided, the computing unit **117** averages respective measured values with respect to these sensors **116** for improving measuring accuracy, and the averaged value is used for the pressure level.

A pressure sensing type sensor is used for the sensor **116** in this embodiment, and the sensor **116** is provided on the face opposed to the direction of rotation of the head body **62** at the engaging projection **114**. The wiring **L** for connecting the sensor **116** to the computing unit **117** reaches, for example, from the sensor **116** through the inside of the carrier **64** into the fluid chamber **73** of the head body **62**, and is connected from the fluid chamber **73** to the computing unit **117** through the wiring insertion passage **102** provided in the shaft **92** of the head body **62**.

The second pressure adjustment mechanism **66** is provided in order to adjust the inner pressure of the space by feeding or withdrawing a fluid into or from the space including the space **SP** between the carrier **64** and the elastic membrane **112**.

The second pressure adjustment mechanism **66** presses the elastic membrane **112** toward outside by increasing the inner pressure of the space between the carrier **64** and the elastic membrane **112** during polishing the wafer **W**, thereby pressing the entire surface of the wafer **W** onto the polishing pad **4** of the polishing apparatus under a uniform pressure with the lower surface of the elastic membrane **112**. The second pressure adjustment mechanism **66** directly applies the pressure of a fluid on the upper face of the wafer **W** through the elastic membrane **112**, when the elastic membrane **112** is made of a gas-permeable material.

The pressure applied by the second pressure adjustment mechanism **66** is adjusted so that the wafer **W** is pressed onto the polishing pad **4** with an optimum pressure. The second pressure adjustment mechanism **66** also allows the elastic membrane **112** to function as a suction cup for absorbing the wafer **W**, by lowering the inner pressure of the space **SP** below the atmospheric pressure while the wafer **W** is allowed to be adhered on the lower face of the elastic membrane **112** to depress the elastic membrane **112** toward the inside of the pressurizing pocket **78**. The second pressure adjustment mechanism **66** permits the wafer **W** to be absorbed via the elastic membrane **112** by sucking the air between the elastic membrane **112** and the wafer **W** trough the elastic membrane **112**, when the elastic membrane **112** is air-permeable.

The polishing head **111** so configured as described above is coupled to the polishing apparatus by connecting the shaft **92** to a spindle provided on an arm (not shown). When the wafer **W** is polished using the polishing head **111**, the wafer **W** is at first allowed to contact the elastic membrane **112** provided on the lower face of the carrier **64** using a loading device (not shown). The elastic membrane **112** is depressed toward inside of the pressurizing pocket **78** by lowering the inner pressure of the space **SP** by means of a second pressure adjustment mechanism **66**, and the wafer **W** is retained by allowing the membrane to serve as a suction cup for absorbing the wafer **W**.

Then, the wafer **W** is transferred onto the polishing pad **4** by allowing the polishing head **111** to travel by the arm.

The wafer **W** is made to come in contact with a polishing pad **4** adhered on the upper face of the platen **3**, while the periphery of the wafer is blocked by the retainer ring **75**.

The platen **3** is allowed to revolve and the polishing head **111** is allowed to rotate while the pressure for pressing the wafer **W** onto the polishing pad **4** is adjusted by the back-pressure of the carrier **64** and the retainer ring **75** onto the polishing pad **4**, and by the back-pressure applied on the elastic membrane **112** by the second pressure adjustment mechanism. The wafer **W** is polished by simultaneously feeding a slurry **S** from a slurry feed device (not shown) onto the surface of the polishing pad **4** and the surface of the wafer **w** to be polished. When the center of the wafer **W** tends to be excessively polished to form a concave portion on the wafer, the rotation speed of the outer circumference side of the wafer **W** relative to the polishing pad, or the polishing speed, is made to be higher than the polishing speed of the inner circumference side of the wafer **W** by increasing the rotation speed of the polishing head **111**, thereby increasing the polished quantity at the outer circumference side of the wafer **W**. A rotation force is created by the rotation of the polishing head **111** on the carrier **64** and the retainer ring **75** retaining the wafer **W** under the polishing condition of the wafer **W** as described above. While this force applies a force to twist the diaphragm **63** on which the carrier and the retainer ring are attached, twist of the diaphragm **63** is restricted by receiving the force by the engaging member **113**.

The polished sate of the wafer **W** in the polishing head **111** so configured as described above is determined as follows.

The wafer is at first polished by allowing the polishing head **111** to contact the polishing pad **4**. The carrier **64** and the retainer ring **75** retaining the wafer **W** is liable to rotate toward the inverse direction to the direction of rotation of the head body **62** by the polishing resistance applied from the polishing pad **4**. Since this rotation is received by the engage member **113** provided between the outer circumference of the carrier **64** and the inner face of the head body **62**, the force along the direction of rotation applied on the engage member **113** is measured by the sensor **116**.

When the back-pressure on the wafer **W** via the elastic membrane **112** is released by lowering the inner pressure of the space **SP** below the atmospheric pressure by means of the second pressure adjustment mechanism **66**, only the retainer ring **75** is pressed onto the polishing pad **4**. consequently, the polishing resistance received by the retainer ring **75** is calculated with the computing unit **117** based on the measured value of the sensor **116**.

The polishing resistance received by the retainer ring **75** can be directly determined under the same condition as polishing the wafer **W** as described above in the polishing apparatus according to the present invention. Since the magnitude of the polishing resistance received by the retainer ring **75** is within a given range so far as the surface of the polishing pad **4** remains constant, the surface state of the polishing pad **4** may be sensed based on variation of the polishing resistance. While a thin film has been formed on the surface of the wafer **W**, the retainer ring **75** is formed of a homogeneous material even in the inside of the retainer ring. Consequently, the measurement takes advantage of the fact that the magnitude of the polishing resistance received by the retainer ring **75** from the polishing pad **4** remains within a given range so far as the surface state of the polishing pad **4** does not change.

The state of the dresser **54** for dressing the polishing pad **4** may be sensed from the surface state of the polishing pad **4**.

Because the polishing resistance received by the retainer ring **75** can be measured by only decreasing the inner pressure of the space **SP** by the second pressure adjustment mechanism **66** in the polishing apparatus according to the present invention, the measurement may be carried out at any time during polishing the wafer. Fluctuation of the polishing resistance received by the retainer ring **75** can be also determined by measurements at an appropriate timing from the initial sate of polishing.

Then, the inner pressure of the space **SP** is reduced to, for example, below the atmospheric pressure using the second pressure adjustment mechanism **66**, and the wafer **W** is polished while pressing it toward the polishing pad **4** via the elastic membrane **112**. Since both of the wafer **W** retained on the carrier **64** and the retainer ring **75** are pressed onto the polishing pad **4**, the total pressure received by the retainer ring **75** received by the wafer **W** and the retainer ring **75** under the same condition as polishing the wafer **W** can be directly calculated using the computing unit **117** based on the measured value of the sensor **116**.

The polishing resistance received by the wafer **W** is directly calculated from the difference between the total resistance and the polishing resistance received by the retainer ring **75**.

The polishing resistance actually received by the wafer **W** may be accurately determined by correcting the polishing resistance received by the wafer **W**, because change of the surface state of the polishing pad **4** can be confirmed from the variation of the polishing resistance received by the retainer ring **75**.

Change of the polishing resistance received by the wafer **W** from the initial state may be determined by measuring the polishing resistance at an appropriate timing starting from the initial state of polishing, because measurement of the total polishing resistance is possible at any time during polishing.

The polishing conditions of the wafer **W**, or the rotational speed of the platen **3** and the polishing head **111**, the polishing pressure (the pressure for pressing the wafer **W** onto the polishing pad), and the amount of the fed slurry, are adjusted to optimize polishing of the wafer **W** based on the polishing resistance received by the wafer **W**.

The polishing resistance received by the wafer **W** is observed, and stabilized measured value of the polishing resistance is used as a polishing end point to complete polishing of the wafer **W**. However, polishing of the wafer is further proceeded for several seconds as a margin.

When the surface of the polishing pad **4** has been decided to be changed, some measures are applied to secure polishing of the wafer **W**. That is, polishing of the wafer **W** is once halted for adjusting (dressing) of the surface of the polishing pad **4** with a conditioner **51** to recover polishing ability of the polishing pad **4**. Polishing of the wafer **W** is resumed thereafter or the polishing time is prolonged. Polishing conditions are also adjusted, if necessary.

The state of the polishing pad **4** is sensed after dressing for a given time and, when dressing is insufficient, dressing s continued until the polishing ability of the polishing pad **4** falls within an appropriate range. When the polishing ability of the polishing pad **4** does not fall within an appropriate range after a certain period of dressing time, the dresser **54** is judged to be at the end of service life and the dresser **54** is replaced with a new one, because it indicates that the dressing ability of the dresser **54** to be used for dressing is decreased to a lower level then an appropriate level.

According to the polishing apparatus of the present invention, the polishing resistance received by the retainer ring **75** and the wafer **W** can be almost directly sensed by the polishing head **111**, since the polishing apparatus according to the present invention has higher information sensing ability on the polished state of the wafer **W** such as the polishing resistance and polishing end point as compared with the conventional polishing apparatus, and responding ability for fluctuation of these signals has been improved.

Sensing ability of the polishing end point of the wafer **W** may be improved by correcting the magnitude of the polishing resistance received by the wafer **W** based on calculation of the effect due to fluctuation of the surface sate of the polishing pad **4**.

Sensing the surface state of the polishing pad **4** allows the timing for adjusting the surface of the polishing pad **4** to be determined, besides enabling countermeasures to be appropriately selected depending on circumstances when polishing ability of the polishing pad **4** has been deteriorated.

It is also possible to sense the state of the dresser **54** to be used for dressing of the polishing pad **4**, to sense exchange timing of the dresser **54**, and to select appropriate countermeasures depending on circumstances when dressing ability of the dresser **54** has been deteriorate.

Accordingly, the wafer **W** can be polished under appropriate conditions.

Wear or damage of the diaphragm **63** may be prevented since the diaphragm **63** does not suffer from excess load even when a force to twist the diaphragm **63** is applied on the diaphragm **63**.

While the polishing pad **4** is dressed after once halting polishing of the wafer **W** in the foregoing embodiment, polishing of the wafer **W** and dressing may be simultaneously proceeded.

Disposition of the engaging projection **114** and engaging groove **115** of the engaging member **113** is not restricted to those described above, but the engaging projection **114** and engaging groove **115** may be provided at the head body **62** and carrier **64**, respectively.

### [Sixth Embodiment]

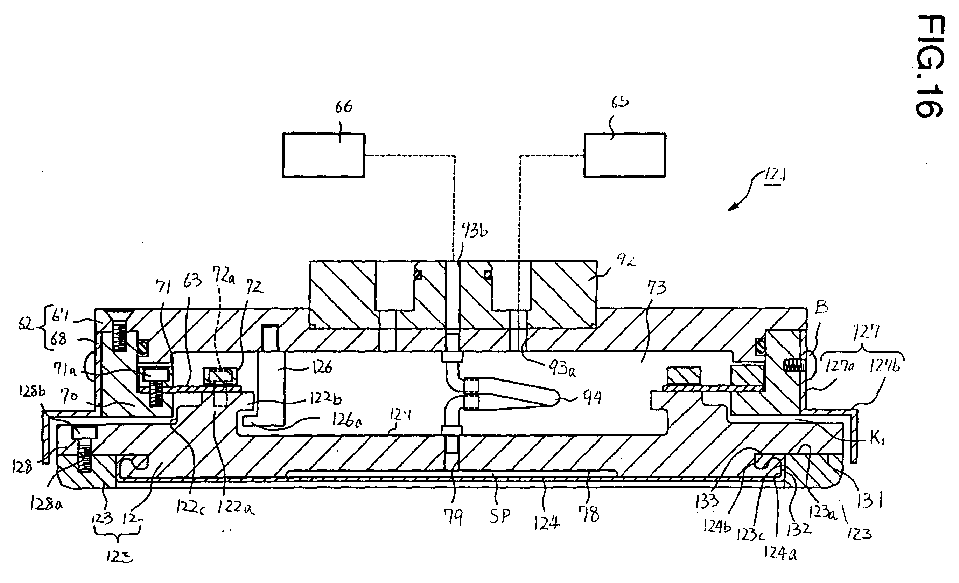

While the sixth embodiment according to the present invention is described hereinafter with reference to the drawings, the same reference numerals as used in the first to fifth embodiments are assigned to the same or similar elements in the fifth embodiments, and their explanations are omitted. The polishing apparatus according to the present invention is constructed to be approximately similar to the conventional polishing apparatus **10** shown in Fig. 28, and the polishing head **121** in the vertical cross section shown in Fig. 16 is also used herein (the polishing head **121** may be used in the polishing apparatus **1** shown in Fig. 27).

As shown in Fig. 16, the polishing head **121** comprises a head body **62** comprising an upper mounting plate **67** and a cylindrical wall **68**, a diaphragm **71** expanded in the head body **62**, an approximately disk-shaped carrier **122** secured in approximately concentric relation to the head body **62** on the lower face of the diaphragm **71**, and an annular retainer ring **123** provided in approximately concentric relation to the carrier **122** at the lower part of the carrier **122**.

The carrier **122** is formed to have a larger outer diameter than the outer diameter of the head body **62**, and retains one face of the wafer **W** via an elastic membrane **124** (to be described hereinafter) expanded over the lower face. The retainer ring **123** contacts the surface of the polishing pad **4** during polishing to block the periphery of the wafer **W**, while being pressed onto the surface of the polishing pad **4** to decrease deformation of the polishing pad **4** at the periphery of the wafer **W**, thereby preventing the wafer **W** to be polished from hanging down (hanging of the edge). The carrier **122** and the retainer ring **123** constitute a floating member **125** that is supported in a floating manner to be movable toward the head axis line direction by elastic deformation of the diaphragm **71**.

The upper mounting plate **67** of the head body **62** is secured in coaxial relation to a shaft **92** for coupling with a spindle **17** of the polishing apparatus. First and second fluid passages **93a** and **93b** are formed along the vertical direction in the shaft **92**.

A stopper bolt **126** elongating toward the head axis line direction is provided on the lower face of the upper mounting plate **67**. A step **126a**, protruding at the side and being able to engage with an inner flange **122b** (to be described hereinafter) provided on the carrier **122**, is provided at the lower end of the stopper bolt **126**.

A step **70** is formed is formed over the entire circumference at the lower part of the inner wall of the circumference wall **68**.

A cover **127** having an approximately annular shape for covering a gap **K1** is provided on the outer circumference face of the circumference wall **68** in this embodiment, so that foreign substances do not invade into the gap **K1** formed between the head body **62** and the floating member **125**. The cover **127** comprises, for example, a base **127a** bolted to the outer circumference face of the circumference wall **68**, and a cover **127b** extending downward of the base **127a** and covering the carrier **122** so as to wrap the carrier up to its outer circumference face. The bolt **B** for securing the cover **127** to the circumference wall **68** may be made of a resin to avoid contamination with metals.

The diaphragm **71** is attached to the head body **62** by screw-fitting the diaphragm fixing ring **71** to the step **70** with diaphragm fixing bolts **71a**, while the circumference portion of the diaphragm is inserted between the annular diaphragm fixing ring **71** and the upper face of the step **70** of the circumference wall **68**.

The space divided by the diaphragm **71** from the outside between the head body **62** and carrier **122** serves as a fluid chamber **73**, and the fluid chamber **73** is connected to a first pressure adjustment mechanism **65** through the first fluid passage **93a** formed in the shaft **92**. The first pressure adjustment mechanism **65** adjusts the inner pressure of the fluid chamber **73** by feeding or withdrawing a fluid into or out of the fluid chamber **73**, thereby the force for allowing the floating member **125** that is deformed with deformation of the diaphragm **71** to deform toward the head axis line direction is adjusted. The first pressure adjustment mechanism **65** mainly adjusts the force for pressing the retainer ring **123**, which makes contact with the polishing pad **4** at the floating member **125**, onto the polishing pad **4**.

A tubing **94** for connecting a second fluid passage **93b** formed in the shaft **92** to a fluid feed passage **79** (to be described hereinafter) formed in the carrier **122** is provided in the fluid chamber **73**. A second pressure adjustment mechanism **66** is connected to the second fluid passage **93b**.

The carrier **122** comprises, for example, a highly rigid material such as a ceramic or a light-weight aluminum material, and is formed to be an approximately disk-shaped with a larger outer diameter than the outer diameter of the head body **62**. The portion of the carrier **122** expanding to outside of the head body **62** serves as a first eaves **128**.

An approximately annular projection **122a** to be housed in the head body **62** is formed at the portion of the upper face of the carrier **122** located within an opening of the head body **62** to be approximately concentric to the carrier **122**. A recess **129** is formed at the inner circumference side of the projection **122a** to be by one step lower than the outer circumference side. The space formed at the upper part of the carrier **122** with the recess **129** also serves as the fluid chamber **73**.

The projection **122a** is screw-fitted to the approximately annular carrier fixing ring **72** disposed on the upper face of the diaphragm **71** with the bolt **72a** while sandwiching the diaphragm **71**, thereby the carrier **122** is attached on the lower face of the diaphragm **71**. The elevation of the projection **122a** protruding out of the upper face of the carrier **122** (the upper face at the outer circumference side) is made to be larger than the thickness of the step **70** of the head body **62** along the head axis line direction. Consequently, the gap **K1** for permitting deformation of the carrier **122** toward the head axis line direction is formed between the upper face of the carrier **122** and the lower end of the circumference wall **68**.

The inner flange **122b** is formed over the entire circumference at the upper part of the projection **122a** by being expanded toward the inner circumference side. The inner flange **122b** is able to engage with the step **126a** of the stopper bolt **126** provided in the head body **62**. Deformation of the carrier **122** toward the head axis line direction is restricted within a proper range by allowing the inner flange **122b** to engage with the step **126a** of the stopper bolt **126**, even when the diaphragm **71** is bent downward, to avoid the diaphragm **71** from suffering excess load.

The side face **122c** of the outer circumference of the projection **122a** is made to be approximately parallel to the axis line of the carrier **122** with a slight gap between the inner circumference face of the circumference wall **68** of the head body **62**. The side face **122c** is allowed to slide toward the head axis line direction relative to the inner circumference face of the circumference wall **68**, thereby restricting deformation of the carrier **122** toward the direction perpendicular to the head axis line while permitting deformation toward the head axis line direction. The outer diameter of the upper part of the projection **122a** is tapered toward the lower part of it, thus ensuring a space for permitting deformation of the diaphragm **71** between the circumference wall **68** when the carrier **122** deforms toward the head axis line direction.

An approximately circular pressurizing pocket **78** that is approximately coaxial to the carrier **122** is formed on the lower face of the carrier **122**. A cutting is formed over the entire circumference at the lower part of the outer circumference of the carrier **122**, thereby a first mounting face **131** approximately perpendicular to the axis line of the carrier **122** and directed downward, and a second mounting face **132** approximately parallel to the axis line of the carrier **122** and directed toward the circumference side are formed. The retainer ring **123** is attached to these first and second mounting faces **131** and **132** to be attachable and detachable. When a structure for securing the retainer ring **123** to the carrier **122** is employed, the first eaves **128** vertically penetrate to form a bolt insertion hole **128a**.

The retainer ring **123** is secured to the carrier **122** with the retainer ring fixing bolt **128b** inserted through the bolt insertion hole **128a**. A plurality of the bolt insertion holes **128a** are formed with an approximately equal distance apart over the entire circumference of the first eaves **128**, and is covered with a cover **127** attached to the head body **62**.

The retainer ring **123** is formed with its upper and lower faces approximately parallel to one another, and the upper face **123b** is so configured as to be able to mount on the first mounting face **131** of the carrier **122**. The inner circumference face **123c** of the retainer ring **123** is approximately in parallel relation to the upper face **123b**, and secures the elastic membrane **124** by inserting the outer circumference **124a** (to be described hereinafter) of the elastic membrane between the retainer ring and the second mounting face **132**.

It is possible to mount the retainer ring **123** by inserting a shim with an approximate thickness between the upper face **123b** and the first mounting face **131** of the carrier **122**. As a result, the degree of projection of the retainer ring **123** from the lower face of the elastic membrane **124** expanded over the lower face of the carrier **122** may be adjusted depending on the thickness of the wafer **W** to be polished.

The service life of the retainer ring **123** may be prolonged by adjusting the degree of projection of the retainer ring **123** from the lower face of the elastic membrane **124**, even when the retainer ring **123** has been worn to reduce its thickness along the upper and lower directions.

A fitting groove **133** is formed over the entire circumference on the second mounting face **132** directed toward the outer circumference side. The fitting groove **133** is tapered to have a narrower width at the opening side relative to the bottom width, and the terminal edge **124b** (to be described hereinafter) of the elastic membrane **124** expanded over the lower face of the carrier **122** is fitted into the fitting groove. The second mounting face **132** is secured by inserting the outer circumference **124a** of the elastic membrane **124** between the inner circumference face **123c** of the retainer ring **123** by attaching the retainer ring **123** to the carrier **122**, thereby the elastic membrane **124** is attached to be airtight to the carrier **122**. The elastic membrane **124** is made of a flexible material such as a fiber reinforced rubber as in the diaphragm **71**. The outer circumference **124a** of the elastic membrane rises up against the planar inner circumference, and is configured so that the terminal edge **124b** is folded toward the inside. The terminal edge **124b** is configured to be engaged with the fitting groove **133** of the carrier **122**.

The first fluid feed passage **79** communicating from the pressurizing pocket **78** formed on the lower face to near the center of the recess **129** is formed in the carrier **122**. The tubing **94** described above is connected to the end at the upper face side of the first fluid feed passage **79**.

The lower face, the face at the side for retaining the wafer **W** on the carrier **122**, is flexible. The elastic membrane **124** for receiving the wafer **W** is expanded on its lower face, and the space **SP** is formed between the elastic membrane **124** and the lower face of the carrier **122**. The space **SP** is connected to the second pressure adjustment mechanism **66** through the first fluid feed passage **79**, the tubing **94**, and the second fluid passage **93b**. The second pressure adjustment mechanism **66** adjusts the inner pressure of the space **SP** by feeding or withdrawing a fluid (for example air) in the space **SP**. The second pressure adjustment mechanism **66** allows the entire surface of the wafer **W** to be pressed onto the polishing pad **4** via the elastic membrane **124** with a uniform pressure by increasing the inner pressure of the space **SP** during polishing the wafer **W**. Alternatively, the elastic membrane **124** also serves as a suction cup for absorbing the wafer **W** by allowing the elastic membrane **124** to depress toward inside of the pressurizing pocket **78** of the carrier **122** by lowering the inner pressure of the space **SP** below the atmospheric pressure.

The second pressure adjustment mechanism **66** supports the wafer **W** to float independently from the retainer ring **123**, to adjust the force for allowing the wafer **W** to be pressed onto the polishing pad **4** through the floating member **125** by adjusting the inner pressure of the space **SP** for.

The force for pressing the wafer **W** onto the polishing pad **4** is created by applying the inner pressure of the space **SP** as a opposing force to the floating member **125**. The pressure for allowing the retainer ring **123** to contact the polishing pad **4** varies depending on the inner pressure of the space **SP**. The inner pressures of the fluid chamber **73** and the space **SP** by the first and second pressure adjustment mechanisms **65** and **66** are adjusted considering the relations as described above.

The polishing head **121** so configured as described above is attached to the polishing apparatus by coupling the shaft **92** to the spindle **17** of the polishing apparatus. When the wafer **W** is polished using the polishing head **121**, the wafer **W** is at first allowed to contact the elastic membrane **124** provided on the lower face of the carrier **122** by means of a loading device (not shown). Then, the elastic membrane **124** is allowed to depress toward the inside of the pressurizing pocket **78** to permit it to serve as a suction cup for absorbing the wafer **W**, thereby retaining the wafer **W**.

In the next step, the wafer **W** is allowed to contact the surface of the polishing pad **4** adhered on the rotating platen **3** by means of the polishing head **121**.

The circumference of the wafer **W** is blocked by the retainer ring **123**, and the surface of the wafer **W** comes in contact with the polishing pad **4** adhered on the upper face of the platen **3**.

The wafer **W** is polished as described above by allowing the platen **3** to evolve and the carousel **11** and the polishing head **121** to rotate, while the pressure for pressing the wafer **W** onto the polishing pad **4** is adjusted by the back-pressure applied by the first pressure adjustment mechanism **65** for pressing the carrier **122** and the retainer ring **123** onto the polishing pad **4**, and by the back pressure applied by the second pressure adjustment mechanism **66** onto the elastic membrane **124**, and by feeding a slurry on the surface of the polishing pad **4** and on the surface of the wafer **W** to be polished from a slurry feed means (not shown).

According to the polishing head **121** so configured as described above, and the polishing apparatus using the polishing head, the mounting space of the polishing head **121** may be reduced by avoiding the wafer **W** from expanding to outside of the polishing head **121**, since the outer diameter of the floating member **125** retaining the wafer **W** is larger than the outer diameter of the head body **62**.

The gap **K1** formed by the floating structure is formed between the upper face of the carrier **122** and the head body **62**, and is located a distance apart from the polishing pad **4**. Since the distance between the opening of this gap **K1** and the polishing pad **4** is blocked by the first eaves **128** besides its circumference is covered with the cover **127**, foreign materials are hardly sucked into the gap **K1**. Accordingly, damages such as scratches are rarely formed on the wafer **W** besides improving serviceability ratio of the polishing apparatus by diminishing the frequency of cleaning that is carried out by disassembling the floating member **125** from the head body **62** in the polishing head **121**.

Since the wafer **W** is supported in a floating manner by the elastic membrane **124**, the retainer ring **123** is supported independently from the wafer **W** in a floating manner to enable good polishing of the wafer **W**, despite the retainer ring **123** is secured to the carrier **122** and is not supported by the carrier **122** in a floating manner.

Since a floating support structure for supporting the retainer ring **123** on the carrier **122** is not needed, a gap formed due to the floating structure may be eliminated from the portion contacting the polishing pad **4**.

Since the retainer ring **123** is attached to the carrier **122**, not to the diaphragm **71**, the retainer ring **123** can be exchanged without disassembling the polishing head **121** to make it possible to improve work efficiency as well as serviceability ratio of the polishing apparatus.

The retainer ring **123** is bolted to the carrier **122** from the upper face side of the first eaves **128** expanding out of the outer circumference side of the head body **62**. Consequently, the retainer ring **123** may be easily attached to and detachment from the carrier **122**. Moreover, since the retainer ring fixing bolt **128b** for securing the retainer ring **123** onto the carrier **122** is located a distance apart from the polishing pad **4**, and the distance between the retainer ring fixing bolt **128b** and the polishing head **4** is blocked by the first eaves **128**, contamination with metals arising from the retainer ring fixing bolt **128** can be reduced.

### [Seventh Embodiment]

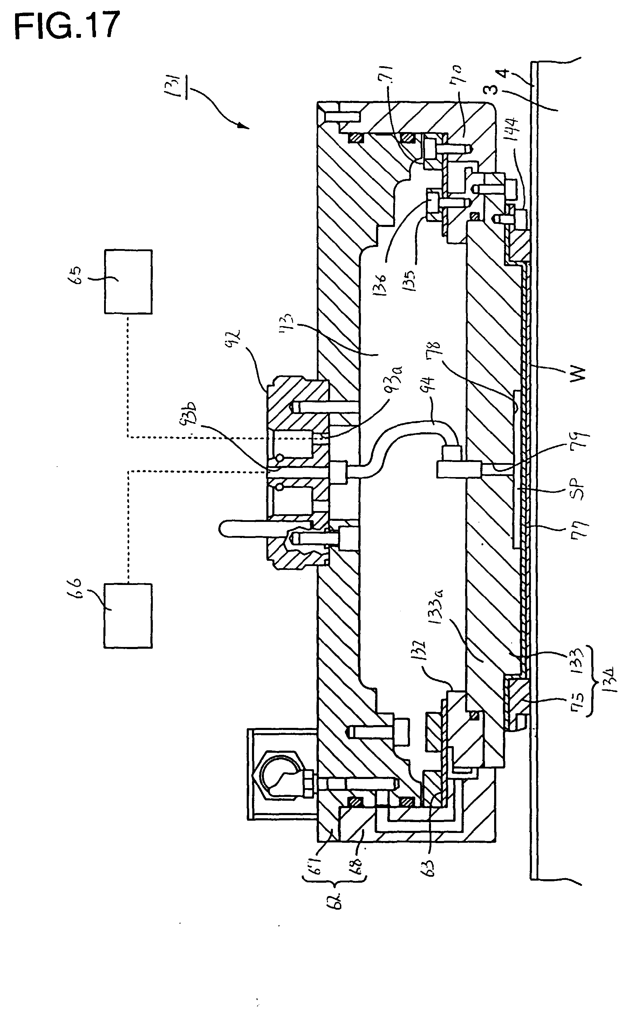

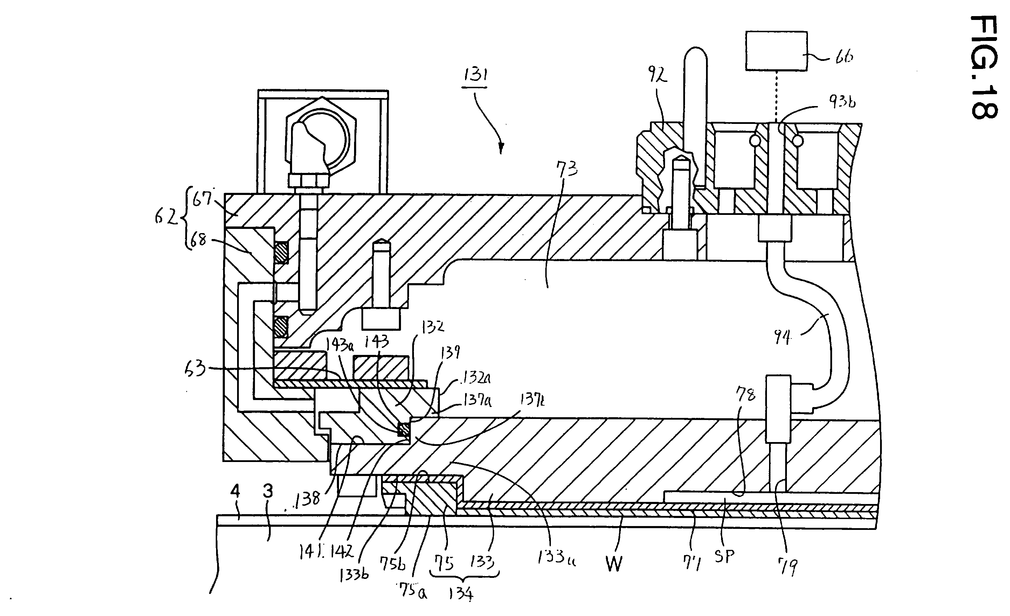

While the seventh embodiment according to the present invention is described hereinafter with reference to the drawings, the same reference numerals as used in the first to sixth embodiments are assigned to the same or similar elements in the seventh embodiments, and their explanations are omitted. The polishing apparatus according to the present invention is constructed to be approximately similar to the conventional polishing apparatus **10** shown in Fig. 28, and the polishing head **131** in the vertical cross section shown in Fig. 17 is also used herein (the polishing head **131** may be used in the polishing apparatus **1** shown in Fig. 27). Fig. 18 is an enlarged drawing of the main part shown in Fig. 17.

In Fig. 17, the polishing head **131** comprises a head body **62** comprising an upper mounting plate **67** and a cylindrical circumference wall **68**, a diaphragm **63** expanded in the head body **62**, an intermediate member **132** secured to the diaphragm **63**, an approximately disk-shaped carrier **133** secured via the intermediate member **132**, and an annular retainer ring **75** provided at the lower part of the carrier **133** by being located between the circumference wall **68** and the carrier.

The carrier **133** is attached to the intermediate member **132** in approximately concentric relation to the head body **62**, and retains one face of the wafer **W** via an elastic membrane **77** expanded over the lower surface. The retainer ring **75** is attached in approximately concentric relation to the carrier **133**. These carrier **133** and the retainer ring **75** assumes a floating structure which allows them to be movable toward the head axis line direction by elastic deformation of the diaphragm **63** to constitute the floating member **134**.

The upper mounting plate **67** of the head body **62** is secured in concentric relation to a shaft **92** as a coupling member for coupling to an arm (not shown) of the polishing apparatus. First and second fluid passages **93a** and **93b** are formed in the shaft **92** along the vertical direction. A step **70** is formed over the entire circumference at the lower part of the inner wall of the circumference wall **68**.

The diaphragm **63** is formed into an annular shape with its inner circumference side open, and is secured to the step **70** formed on the inner wall of the circumference wall **68** with a diaphragm fixing ring **71**.

The space divided by the diaphragm **63** from the outside between the head body **62**, and the floating member **134** and the intermediate member, serves as a fluid chamber **73**, and communicates with the first fluid passage **93a** formed in the shaft **92**. The pressure in the fluid chamber **73** is adjusted by feeding a fluid such as air into the fluid chamber **73** from the first pressure adjustment mechanism **65** through the first fluid passage **93a**. The first pressure adjustment mechanism **65** controls the pressure in the fluid chamber **73**, or the force for allowing the floating member **134** that displaces together with the diaphragm **63** to displace toward the head axis line direction. The first pressure adjustment mechanism **65** mainly adjusts the force for pressing the retainer **75** that makes contact with the polishing pad **4** at the floating member **134** onto the polishing pad **4**.

A tubing **94** for connecting the second fluid passage **93b** formed in the shaft **92** to the fluid feed passage **79** provided in the carrier **133** is provided in the fluid chamber **73**.

The intermediate member **132** is an approximately annular shaped member whose inner circumference side is open, and is made of a rigid material such as stainless steel, ceramic or a light-weight aluminum material. The intermediate member **132** is attached on the lower face of the diaphragm **63** in approximately concentric relation to the head body **62** by screw-fitting the intermediate member fixing ring **135** and the diaphragm **63** with intermediate member fixing bolts **136** while the diaphragm is inserted between the intermediate member and the fixing ring disposed on the upper face of the diaphragm **63**.

An inner flange **132a** projecting toward the inner circumference side is formed at the upper part of the intermediate member **132** as shown in Fig. 18, and the step formed by this inner flange **132a** below it and the lower face of the intermediate member **132** serve as engage members **137a** for engaging with an engage member **137b** (to be described hereinafter) of the carrier **133**. The lower face of the intermediate member **132** of these engage members **137a** is approximately perpendicular to the axis line of the intermediate member **132**, and serves as a first mounting reference face **138**. The face directing toward the inner circumference side of the steps forming the engage members **137a** is approximately parallel to the axis line of the intermediate member **132**, and serves as a second mounting reference face **139**.

The carrier **133** comprising a highly rigid material such as a ceramic, or a lighter aluminum material, is formed into an approximately disk-shaped member as shown in Fig. 17, and is bolted to the lower part of the intermediate member **132** to be attachable and detachable. Cut portions are provided over the entire circumference at the upper and lower parts of the outer circumference **133a** of the carrier **133**, respectively, in concentric relation to the carrier **133** to form steps and, as shown in Fig. 18, the step formed at the upper part at the outer circumference **133a** of the carrier **133** serves as an engage member **137b** for engaging with the engage member **137a** of the intermediate member **132**. The face directing toward upward of the steps forming the engage member **137b** is approximately perpendicular to the axis line of the carrier **133**, and serves as a third mounting reference face **141**. The face directing toward the outer circumference side of the steps is approximately parallel to the axis line of the carrier **133**, and serves as a fourth mounting reference face **142**.

The carrier **133** allows the third mounting reference face **141** of the engage members **137b** to contact the first mounting reference face **138** of the intermediate member, and allows the fourth mounting reference face **142** to contact the second mounting reference face **139** of the intermediate member **132**, thereby the carrier is positioned to be in concentric relation to the intermediate member **132**. A sealing member **143** is provided at the engage member **137a** of the intermediate member **132** or at the engage member **137b** of the carrier **133**, or at both of them, for sealing to be airtight or liquid-tight among the members. An O-ring is used for the sealing member **143**, and a groove **143a** for fitting the sealing member **143** is formed over the entire circumference on the second mounting reference face **139** of the engage member **137a** (the groove **143a** may be provided at the fourth mounting reference face **142** side of the carrier **133**).

A pressurizing pocket **78** as an approximately circular recess is provided at the center of the lower face of the carrier **133**, and the other portion of the lower face has a constant thickness. A fluid fed passage **79** communicating from the pressurizing pocket **78** to the upper face of the carrier **133** is formed on the carrier **133**. The fluid feed passage **79** is connected to the second pressure adjustment mechanism **66** through the tubing **94** provided in the fluid chamber **73** and the second fluid passage **93b** of the upper mounting plate **67**.

The retainer ring **75** is a member formed into an approximately annular shape and, as shown in Fig. 17, is attached to the step formed at the lower part of the outer circumference **133a** of the carrier **133** so as to be approximately concentric to the circumference wall **68** and the carrier **133**. The retainer ring **75** is attached to the carrier **133** to be attachable and detachable by, for example, bolting with retainer ring fixing bolts **144** by leaving a slight gap between the inner wall of the circumference wall **68** and the face directing toward the outer circumference side of the steps at the lower side of the carrier **133**.

As shown in Fig. 18, the retainer ring **75** is formed to be approximately parallel to the upper face **75b** and lower face **75a**, and is provided so that the lower face **75a** protrudes out of the lower face of the elastic membrane **77** expanded over the carrier **133** in order to allow the lower face **75a** to contact the polishing pad **4**. It is possible to mount the retainer ring **75** while a shim with an appropriate thickness is inserted between the upper face **75b** of the retainer ring and the face **133b** directed to downward of the lower side steps of the carrier **133**, thereby the degree of projection from the lower face of the elastic membrane **77** expanded over the lower face of the carrier **133** may be adjusted depending on the thickness of the wafer **W** to be polished.

It is also possible to prolong the service life of the retainer ring **75** by limiting the degree of projection of the retainer ring **75** from the lower face of the elastic membrane **77** within an appropriate range.

The elastic membrane **77** for dividing the pressurizing pocket **78** from the outside to form the space **SP** is expanded over the lower face of the carrier **133**. The elastic membrane **77** is an approximately circular sheet member comprising a flexible material such as a fiber reinforced rubber as in the diaphragm **63**, and is attached to the carrier **133** to be airtight by inserting its outer circumference edge between the face **133b** of the step on the carrier **133** and the upper face **75b** of the retainer ring **75**.

The second pressure adjustment mechanism **66** is provided to adjust the inner pressure of the space **SP** by feeding or withdrawing a gas to or from the space (the upper face side of the elastic membrane **77**) between the carrier **133** and the elastic membrane **77** including the space **SP**.

The second pressure adjustment mechanism **66** presses the elastic membrane **77** toward outside to press the entire surface of the wafer **W** onto the polishing pad **4** with a uniform pressure, by increasing the inner pressure of the space between the carrier **133** and the elastic membrane **77** up to a prescribed pressure during polishing the wafer **W**. The pressure applied from the second pressure adjustment mechanism **66** is adjusted so that the wafer **W** is pressed onto the polishing pad **4** with an optimum pressure for polishing. The second pressure adjustment mechanism **66** allows the inner pressure of the space **SP** to decrease below the atmospheric pressure while allowing the wafer **W** to be absorbed on the lower face of the elastic membrane **77** to permit the elastic membrane **77** to depress toward the inside of the pressurizing pocket **78**, thereby making the elastic membrane **77** to serve as a suction cup for absorbing the wafer **W**.

The second pressure adjustment mechanism **66** supports the wafer **W** independently from the retainer ring **75** in a floating manner, by adjusting the inner pressure of the space **SP** to adjust the force for pressing the wafer **W** from the floating member **134** onto the polishing pad **4**.

While the force for pressing the wafer **W** onto the polishing pad **4** is determined by the inner pressure of the space **SP**, this force also pushes up the floating member **134** by the same force as pressing the wafer **W** onto the polishing pad **4**. The force for pressing the retainer ring **75** onto the polishing pad **4** is given as a difference between the force for pushing up the floating member **134** and the force for pressing the floating member **134** onto the polishing pad **4** by the pressure of a fluid fed from the first pressure adjustment mechanism **65**. In other words. The pressure for allowing the retainer ring **75** to contact the polishing pad **4** varies depending on the inner pressure of the space **SP**. The inner pressure of the fluid chamber **73** and the space **SP** is adjusted by the first and second pressure adjustment mechanisms **65** and **66** by taking these relations described above into consideration.

The polishing head **113** so configured as described above is coupled to the polishing apparatus by coupling the shaft **92** to the arm (not shown). When the wafer **W** is polished using the polishing head **131**, the wafer **W** is allowed to contact the elastic membrane **77** provided on the lower face of the carrier **133** by a loading device (not shown). The elastic membrane **77** is made to depress toward the inside of the pressurizing pocket **78** by reducing the inner pressure of the space **SP** by means of the second pressure adjustment mechanism **66**, thereby allowing the elastic membrane to serve as a suction cup for absorbing the wafer **W** to retain the wafer **W**.

Then, the wafer **W** is transferred on the polishing pad **4** by allowing the polishing head **131** to travel by the arm.

The wafer **W** is made to contact the polishing pad **4** adhered on the upper surface of the platen **3** while the periphery of the wafer **W** is blocked with the retainer ring **75**.

The pressure for pressing the wafer **W** onto the polishing pad **4** is adjusted by the back-pressure of the carrier **133** and the retainer ring **75** onto the polishing pad **4** from the first pressure adjustment mechanism **65**, and the back pressure applied on the elastic membrane **77** by the second pressure adjustment mechanism **66**. The wafer **W** is polished by allowing the platen **3** to revolve and the polishing head to rotate while feeding the slurry **S** on the surface of the polishing pad **4** and on the surface of the wafer **W** to be polished from a slurry feed device (not shown).

According to the polishing head **131** so configured as described above, and the polishing apparatus using the polishing head, the floating member **134** can be attached and detached without disassembling the entire polishing head **131**, since the carrier **133** and the retainer ring **75** (the floating member **134**) is attached to the diaphragm **63** via the intermediate member **132**, and the floating member **134** is mounted on the intermediate member **132** to be attachable and detachable, thereby making maintenance easy and serviceability ration of the polishing apparatus to be improved. Also, since the intermediate member **132** is rigid, assembling accuracy of the floating member is assured as compared with the conventional floating member directly assembled to the flexible diaphragm. Machining accuracy of the wafer is stabilized by securing the assembling accuracy of the intermediate member **132** to the diaphragm **63** because the assembling accuracy of the floating member **134** is secured by merely a simple adjustment when the floating member **134** is reassembled to stabilize machining accuracy of the wafer.

The intermediate member **132** may be also used for the spacer for adjusting the position of the floating member **134** along the head axis line direction. That is, The position of the floating member **134** for retaining the wafer may be adjusted by replacing an intermediate member **132** with an another intermediate member **132** having a portion to serve as a spacer with a different thickness to allow the thickness to fit the thickness of the wafer **W** to be polished, and to change the position of the floating member **134** relative to the head body **62** along the head axis line direction. Setting of the floating member **134** can be visually confirmed to reduce the occurrence of faulty adjustment, by providing an indicator for indicating the thickness (the thickness from the upper face to the lower face of the intermediate member **132** in this embodiment) of the member to be used for the spacer. The indicator should not be always a part of the intermediate member **132**, but the entire surface of the intermediate member **132** may be used for the indicator. The thickness (the thickness may be represented by the distance between the head body **62** and the floating member **134** or their relative position, or the thickness of the corresponding wafer **W**) of the part to serve as a spacer may be represented by the numerical value or the number of marks, or by the shape of the spacer, or by using different colors depending on the thickness to serve as a spacer.

Setting information of the polishing head **131** may be readily inputted to a control unit (not shown) of the polishing apparatus by providing a bar-code showing the thickness of the portion to serve as a spacer on the indicator. As a result, occurrence of faulty adjustment may be reduced by allowing the control unit to collate the current polishing condition with setting of the polishing head to verify whether setting is correct.

Both of the diaphragm **63** and the intermediate member **132** assumes an approximately circular configuration with their inner circumference side open. Since the interior of the polishing head **131** is exposed to outside by removing the floating member **134** from the intermediate member **132**, simultaneous maintenance of the interior of the polishing head **131** is enabled. Making maintenance easy results in improvement of serviceability of the polishing apparatus. Since the space between the engage members **137a** and **137b** is sealed with a sealing member **143** disposed between the engage members **137a** and **137b** for engaging the intermediate member **132** to the carrier **133**, assuring an airtight property of the fluid chamber **73** is emphasized in assembling the intermediate member **132** to the diaphragm **63**, and assuring an assembling accuracy of the floating member **134** is emphasized in assembling the floating member **134** to the intermediate member **132**.

Since the wafer **W** retained on the wafer polishing head **131** is supported by the elastic membrane **77** in a floating manner, the retainer ring **75** is independently supported from the wafer **W** in a floating manner to polish the wafer **W** in good condition, even when the retainer ring **75** is fixed to the carrier **133** and is not supported by the carrier **133** in a floating manner.

Since a structure for supporting the retainer ring **75** by the carrier **133** in a floating manner is not needed, the gap at the portion facing the polishing pad **4** formed by the floating structure may be reduced.

Work efficiency may be improved while improving serviceability of the polishing apparatus, because the retainer ring **75** is attached to the carrier **133** to enable the retainer ring **75** to be exchanged without disassembling the polishing head **131**.

Placing the intermediate member **132** between the diaphragm **63** and the floating member **134** allows the lower end of the floating member **134** to be disposed with a distance apart from the opening of the head body **62**. Consequently, the slurry **S** on the polishing pad **4** is hardly incorporated into the polishing head **62**. Provided that the slurry **S** be incorporated, then it is seldom flows out on the polishing pad **4**.

The sealing member **143** for sealing the gap between the engage member **137a** of the intermediate member **132** and the engage member **137b** of the carrier **133** was disposed between the second mounting reference face **139** of the engage member **137a** and the fourth mounting reference face **142** of the engage member **137b** in the embodiment described above. However, the construction of the present invention is not restricted thereto, but the sealing member **143** may be disposed between the first mounting reference face **138** of the engage member **137a** and the third mounting reference face **141** of the engage member **137b**. When an O-ring is used for the sealing member **143**, a groove **143** for housing the sealing member **143** is formed on the first mounting reference face **138** or on the third mounting reference face **141** over its entire circumference.

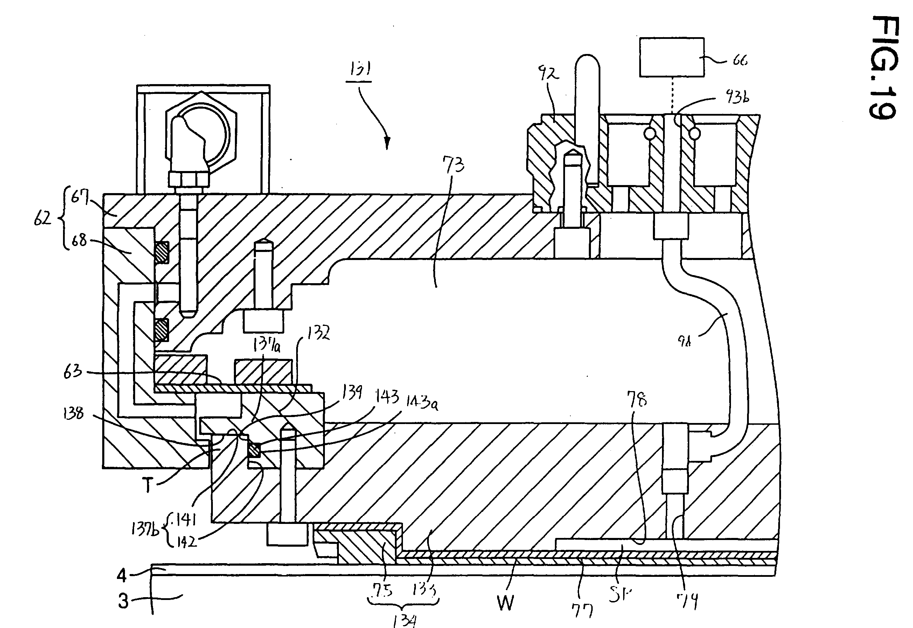

The step formed at the lower part of the inner circumference of the intermediate member **132** serves as the engage member **137a**, and the step formed at the upper part of the outer circumference of the carrier **133** serves as the engage member **137b** in the embodiment described above. As shown in Fig. 19, however, the construction of the present invention is not restricted thereto, but the step may be formed at the lower part of the outer circumference, not at the lower part of the inner circumference, of the intermediate member **132** to serve as the engage member **137a**, and a protruding bank **T** may be formed over the entire circumference in place of providing cutting on the upper part of the outer circumference to form the engage member **137b** with the upper face and the face directing toward the inner circumference side of the protruding bank **T**. Of the steps forming the engage members **137a**, the face directing downward is allowed to serve as the first mounting reference face **138** approximately perpendicular to the axis line of the intermediate member **132**, and the face directing toward the outer circumference side is allowed to serve as the second mounting reference face **139** approximately parallel to the axis line of the intermediate member **132**. Likewise, the upper face of the protruding bank **T** forming the engage member **137b** is allowed to serve as the third mounting reference face **141** approximately perpendicular to the axis line of the carrier **133**, and the face of the protruding bank **T** directing toward the inner circumference side is allowed to serve as the fourth mounting reference face **142** approximately parallel to the axis line of the carrier **133**.

When the retainer ring **75** is bolted to the carrier **133**, it may be bolted, for example, from the upper face side of the carrier **133** with the retainer ring fixing bolt **144**. Since the retainer ring fixing bolt **144** is placed a distance apart from the polishing pad **4** on the upper face of the carrier **133**, and the space between the retainer ring fixing bolt **144** and the polishing pad **4** is blocked with the carrier **133**, occurrence of contamination with metals arising from the retainer ring fixing bolt **144** (contamination by the metals dissolved from the retainer ring fixing bolt **144**) may be reduced. Contamination with metals arising from the retainer ring fixing bolt **144** may be further diminished by covering the retainer ring fixing bolt **144** with the intermediate member **132**, or by housing the retainer ring fixing bolt **144** into the fluid chamber **73**.

### [Eighth Embodiment]

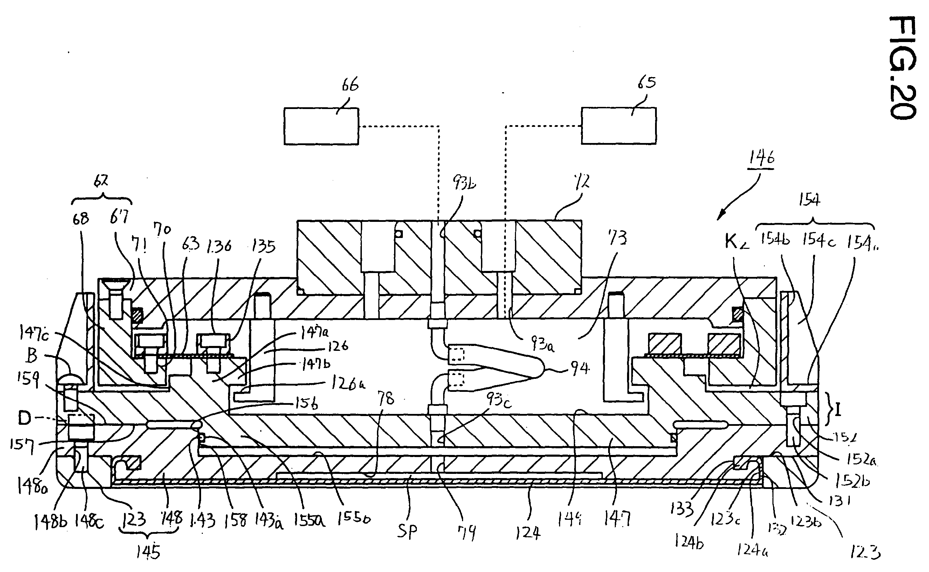

While the eighth embodiment according to the present invention is described hereinafter with reference to the drawings, the same reference numerals as used in the first to seventh embodiments are assigned to the same or similar elements in the eighth embodiments, and their explanations are omitted. The polishing apparatus according to the present invention is constructed to be approximately similar to the conventional polishing apparatus **10** shown in Fig. 28, and the polishing head **146** in the vertical cross section shown in Fig. 20 is also used herein (the polishing head **146** may be used in the polishing apparatus **1** shown in Fig. 27).

In Fig. 20, the polishing head **146** comprises a head body **62** comprising an upper mounting plate **67** and a diaphragm **63** expanded in the polishing head **62**, an intermediate member **147** secured to the diaphragm **63**, an approximately disk-shaped carrier **148** secured on the lower face of the diaphragm **63** via the intermediate member **147**, and an approximately annular retainer ring **123** provided at the lower part of the carrier**148**. The carrier **148** and the retainer ring **123** constitutes a floating member **145** movable toward the head axis line direction by elastic deformation of the diaphragm **63**.

The upper mounting plate **67** of the head body **62** is secured to a shaft **92** in concentric relation for coupling with an arm (not shown) in the polishing apparatus. First and second fluid passage **93a** and **93b** are formed in the shaft **92** along the vertical direction.

A stopper bolt **126** extending toward the head axis line direction is provided on the lower face of the upper mounting plate **67**. A step **126a** protruding toward the side to engage with an inner flange **147b** (to be described hereinafter) provided at the intermediate member **147** is provided at the lower end of the stopper bolt **126**.

A step **70** is formed at the lower part of the circumference wall **68** over the entire circumference.

The diaphragm **63** is secured with a diaphragm fixing ring **71** on the step **70** formed on the inner wall of the circumference wall **68**. The space formed by being divided between the head body **62** and the intermediate member **147** from the outside by the diaphragm **63** serves as a fluid chamber **73**, and communicates with a first fluid passage **93a** formed in the shaft **92**.

A tubing **94** connecting a second fluid passage **93b** formed in the shaft **92** to a third fluid passage **93c** (to be described hereinafter) provided in the intermediate member **147** is provide in the fluid chamber **73**.

The intermediate member **147** comprises a rigid material such as stainless steel, a ceramic and an aluminum material, and assumes an approximately disk-shape with a larger outer diameter than the outer diameter of the head body **62**. The intermediate member **147** is attached in concentric relation to the head body **62**, and the portion expanding out of the outer circumference side from the head body **62** serves as a second eaves **152**.

The intermediate member **147** also serves as a spacer for adjusting the position of the floating member **145** along the head axis direction. An indicator **I** for indicating the thickness of the portion that serves as a spacer is provided on the intermediate member **147**. The thickness of the portion that serves as a spacer corresponds to the thickness from the top face of a projection **147a** to a sixth mounting reference face **147** to be described hereinafter. The indicator **I** is not necessarily a part of the intermediate member **147**, but the entire surface of the intermediate member **147** may be used for the indicator. The thickness of the portion to serve as a spacer (the thickness may be represented by the distance between the head body **62** and the floating member **145** and their relative position, or by the thickness of the corresponding wafer **W**) may be displayed by a numerical value, the number of the mark, and the shape, or may be represented by a different color depending on the thickness of the portion that serves as a spacer. The outer circumference of the second eaves **152** as a portion exposed to outside on the intermediate member **147** may be used for the indicator **I**, and the intermediate member **147** is differently colored depending on the thickness of the portion to serve as a spacer.

The portion located in the opening of the head body **62** of the upper face of the intermediate member **147** is made to be approximately in concentric relation to the intermediate member **147**, and an approximately annular projection **147a** to be housed in the head body **62** is formed. A recess **149** is formed at the inner circumference side of the projection **147a** with a step lower than the outer circumference side. The space formed at the upper part of the intermediate member **147** by the recess **149** also serves as the fluid chamber **173**.

The projection **147a** is screw-fitted with an intermediate member fixing bolt **136** while inserting the diaphragm **63** between the projection and an approximately annular shaped intermediate member fixing ring **135** disposed on the upper face of the diaphragm **63**, thereby the intermediate member **147** is attached on the lower face of the diaphragm **63**. The elevation of the projection **147a** projecting out of the upper face (the upper face of the outer circumference) of the intermediate member **147** is adjusted to be larger than the thickness of the step **70** of the head body **62** along the head axis line direction. Consequently, a gap **K2** for permitting the intermediate member **147** to displace toward the head axis line direction is formed between the upper face of the intermediate member **147** and the lower end of the circumference wall **68**.

A third fluid passage **93c** communicating to the lower face side of the intermediate member **147** is formed at the center of the bottom of the recess **149**.

An inner flange **147b** projecting toward the inner circumference side is formed over the entire circumference at the upper part of the projection **147a**. The inner flange **147b** is provided to engage with the step **126a** of the stopper bolt **126** provided in the head body **62**, and relative movement between the head body **62** and the intermediate member **147** is restricted within an appropriate range by allowing the inner flange **147b** to engage with the step **126a** of the stopper bolt **126**, thereby making the diaphragm **63** to be free from an excess force. The side face **147c** of the outer circumference side of the projection **147a** is made to be a face approximately parallel to the head axis line, and is provided with a slight gap from the inner circumference face of the circumference wall **68** of the head body **62**. The side face **147c** is able to slide along the head axis line direction relative to the inner circumference face of the circumference wall **68**, thereby restricting displacement toward the direction perpendicular to the head axis line while permitting the intermediate member **147** to displace toward the head axis line direction. The upper part of the projection **147a** is tapered to have a narrower outer diameter than the lower part to ensure a space from the circumference wall **68** for permitting deformation of the diaphragm **63** accompanied by displacement of the intermediate member **147** to ward the head axis line direction.

An approximately annular-shaped cover **154** for covering the gap **K2** formed between the head body **62** and the intermediate material **147** from the side is provided on the upper face of the second eaves **152** in this embodiment. The cover **154** comprises a base **154a** secured by, for example, bolting to the upper face of the second eaves **152**, and a cover member **154b** raising from the base **154a** toward the head axis line direction along the outer circumference face (the outer circumference face of the circumference wall **68**) of the head body **62**. A plurality of ribs **154c** are provided between the cover member **154b** and the base **154a** with an appropriate distance apart along the peripheral direction of the cover **154**. A bolt made of a resign is used for the bolt for securing the base **154a** to the second eaves **152** in order to avoid contamination with metals.

An engaging projection **155a** for engaging with an engaging recess **155b** (to be described hereinafter) provided on the carrier **148** is formed on the lower face of the intermediate member **147** in concentric relation to the intermediate member **147**. The outer circumference face of the engaging projection **155a** is approximately parallel to the axis line of the intermediate member **147**, serving as a fifth mounting reference face **156**. The face locating at the outer circumference side from the engaging projection **155a** of the lower face of the intermediate member **147** is approximately perpendicular to the axis line of the intermediate member **147** to serve as a sixth mounting reference face **157**. These fifth and sixth mounting reference faces **156** and **157** serve as mounting reference faces for mounting the carrier **148** on the intermediate member **147**.

A margin is provided from the upper end of the fifth mounting reference faces **156** through the inner circumference side of the sixth mounting reference faces **157**, and the lower face of the engaging projection **155a** does not make contact with the bottom face of the engaging recess **155b** of the carrier **148**. Consequently, mounting accuracy of the carrier **148** onto the intermediate member **147** is maintained.

The carrier **148** is made of a highly rigid material such as a ceramic or a lighter aluminum material, and is attached to the intermediate member **147** to be attachable and detachable. The carrier **148** is also attached to the intermediate member **147** in concentric relation to the head body **62**, and the portion of the carrier **148** projecting out of the head body **62** toward the circumference side serves as a third eaves **148a**.

The engaging recess **155b** for engaging with the engaging projection **155a** of the intermediate member **147** is formed on the upper face of the carrier **148**. The inner side face of the engaging recess **155b** is approximately parallel to the axis line of the carrier **148**, and serves as a seventh mounting reference face **158** making contact with the fifth mounting reference face **156** of the intermediate member **147**. The upper face of the carrier **148** is approximately perpendicular to the axis line of the carrier **148**, and serves as a eighth mounting reference face **159** making contact with the sixth mounting reference face **157** of the intermediate member **147**.

The carrier **148** is positioned to be concentric to the intermediate member **147** by allowing the seventh mounting reference face **158** to contact the fifth mounting reference face **156** of the intermediate member **147**, and by allowing the eighth mounting reference face **159** to contact the sixth mounting reference face **157** of the intermediate member **147**. A sealing member **143** are placed on the mounting reference faces of the intermediate member **147** or on the mounting reference faces of the carrier **148**, or on both of them, in order to seal them to be airtight or liquid-tight. An O-ring is used as the sealing member **143** in this embodiment, and a groove **143a** for fitting the sealing member **143** is formed over the entire circumference on the fifth mounting reference face **156** of the intermediate member **147** (the groove **143a** may be provided at the seventh mounting reference face **158** side of the carrier **148**).

When a structure for bolting the carrier **148** to the intermediate member **147** is employed, a bolt insertion hole **152a** is formed by vertically perforating on the second eaves **152**. The carrier **148** is secured to the intermediate member **147** with the carrier fixing bolt **152b** perforating through the bolt insertion hole **152a**. A plurality of the bolt insertion holes **152a** are formed along the entire circumference of the second eaves **152** with, for example, an equal distance apart, and is covered with the cover **154** attached to the second eaves **152** (the head of the carrier fixing bolt **152b** may not be housed in the bolt insertion hole **152a**, but the head of the carrier fixing bolt **152b** may be covered with the cover **154**).

A pressurizing pocket **78** is formed on the lower face of the carrier **148** in concentric relation to the carrier **148**. A fluid feed passage **79** communicating from the pressurizing pocket **78** through the bottom face of the engaging recess **156b** is formed in the carrier **148**. The fluid feed passage **79** is connected to the tubing **94** through the space formed between the engaging recess **155b** of the carrier **148** and the engaging projection **155a** of the intermediate member **147**, and through the third fluid passage **93c** formed in the intermediate member **147**, thereby being connected to the second pressure adjustment mechanism **66**.

A cutting is formed over the entire circumference at the lower part of the carrier **148** to form a first mounting face **131** directing downward the axis line direction of the carrier **148**, and a second mounting face **132** directing toward the outer circumference direction of the carrier **148**. The retainer ring **123** is attached to these first and second mounting faces **131** and **132**.

When a structure for bolting the retainer ring **123** to the carrier **148** is employed, the bolt insertion hole **148b** is formed through the third eaves **148a** from the upper side to the lower side. The retainer ring **123** is screw-fitted to the carrier **148** with the retainer ring fixing bolt **148c** perforating through the bolt insertion hole **66b**. The bolt insertion hole **148b** is so configured as to house the head of the retainer ring fixing bolt **148c**, thereby the retainer ring fixing bolt **148c** is isolated from outside by being housed between the intermediate member **147** and the carrier **148** when the carrier **148** is attached to the intermediate member **147**. A plurality of the bolt insertion holes **148b** are formed along the entire circumference of the third eaves **148a** with, for example, an equal distance apart (for example, a hole **D** (or a groove) are formed at the positions opposed to the bolt insertion hole **148b** on the lower face of the intermediate member **147** as indicated by the double dotted line in Fig. 20 to house the head of the retainer fixing bolt **148c** in this hole, instead of allowing the bolt insertion hole **148b** to house the head of the retainer fixing bolt **148c**).

The upper and lower faces of the retainer ring **123** are formed to be approximately in parallel to one another, and the upper face **123b** is attached to the first mounting face **131** of the carrier **148**. The inner circumference face **123c** of the retainer ring **132** is approximately perpendicular to the upper face **123b,** and the elastic membrane **124** is secured by inserting its outer circumference **124a** (to be described hereinafter) into the gap from the second mounting face **132**, thereby the elastic membrane **124** is attached to be airtight to the carrier **6**. It is possible to mount the retainer ring **123** by inserting a shim with an appropriate thickness between the upper face **67a** and the first mounting face **131** of the carrier **148**. As a result, the degree of projection of the retainer ring **123** from the lower face of the elastic membrane **124** expanded over the lower face of the carrier **148** can be adjusted depending on the thickness of the wafer **W** to be polished. It is also possible to elongate the service life of the retainer ring **123** by restricting the degree of projection of the retainer ring **123** out of the lower face of the elastic membrane **124** within an optimum range, even when the retainer ring **123** is worn to reduce the thickness along the vertical direction.

A fitting groove **133** is formed over the entire circumference on the second mounting face **132** directing toward the outer circumference side. The fitting groove **133** is tapered so that the width at the opening side is narrower than the with of the bottom part, and the terminal edge **124b** (to be described hereinafter) of the elastic membrane **124** expanded over the lower face of the carrier **148** is inserted into the groove. The second mounting face **132** secures the elastic membrane by inserting the outer circumference **124a** of the elastic membrane **124** into the gap from the inner circumference face **67b** of the retainer ring **123** after mounting the retainer ring **123** on the carrier **148**. The elastic membrane **124** is made of, for example, a flexible material such as a fiber reinforced rubber as in the diaphragm **63**, and the outer circumference **124a** raises toward the upper face side against the planar inner circumference, and the terminal edge **124b** is folded toward the inner circumference side. The terminal edge **124b** is formed to be thicker than the remaining part, thereby the terminal edge **124b** is engaged with the fitting groove **133** of the carrier **148**.

The second pressure adjustment mechanism **66** feeds or withdraws a gas to or from the space (the upper face side of the elastic membrane **124**) including the space **SP** between the carrier **148** and the elastic membrane **124** to adjust the inner pressure of the space. The second pressure adjustment mechanism **66** presses the entire surface of the wafer **W** onto the polishing pad **4** of the polishing apparatus via the elastic membrane **124** by increasing the inner pressure of the space **SP** during polishing, and depresses the elastic membrane **124** toward the inside of the pressurizing pocket **78** to permit the elastic membrane **124** to serve as a suction cup for absorbing the wafer **W** by decreasing the inner pressure of the space **SP** below the atmospheric pressure.

In the polishing head **146** so configured as described above, the floating member **145** can be easily attached and detached without disassembling the head body **62**, since the floating member **145** is bolted to the second eaves **152** of the intermediate member **147**. Accordingly, maintenance is easy and serviceability ratio of the polishing apparatus is improved.

Since the outer diameter of the floating member **145** for retaining the wafer **W** is larger than the outer diameter of the head body **62**, the mounting space of the polishing head may be reduced by eliminating expansion of the polishing head **146** toward the outside of the wafer **W**.

The carrier fixing bolt **152b** for securing the floating member **145** to the intermediate member **147** is placed a distance apart from the polishing pad **4** by bolting the floating member **145** to the second eaves **152** of the intermediate member **147** from the upper face side. In addition, the space between the carrier fixing bolt **152b** and the polishing pad **4** is blocked by the second eaves **152** of the intermediate member **147**. Consequently, the wafer **W** and the polishing pad **4** are hardly affected by contamination with metals arising from the carrier fixing bolt **152b**.

The gap **K2** formed by the floating structure (the gap arising by variation of the volume due to displacement of the floating member **145**) is formed between the intermediate member **147** and the head body **62**, and is located a distance apart from the polishing head **4**. Since the space between the opening of the gap **K2** and the polishing pad **4** is blocked by the second eaves **152** of the intermediate member **147**, foreign substances are seldom sucked into the gap **K2**. As a result, serviceability ratio of the polishing apparatus can be improved by reducing the frequency of cleaning carried out by removing the intermediate member **147** from the head body **62** in the polishing head **146**.

The position of the floating member **145** for retaining the wafer may be adjusted by replacing the intermediate member **147** with an intermediate member having a different thickness of the portion to serve as a spacer.

Since an indicator **I** for indicating the thickness of the portion to serve as a spacer is provided on the intermediate member **147**, setting of the floating member **145** may be visually confirmed to reduce the occurrence of faulty adjustment. Since the indicator **I** is also provided at the second eaves **152** that is exposed outside of the polishing head **146** in the intermediate member **147**, and the indicator **I** is colored depending on the thickness of the portion to serve as the spacer, setting of the floating member **145** may be more easily confirmed without disassembling the polishing head **146**.

Invasion of the slurry and other foreign substances into the gap **K2** may be further reduced by covering the gap **K2** between the head body **62** and the intermediate member **147** with the cover **154** from the side. The inlet and outlet of air to the gap **K2** is directed toward upward by providing the cover **154** at the second eaves **152** to make it further difficult to suck foreign substances. In addition, since the foreign substances are pulled back toward the inside of the space with the cover **154** by gravity, even if the foreign substances be sucked in to the space with the cover **154**, the foreign substances are hardly discharged to outside.

When the floating member **145** (the carrier **148**) is bolted to the intermediate member **147** as shown in this embodiment, contamination with metals arising from the carrier fixing bolt **152b** may be effectively reduced by covering the carrier fixing bolt **152b** with the cover **154**. Moreover, since the cover **154** is not required to be expanded toward the outer circumference side of the intermediate member **147**, the outer diameter of the polishing head **146** is not also required to be large even by providing the cover **154** to enable the mounting space small.

The retainer ring fixing bolt **148c** for securing the retainer ring **123** on the carrier **148** is located on the upper face of the carrier **148** to be a distance apart from the polishing pad **4**. Further, the distance between the retainer ring fixing bolt **148c** and the polishing pad **4** is blocked with the carrier **148**, contamination with metals ascribed to the retainer ring fixing bolt **148c** may be reduced. Also, since the retainer ring fixing bolt **148c** is covered with the intermediate member **147** on the upper face of the carrier to isolate the bolt from outside, contamination with metals arising from the retainer ring fixing bolt **148c** may be further reduced.

In the seventh embodiment, the construction for mounting the elastic membrane **124** on the carrier **148** shown in the eighth embodiment may be applied to the construction for mounting the elastic membrane **124** on the lower face of the carrier **133**. In other words, The elastic membrane **124** is used in place of the elastic membrane **77**, and the fitting groove **133** is formed on the face directing toward the outer circumference side at the lower part of the outer circumference **133a** of the carrier **133**. The outer circumference **124a** of the elastic membrane **124** may be secured by inserting it between the faces directing toward the outer circumference side of the carrier **133** and the inner circumference face of the retainer ring **75**, while fitting the terminal edge **124b** of the elastic membrane **124** into the engaging groove **133**. Alternatively, the construction for attaching the elastic membrane to the carrier **133** according to the seventh embodiment may be employed as the construction for mounting the membrane on the lower face of the carrier **148** in the eighth embodiment. That is, the elastic membrane **77** is used in place of the elastic membrane **124**, and the fitting groove **133** may be eliminated from the second mounting face **132** of the carrier **148** to secure the elastic membrane **77** by inserting the outer circumference edge of the elastic membrane **77** between the first mounting face **131** of the carrier **148** and the upper face **67a** of the retainer ring **123**.

### [Ninth Embodiment]

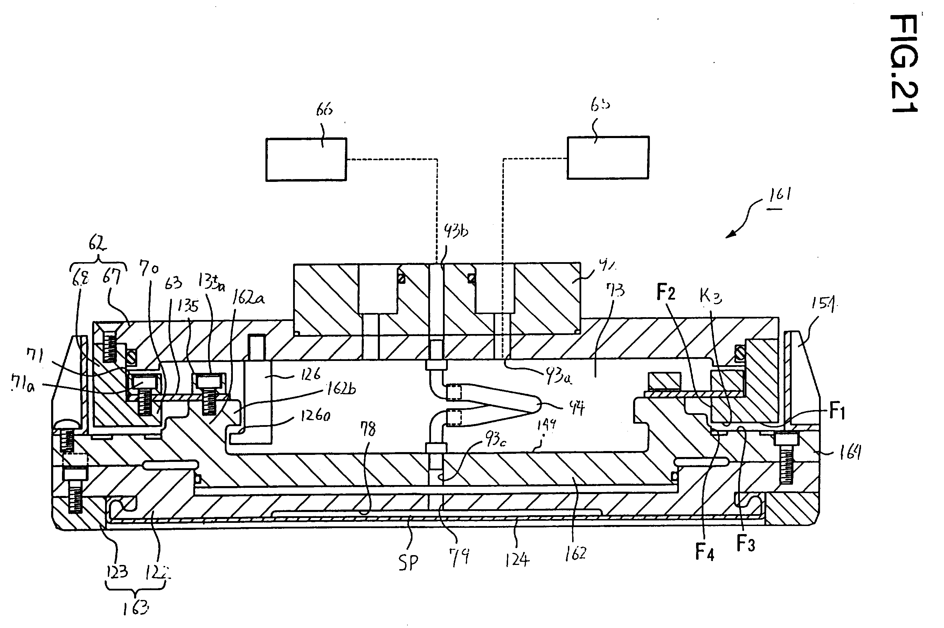

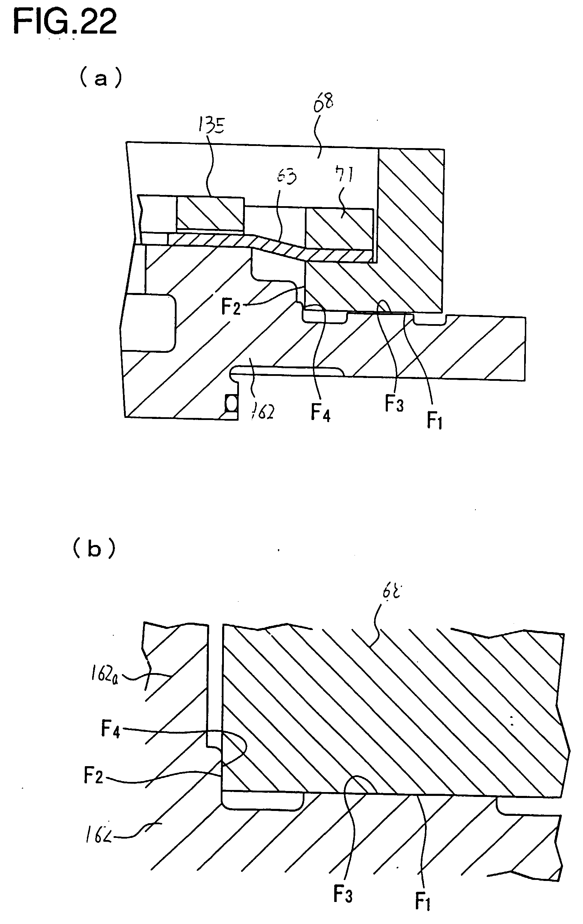

While the ninth embodiment according to the present invention is described hereinafter with reference to the drawings, the same reference numerals as used in the first to eighth embodiments are assigned to the same or similar elements in the eighth embodiments, and their explanations are omitted. The polishing apparatus according to the present invention is constructed to be approximately similar to the conventional polishing apparatus **1** shown in Fig. 27, and the polishing head **161** in the vertical cross section shown in Fig. 21 is also used herein (the polishing head **161** may be used in the polishing apparatus **1** shown in Fig. 28). Fig. 22 is a partially enlarged vertical cross section of the process for assembling the diaphragm in the polishing head **161**.

In Fig. 21, the polishing head **161** comprises a head body **62** comprising an upper mounting plate **67** and a cylindrical circumference wall **68**, a diaphragm **63** expanded in the head body **62**, an approximately disk-shaped carrier **122** secured in approximately concentric relation to the head body **62** on the lower face of the diaphragm **63**, and a retainer ring **123** provided in approximately concentric relation to the carrier **122** at the lower part of the outer circumference of the carrier **122**.

The carrier **122** is attached to the diaphragm **63** via a rigid intermediate member **162** in this embodiment.

The intermediate member **162** is an approximately disk-shaped member having a larger outer diameter than the outer diameter of the head body **62**.

The carrier **122** has a larger outer diameter than the outer diameter of the head body **62**, and retains one face of the wafer **W** via the elastic membrane **124** (to be described hereinafter) expanded over the lower face. The carrier **122**, the retainer ring **123** and the intermediate member **162** constitute a floating member **163** supported to be movable toward the head axis line direction by elastic deformation of the diaphragm **63**.

The upper mounting plate **67** of the head body **62** is secured in concentric relation to the shaft **92** for coupling with a spindle (not shown) of the polishing apparatus. First and second fluid passages **93a** and **93b** are vertically formed in the shaft **92**.

A stopper bolt **126** elongating toward the head axis line direction is provided on the lower face of the upper mounting plate **67**. A step **126a** is provided at the lower end of the stopper bolt **126** for engaging with an inner flange **162b** (to be described hereinafter) projecting out to the side and provided on the intermediate member **162**.

A step **70** is formed over the entire circumference at the lower part of the circumference wall **68**.

The lower face of the circumference wall **68** serves as a first reference face **F1** approximately perpendicular to the head axis line, and the inner face of the circumference wall **68** serves as a second reference face **F2** approximately parallel to the head axis line. The first and second reference faces **F1** and **F2** are used as references for positioning the intermediate member **162** relative to the head body **62** by allowing them to contact third and fourth reference faces **F3** and **F4** (to be described hereinafter) provided on the intermediate member **162**.

The diaphragm **63** is mounted on the head body **62** by screw-fitting the diaphragm fixing ring **71** to the step **70** with diaphragm fixing bolts **71a**, while the outer circumference of the diaphragm is inserted between the approximately annular diaphragm fixing ring **71** and the upper face of the step **70** of the circumference wall **68**.

The space between the head body **62** and the intermediate member **162** divided from the outside by the diaphragm **63** serves as a fluid chamber **73**, and its inner pressure is adjusted with the first pressure adjustment mechanism.

A tubing **94** for connecting the second fluid passage **93b** formed in the shaft **92** to the third fluid passage **93c** (to be described hereinafter) provided on the intermediate member **162** is provide in the fluid chamber **73**. The second pressure adjustment mechanism **66** is connected to the second fluid passage **93b**.

The intermediate member **162** is made of a rigid material such as stainless steel, a ceramic and an aluminum material, and is formed to be an approximately disk-shaped member having a larger outer diameter than the outer diameter of the head body **62**. The intermediate member **162** is attached in approximately concentric relation to the head body **62**, and the portion expanding out of the outer circumference side from the head body **62** serves as fourth sieves **164**.

The portion located within the opening of the head body **62** of the upper face of the intermediate member **162** is approximately in concentric relation to the intermediate member **162** to form an approximately annular projection **162a** housed in the head body **62**. A recess **149** is formed at the inner face side of the projection **162a** to be by one step lower than the outer circumference side. The space formed by the recess **149** on the upper part of the intermediate member **162** also serves as the fluid chamber **73**. A third fluid passage **93c** communicating to the lower face side of the intermediate member **162** is formed at the center of the bottom face of the recess **149**, and the tubing **94** is connected to the upper end of the third fluid passage **93c**.

The third reference face **F3** approximately perpendicular to the axis line of the intermediate member **162** is formed over the entire portion opposing to the lower face of the circumference wall **68** of the head body **62** in the upper face of the intermediate member **162**. The third reference face **F3** is able to contact the first reference face **F1** of the head body **62**, and the elevations of the head body **62** and the intermediate member **162** are positioned by allowing them to contact the first reference face **F1**.

The attachment portion (the upper face of the projection **162a**) of the diaphragm **63** in the intermediate member **162** is located at a given distance upward of the attachment portion (the upper face of the step **70** of the circumference wall **68**) of the diaphragm **63** in the head body **62**.

The portions other than the third reference face **F3** is formed to be by one step lower than the third reference face **F3** at the portion opposing to the lower face of the circumference wall **68** of the head body **62** in the upper face of the intermediate member **162**, so that the portions other than the third reference face **F3** do not come in contact with the first reference face **F1** when the third reference face **F3** contacts the first reference face **F1**.

The projection is screw-fitted to the approximately annular intermediate member fixing ring **135** disposed on the upper face of the diaphragm **63** with the intermediate member fixing bolt **135a** to insert the diaphragm **63**, thereby mounting the intermediate member on the lower face of the diaphragm **63**.

The elevation of the projection **162a** projecting out of the upper face (the upper face at the outer circumference side) of the intermediate member **162** is made to be larger than the thickness of the step **70** of the head body **62** along the head axis line direction. Accordingly, a gap **K3** that permits the intermediate member **162** to displace toward the head axis line direction is formed between the first reference face **F1** of the head body **62** and the third reference face **F3** of the intermediate member **162**, when the head body **62** is placed a distance apart from the intermediate member **162** (the disposition for actually operating the polishing head **161**) after completing positioning.

An approximately annular cover **154** covering the gap **K3** formed between the head body **62** and the intermediate member **162** from the side is provided on the upper face of the fourth eaves **164** in this embodiment, in order to block abrasive particles and other foreign substances from invading into the gap **K3**.

A fourth reference face **F4** approximately parallel to the axis line of the intermediate member **162** is formed over the entire circumference of the lower part of the side face directing toward the outer circumference side of the projection **162a**. The fourth reference face **F4** is able to contact the second reference face **F2** of the head body **62** when the head body **62** comes close to the intermediate member **162** to allow the first reference face **F1** to contact the third reference face **F3**. The fourth reference face **F4** is able to define the direction approximately perpendicular to the axis lines by contacting the second reference face **F2**, so that the axis line of the head body **62** aligns the axis line of the intermediate member **162**.

The portions other than the fourth reference face **F4** of the faces directing toward the outer circumference side of the projection **162a** is formed to be located at the inner circumference side by one step from the fourth reference face **F4**, so that the portions other than the fourth reference face **F4** do not contact the second reference face **F2** when the fourth reference face **F4** contacts the second reference face **F2**. In addition, the head body **62** does not interfere with the intermediate member **162** when the head body **62** is placed to be a distance apart from the intermediate member **162** after completing positioning. The upper part of the projection **162a** is tapered toward the lower part to have a smaller outer diameter than the outer diameter of the lower part. Consequently, a space for permitting deformation of the diaphragm **63** is secured when the intermediate member **162** displaces toward the head axis line direction.

An inner flange **162b** projecting out toward the inner circumference side is formed over the entire circumference at the upper end of the projection **162a**. The flange **162b** is able to engage with the step **162a** of the stopper bolt **126** provided in the head body **62**, so that deformation of the carrier **122** toward the head axis line direction is restricted within an appropriate range to protect the diaphragm from suffering excess load, by allowing the inner flange **162b** to engage the step **126a** of the stopper bolt **126** even when the diaphragm **63** bends downward.

The carrier **122** is to be attached on the lower face of the intermediate member **162**, and comprises a highly rigid material such as a ceramic or a lighter aluminum material, which is an approximately disk-shaped with a larger outer diameter than the outer diameter of the head body **62**.

An pressurizing pocket **78**, which is an approximately circular recess in approximately concentric relation to the carrier **122**, is formed on the lower face of the carrier **122** in approximately concentric relation to the carrier **122**. An elastic membrane **124** is expanded on the lower face of the carrier **122** so as to cover the pressurizing pocket **78**, and the wafer **W** is received by the lower face of the elastic membrane **124**. A retainer ring **123** is attached to the outer circumference of the carrier **122** by allowing its lower end to protrude downward from the lower face of the elastic membrane **124**.

A space **SP** is formed between the lower face at the inner circumference of the carrier **122** and the elastic membrane **124**. A fluid feed passage **79** communicating the upper face to the lower face is formed at the center of the carrier **122**, and the space **SP** is connected to the second pressure adjustment mechanism **66** through the fluid feed passage **79**, the third fluid passage **93c**, the tubing **94** and the second fluid passage **93b**.

The wafer **W** is supported in a floating manner independently from the retainer ring **123** by adjusting the force for pressing the wafer **W** from the floating member **163** toward the polishing pad **4** as a result of adjusting the inner pressure of the space **SP** using the second pressure adjustment mechanism **66**.

The polishing head **161** so configured as described above is attached to the polishing apparatus by coupling the shaft **92** to the spindle of the polishing apparatus.

While the procedure for assembling the polishing head **161** is described hereinafter, only the steps for assembling the diaphragm **63** as a main element of the present invention will be described herein.

At first, the intermediate member **162** is placed on the work table (the carrier **122** and the retainer ring **123** may be mounted on the intermediate member **162**).

Subsequently, the circumference wall **68** is mounted on the intermediate member **162**, and is positioned by allowing the first and second reference faces **F1** and **F2** to contact the reference faces **F3** and **F4** of the intermediate member **162** (see Fig. 22B).

Then, the diaphragm **63** is mounted so as to bridge between the upper face of the projection **162a** of the intermediate member **162** and the upper face of the step **70** of the circumference wall **68**. The intermediate member fixing ring **135** is mounted on the portion located on the projection **162a** in the diaphragm **63**, and the diaphragm **63** is secured on the intermediate member **162** by screw-fitting the intermediate member fixing ring **135** on the projection **162a** with the intermediate member fixing bolt **135a**.

Likewise, the diaphragm fixing ring **71** is mounted on the portion located on the step **70** in the diaphragm **63**, and the diaphragm **63** is secured on the circumference wall **68** by screw-fitting the diaphragm fixing ring **71** on the step **70** with the diaphragm fixing bolt **71a**. The diaphragm **63** may be attached to the circumference wall **68** in advance.

After finishing the assembling work of the diaphragm **63**, the upper mounting plate **67** is attached at the upper part of the circumference wall **68** to complete assembling of the head body **62**. When the carrier **122** and other members have not been mounted yet, they are mounted on the intermediate member **162** to assemble the floating member **163**, thereby completing the assembling work of the polishing head **161**.

Fig. 22A shows the configuration when the diaphragm **63** is mounted on both the intermediate member **162** and the circumference wall **68**. When the diaphragm **63** is mounted as shown in the drawing, the upper face of the projection **162a** of the intermediate member **162** is positioned so as to locate at upward from the upper face of the step **70** of the circumference wall **68**, and the upper face of the projection **162a** is located with a given distance apart from the upper face of the step **70** as compared with the case when these members are located on the same elevation. A prescribed degree of relaxation is assured for the diaphragm **63** when the upper face of the projection **162a** comes to the same elevation as the upper face of the step **70** by attaching the diaphragm **63** between the upper face of the projection and the upper face of the step. The floating member **163** is favorably supported in a floating manner by allowing the diaphragm **63** to relax, by permitting the range where restoration force of the diaphragm **63** is not applied, or the range where the force for allowing the floating member **163** to displace toward the polishing pad **4** is determined only by the inner pressure of the fluid chamber **73**, of the movable range of the floating member **163** toward the axis line direction to be expanded.

The floating member **163** displaces toward downward of the head axis line direction by its own weight during the polishing head is used. Since the diaphragm is supported in a floating manner at the position lower than the position when positioned in assembling the diaphragm **63**, the floating member **163** is favorably supported in a floating manner without being interfered with the head body **62** provided that displacement of the floating member **163** falls within an appropriate range.

According to the polishing head **161** so constructed as described above, the head body **62** and the floating member **163** is easily positioned for mounting the diaphragm **63** without using any jig to be exclusively used.

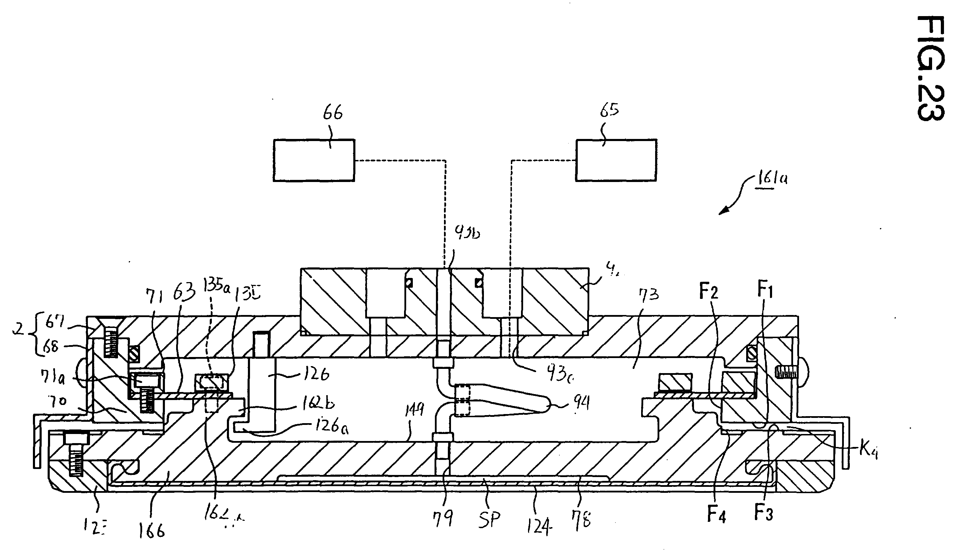

While the floating member **163** of the polishing head **161** involves the intermediate member **162** in the foregoing embodiment, the construction is not restricted thereto, but the intermediate member **162** may be omitted from the floating member **163** in the polishing head **161** as in the polishing head **161a** shown in the vertical cross section in Fig. 23, and the polishing head is constructed by directly securing the carrier to the diaphragm.

An approximately disk-shaped carrier **166** having a larger outer diameter than the outer diameter of the head body **62** is used in the case above in place of the carrier **122**. The upper part of the carrier **122** is changed to have the same construction as the intermediate member **162** in the carrier **166**. That is, the carrier **166** is attached approximately in concentric relation to the head body **62**. The portion located within the opening of the head body **62** of the upper face of the carrier is approximately in concentric relation to the carrier **166**, and an approximately ring-shaped projection **162a** to be housed in the head body **62** is formed. A recess **149** is formed at the inner circumference side of the projection **162a** by a step lower than the outer circumference side, a fluid feed passage **79** communicating to the lower face side of the carrier **166** is formed at the center of the recess **149**, and a tubing **94** is connected at the upper end of the fluid feed passage **79**.

Of the upper face of the carrier **166**, a third reference face **F3** approximately perpendicular to the axis line of the carrier **166** is formed over the entire circumference at the portion opposing to the lower face of the circumference wall **68** of the head body **62**. A fourth reference face **F4** approximately parallel to the axis line o the intermediate member **162** is formed over the entire circumference at the lower part of the side face directing toward the outer circumference side of the projection **162a**.

### [Tenth Embodiment]

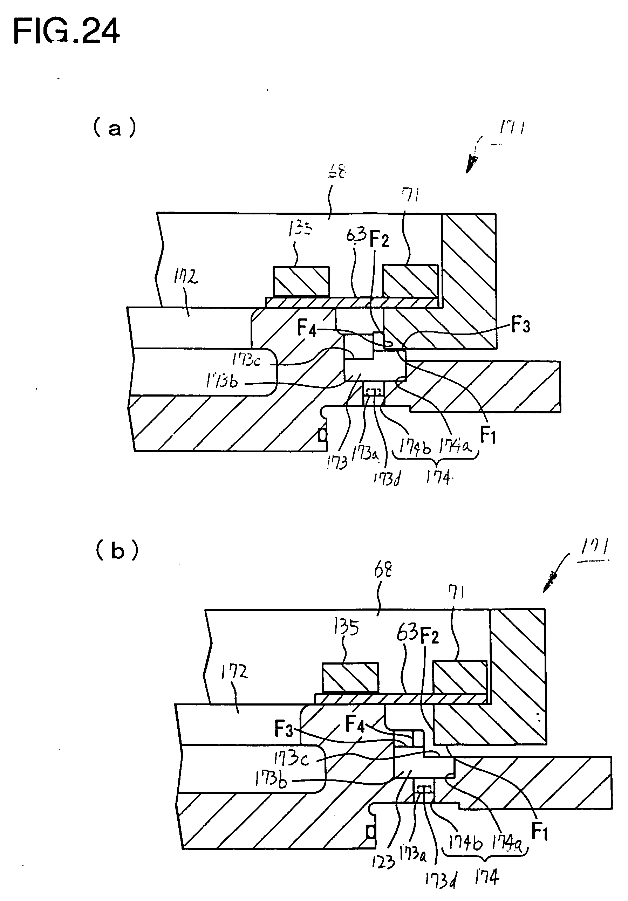

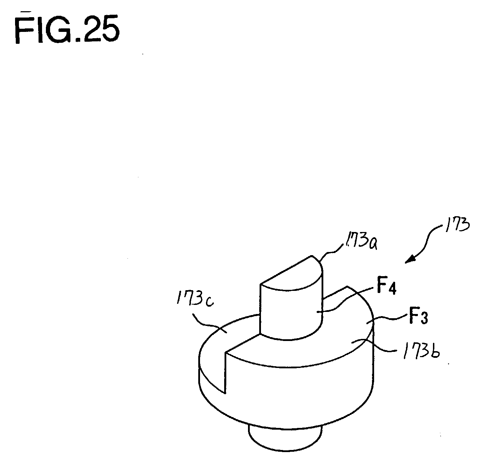

The tenth embodiment of the present invention will be described hereinafter with reference to the drawings. Figs. 24A and B are a partially enlarged vertical cross sections showing the structure of the polishing head and the process for assembling the diaphragm according to this embodiment, and Fig. 25 shows the configuration of the rotation piece used for the polishing head according to this embodiment.

An intermediate member **172** is provided in the polishing head **171** in the tenth embodiment in place of the intermediate member **162** in the polishing head **161**. The same reference numerals as used in the polishing head **161** and the intermediate member **162** in the ninth embodiment are assigned to the same or similar elements in the following descriptions. The polishing apparatus according to the present invention is constructed to be approximately similar to the conventional polishing apparatus **1** shown in Fig. 27, and the polishing head **171** is also used herein (the polishing head **171** may be used in the polishing apparatus **1** shown in Fig. 27).

In the intermediate member **172**, a movable member at least a part of which is able to advance and retreat between the lower face of the circumference wall **68** of the head body **62** and the upper face of the intermediate member is provided in the intermediate member **162**, and the third and fourth reference faces **F3** and **F4** are provided at a portion being able to advance between the lower face of the circumference wall **68** and the upper face of the intermediate member **172** in the movable member, instead of directly forming on the intermediate member **172**.

A rotation piece **173** comprising a rotation axis **173a** and an increasing tandem joint **173b** formed at an intermediate portion along the axis line of the rotation axis **173a** are used for the movable member in this embodiment as shown in Figs. 24A, 24B and 25.

A housing hole **174** for housing a part of the rotation piece **173** is formed by bridging between the position opposing to the lower face of the circumference wall **68** and the position located at the inner circumference side from the former position in the intermediate member **172**. The rotation piece **173** is housed in the housing hole **174** so that the upper face of the increasing tandem joint **173b** protrudes by a given distance out of the upper face of the intermediate member **172**, and a part along the circumference direction is opposed to the lower face of the circumference wall **68**. The housing hole **174** comprises, from the top to the bottom, an increasing tandem joint **174a** for housing the lower part of the increasing tandem joint **173b** of the rotation piece **173**, and a decreasing tandem joint **174b** for housing the portion located at downward of the increasing tandem joint **173b** of the rotation axis **173a** of the rotation piece **173**. The rotation axis **173a** is positioned by the decreasing tandem joint **174b**. The housing hole **174** is provided so as to perforate to the lower face of the intermediate member **172**.

The upper face of the increasing tandem joint **173b** serves as the third reference face **F3**, and the side face of the rotation axis **173a** serves as the fourth reference face **F4**. A cutting **173c** is formed at the upper part of the rotation piece **173**, thereby the third and fourth reference faces **F3** and **F4** are also cut to remain only a part of them along the circumference direction of the rotation piece **173**. The rotation piece **173** is enabled to allow the portion on which the cutting **173c** is formed and the portion on which the cutting **173c** is not formed to selectively advance between the lower face of the circumference wall **68** and the upper face of the intermediate member **172** by rotating around its own rotation axis. An engage member **173d** for engaging with a tool such as a screw driver and an Allen wrench is formed at the lower end of the rotation axis **173a**, thereby it is made possible to rotate the rotation piece **173** through the housing hole **174** from the lower face side of the intermediate member **172**.

A plurality of the housing holes **174** and the rotation pieces **173** are provided with an appropriate distance apart along the circumference direction of the intermediate member **172**. There are three holes and pieces with a distance apart along the circumference direction in order to position the head body **62** by three points in this embodiment.

While the procedure for assembling the polishing head **171** is described hereinafter, only the assembling work of the diaphragm as an essential element of the present invention will be described herein.

The third and fourth reference faces **F3** and **F4** are allowed to travel at the outer circumference side (the position opposed to the lower face of the circumference wall **68**) by operating the rotation piece **173** of the intermediate member **172**, and the intermediate member **172** is mounted on the work table.

Subsequently, the circumference wall **68** is mounted on the upper face of the intermediate member **172** to position the first and second reference faces **F1** and **F2** of the circumference wall **68** by allowing them to contact the third and fourth reference faces **F3** and **F4** of the intermediate member **172** (see Fig. 24A).

Positioning is performed while the circumference wall **68** is placed a distance apart from the intermediate member **172**.

The diaphragm **63** is mounted so as to bridge between the upper face of the projection **162a** of the intermediate member **172** and the step **70** of the circumference wall **68**, and the diaphragm **63** is secured to the circumference wall **68** and the intermediate member **172**.

After completing the assembling work of the diaphragm **63**, the head body **62** is assembled by mounting the upper mounting plate **67** at the upper part of the circumference wall **68**. The portion where the cutting is formed is allowed to travel to the position opposed to the lower face of the circumference wall **68**, by allowing the rotation piece **173** to rotate by operating a tool which is operated by engaging with the engage member **173d** through the housing hole **174** from the lower face of the intermediate member **172**.

The circumference wall **68** is made possible to advance into the cutting **173c**, and a margin is assured between the circumference wall **68** and the intermediate member **172** along the direction to be closer than the positioning site of these members (see Fig. 24b).

The assembling work of the polishing head **171** is completed by mounting the carrier **122** and other members on the intermediate member **172**.

According to the polishing head **171** so configured as described above, the head body **62** and the floating member **163** may be easily positioned in assembling the diaphragm **63** without using any exclusive use jigs.

Since a margin is secured between the circumference wall **68** and the intermediate member **172** along the direction closer to the position where these members have been positioned, they are hardly interfered with the head body when they are displaced toward the head axis direction during polishing, thereby allowing the floating member to be favorably supported in a floating manner.

The margin is secured between the circumference wall **68** and the intermediate member **172** without making the structure of the polishing head **171** complex to enable the manufacturing cost of the polishing head **171** to be reduced.

The rotation piece **173** is provided to allow its axis line to be approximately parallel to the axis line of the intermediate member **172** in this embodiment. Either the portion where the third and fourth reference faces **F3** and **F4** are formed, or the portion where the cutting **173c** is formed is selectively projected out of the side of the gap formed between the head body **62** and the intermediate member **172** in this example. However, the construction is not restricted to those above, but the rotation piece **173** is provided so that its axis line is directed toward the direction approximately perpendicular to the axis line of the intermediate member **172**, and the third reference face **F3** is directed toward the outer circumference side of the intermediate member **172**. As a result, either the portion where the third and fourth reference faces **F3** and **F4** are formed, or the portion where the cutting **173c** is formed may be selectively projected out of the upper face of the intermediate member **172** by allowing the rotation piece **173** to rotate around its axis line. The head body **62** and the intermediate member **172** is positioned in this case by allowing the third reference face **F3** and the fourth reference face **F4** to contact the second reference face **F2** and the first reference face **F1**, respectively. A margin is secured between the circumference wall **68** and the intermediate member **172** by allowing the portion where the cutting **173c** is formed to project out of the upper face of the intermediate member **172**.

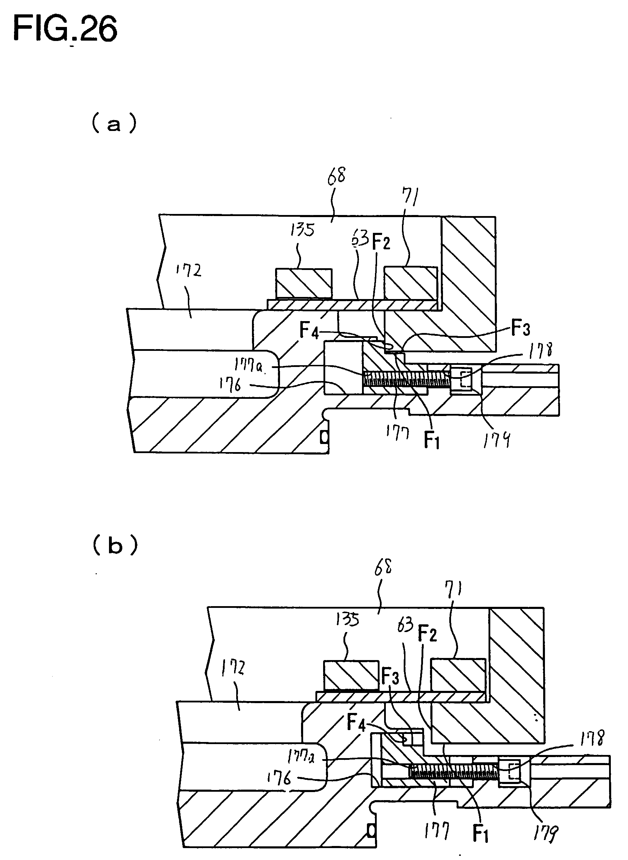

While the rotation piece **173** is used for the movable member in the foregoing embodiment, the constriction is not always restricted thereto, but the housing hole **176** may be provided so that it is elongated from the position opposing to the circumference wall **68** of the head body **62** to the inner circumference side along the radial direction of the intermediate member **172** of the upper face of the intermediate member **172** as shown in Figs. 26A and 26B. A positioning piece **177** (a movable member), which is movable toward the longitudinal direction of the housing hole **176**, is provided in the housing hole **176** by projecting a part of it out of the upper face of the intermediate member **172**. At least two steps are provided on the positioning piece **177**. These steps are formed so that the degree of projection from the upper face of the intermediate member **172** gradually reduces from the side located at the inner circumference side toward the outer circumference direction of the intermediate member **172**. The portion at the lowest site of the upper face of the positioning piece **177** is formed to have the same elevation as the upper face of the intermediate member **172**, or to locate lower than it. The face directing toward upward of the highest step of these steps serves as the second reference face **F3**, and the face directing toward the outer circumference side of the intermediate member **172** serves as the fourth reference face **F4**. The circumference wall **68** of the head body **62** and the intermediate member **172** are positioned by allowing the portion on which the third reference face **F3** is formed to advance between the circumference wall **68** and the intermediate member **172**, after allowing the positioning piece **177** to travel along the housing hole **176** (see Fig. 26A). A margin is secured, on the other hand, between the circumference wall **68** and the intermediate member **172** by allowing the portion on which the third reference face **F3** is formed to shunt from the space between the circumference wall **68** and the intermediate member **172** (see Fig. 26B).

The mechanism for allowing the positioning piece **177** to travel along the housing hole **176** comprises the bolt insertion hole **178** formed from the outer circumference face of the intermediate member **172** toward the inner circumference, a threaded hole **177a** provided in the positioning piece **177** coaxial to the bolt insertion hole **178**, and a bolt **179** inserted from he outer circumference side of the intermediate member **172** through the bolt insertion hole **178** and the threaded hole **177a**. The bolt **179** is screwed into the threaded hole **177a**, and restricts movement of the positioning piece along the axis line direction of the bolt insertion hole. The positioning piece **177** is allowed to travel toward the axis line direction of the bolt **179**, or toward the radial direction of the intermediate member **172**, by turning the bolt **179**. The bolt **179** is protected from being exposed outside by providing the bolt **179** at an intermediate position of the bolt insertion hole **178** in Figs. 26A and 26B, so that the polishing pad **4** and the wafer **W** seldom suffers contamination with metals ascribed to the bolt **179**.

The present invention is not restricted to the embodiments as set forth herein, but involves various modifications including combinations of the embodiments as set forth above.

## Claims

1. A polishing head comprising:
a head body comprising an upper mounting plate (bridge) and a cylindrical circumference wall provided at downward of the outer circumference of the upper mounting plate;
a diaphragm vertically provided against a head axis line in the head body;
a disk-shaped carrier secured to the diaphragm and provided to be able to displace toward the head axis line direction together with the diaphragm, one face of a polishing object to be polished being retained on the lower face of the carrier;
a first pressure adjustment mechanism for adjusting the pressure of a liquid filled in a fluid chamber formed between the carrier and the head body; and
a retainer ring disposed in concentric relation between the lower face of the carrier and the inner wall of the circumference wall, besides being provided at an approximately the same elevation as the lower face of the carrier to contact the polishing pad during polishing,
the retainer ring being secured to the carrier,
an elastic membrane being attached to the lower face of the carrier, and
the elastic membrane being secured with its circumference edge being inserted between the retainer ring and the carrier,
characterized in that the carrier comprises a fluid feed passage for feeding a pressure-variable fluid between the elastic membrane and the carrier.

2. A polishing head according to Claim 1, characterized in that the fluid feed passage is connected to a second pressure adjustment mechanism for adjusting the pressure of the fluid fed between the elastic membrane and the carrier.

3. A polishing head comprising:
a head body comprising an upper mounting plate and a cylindrical circumference wall provided at downward of the outer circumference of the upper mounting plate;
a diaphragm vertically expanded against a head axis line in the head body;
a first pressure adjustment mechanism for adjusting the pressure of a liquid filled in a fluid chamber formed between the diaphragm and the head body;
a carrier fixed to the diaphragm and provided to be able to displace toward the head axis line direction together with the diaphragm, one face of a polishing object to be polished being retained on the lower face of the carrier; and
a retainer ring disposed in concentric relation between the inner wall of the circumference wall and the outer circumference of the carrier, besides being secured to the diaphragm and provided so as to be able to displace toward the head axis line direction together with the diaphragm, the retainer ring contacting the polishing pad during polishing,
an elastic membrane being expanded over an area surrounded by the retainer ring on the lower surface of the carrier, and
the carrier comprising a fluid feed passage for feeding a fluid between the lower face of the carrier and the elastic membrane,
characterized in that a second pressure adjustment mechanism for adjusting the fluid pressure fed between the lower face of the carrier and the elastic membrane is connected to the fluid feed passage.

4. A polishing head comprising:
an elastic membrane expanded at the tip of the head for receiving the polishing object on its lower face;
a pressure adjustment mechanism for adjusting the gas pressure by feeding or sucking a gas at the upper face side of the elastic membrane;
a pressure gauge for measuring the gas pressure at the upper face side of the elastic membrane; and
a detector for sensing that at least the polishing object is not properly retained or the polishing object is cracked based on the observation result that the measured pressure does not attain a reference pressure by comparing the measured pressure of the pressure gauge with respective reference pressures when the gas is fed and sucked by the pressure adjustment mechanism,
characterized in that the elastic membrane comprises a gas permeable and water proof material that permits a gas to permeate but prohibits a liquid from permeating.

5. A polishing head according to Claim 4, characterized in that the outer circumference portion of the elastic membrane including the portion for receiving the outer circumference of the polishing object is so configured as to be airtight that also prohibits a gas from permeating.

6. A polishing apparatus comprising:
a platen on the surface of which a polishing pad is adhered; and
a polishing head for retaining one face of a polishing object to be polishing to allow the other face to contact the polishing pad,
characterized in that the polishing object is polished by a relative movement between the platen and the polishing object while the polishing object is allowed to contact the polishing pad,
the polishing apparatus comprising the polishing pad according to Claim 4.

7. A polishing head comprising a carrier provided with a recess on the lower face as a face at the side for retaining a polishing object, and a flexible member provided on the lower face of the carrier for dividing the recess from the outside to form a space while receiving the polishing object on its lower face, characterized in that a pressure adjustment mechanism is connected to the recess of the carrier, said pressure adjustment mechanism adjusting the pressure in the space to reduce the pressure in the space to be lower than the atmospheric pressure for retaining the polishing object, thereby allowing the flexible member to depress toward the inside of the recess to serve as a suction cup for absorbing the polishing object,
the carrier comprising a fluid feed passage for connecting the pressure adjustment mechanism and the recess provided at almost the center of the recess, and
the flexible member being further depressed toward the inside of the recess by the suction pressure of the pressure adjustment mechanism when the polishing object is not adhered on the lower face of the flexible member to close the fluid feed passage while a space is remaining at the outer circumference of the recess,
characterized in that the polishing head further comprising:
a differential pressure measuring device for measuring the differential pressure between the suction pressure of the pressure adjustment mechanism and the inner pressure of the space at the outer circumference of the recess; and
a detector for sensing whether the polishing object is retained or not by sensing the differential pressure with the differential pressure measuring device.

8. A polishing head according to Claim 7 comprising a plurality of the recesses provided on the lower face of the carrier, a plurality of spaces being formed by the plural recesses and the elastic membrane,
the recess comprising the pressure adjustment mechanism connected through the respective liquid feed passages as well as the differential pressure measuring device,
characterized in that the detector is so configured as to sense whether the polishing object is retained or not by the number of the spaces among the plural spaces where differential pressure between the suction pressure of the pressure adjustment mechanism and the inner pressure in the space at the outer circumference of the recess is sensed by the differential pressure measuring device.

9. A polishing head according to Claim 8, characterized in that the sensor is so configured as to sense whether the polishing object is retained or not by considering the positional relation of the spaces among the plural spaces where differential pressure between the suction pressure of the pressure adjustment mechanism and the inner pressure in the space at the outer circumference of the recess is sensed by the differential pressure measuring device.

10. A polishing apparatus comprising:
a platen on the surface of which a polishing pad is adhered; and
a polishing head for retaining one face of the polishing object to be polished to allow the other face to contact the polishing pad,
characterized in that the polishing object is polished by a relative movement between the platen and the polishing object while allowing the polishing object to contact the polishing pad,
the polishing apparatus further comprising the polishing head according to Claim 7.

11. A polishing apparatus comprising a platen on the surface of which a polishing pad is adhered, a polishing head for retaining one face of the polishing object to allow the other face of the polishing object to contact the polishing pad, and a head drive mechanism for polishing the other face of the polishing object by driving the polishing head,
the polishing head comprising a head body comprising an upper mounting plate and a cylindrical circumference wall provided at downward of the outer circumference of the upper mounting plate, a diaphragm expanded in the head body, and an approximately disk-shaped carrier secured to the diaphragm to displace toward the head axis line direction together with the diaphragm while retaining one face of the polishing object,
the lower face of the carrier comprising a recess and an elastic membrane for forming a space by dividing the recess from the outside of the recess,
a pressure adjustment mechanism being connected to the recess, the pressure adjustment mechanism adjusting the inner pressure of the space to adjust the back-pressure for allowing the elastic membrane to press the polishing object onto the polishing pad by receiving the inner pressure,
the carrier comprising a retainer ring integrally attached at the outer circumference by allowing its lower end to protrude out of the lower face of the carrier,
the outer circumference of at least one of the carrier or the retainer ring and the inner face of the head body comprising an engage member for allowing the carrier or the retainer ring to engage with the head body so as to restrict relative rotation between the carrier or the retainer ring and the head body around the head axis line as a center of rotation caused by the frictional resistance suffering from the polishing pad,
the polishing apparatus further comprising:
a sensor provided between the engage members for measuring the force along the direction of rotation applied among the engage members; and
a computing unit for calculating the polishing resistance received by the retainer ring from the measured value by the censor while the back-pressure of the polishing object is released by reducing the inner pressure of the space.

12. A polishing apparatus according to Claim 11,
characterized in that the computing unit calculates the total polishing resistance received by the polishing object retained on the carrier and the retainer ring based on the measured value by the sensor while the polishing object is pressed onto the polishing pad by increasing the inner pressure of the space by means of the pressure adjustment mechanism, and
the polishing resistance received by the polishing object is calculated from the difference between the total polishing resistance and the polishing resistance received by the retainer ring.

13. A method for sensing polished state using a polishing apparatus comprising a platen on the surface of which a polishing pad is adhered, a polishing head for retaining one face of a polishing object to allow the polishing pad to contact the other face of the polishing object, and a head drive mechanism for polishing the other face of the polishing object by allowing the polishing head to drive,
the polishing head comprising a head body comprising an upper mounting plate and a cylindrical circumference wall provided at downward of the outer circumference of the upper mounting plate, a diaphragm expanded in the head body, and an approximately disk-shaped carrier secured to the diaphragm to displace toward the axis line direction together with the diaphragm while retaining one face of the polishing object,
the lower face of the carrier comprising a recess, and an elastic membrane for forming a space by dividing the recess from the outside of the recess,
a pressure adjustment mechanism being connected to the recess, said pressure adjustment mechanism adjusting the inner pressure to adjust the back-pressure for allowing the elastic membrane to press the polishing object onto the polishing pad by receiving the inner pressure,
the outer periphery of the carrier comprising an integrated retainer ring with its lower end protruding out of the lower face of the carrier,
the polishing apparatus further comprising:
an engage member, at the outer circumference of either the carrier or the retainer ring and on the inner face of the head body, for allowing the carrier or the retainer ring to engage with the head body so as to restrict relative rotation around the head axis line as a center of rotation; and
a sensor provided among the engage members to measure the force along the direction of rotation acting among the carrier or the retainer ring and the head body,
characterized in that the polishing resistance received by the retainer ring is calculated with a computing unit using the measured value from the sensor while the back-pressure of the polishing object is released by reducing the inner pressure of the space using the pressure adjustment mechanism, thereby sensing the surface state of the polishing pad.

14. A method for sensing polished state according to Claim 13,
characterized in that the total polishing resistance received by the polishing object retained on the carrier and by the retainer ring is calculated with a computing unit using the measured value of the sensor while the polishing object is pressed onto the polishing pad by increasing the inner pressure of the space using the pressure adjustment mechanism, and
the polishing resistance received by the polishing object is calculated with the computing unit from the difference between the total polishing resistance and the polishing resistance received by the retainer ring.

15. A polishing head to be used for a polishing apparatus for polishing a polishing object by allowing one face of the polishing object to contact a polishing pad adhered on a platen followed by a relative movement between the polishing pad and the polishing object, and for retaining the polishing object to allow it to contact the polishing pad, comprising:
a head body comprising an upper mounting plate and a cylindrical circumference wall provided at downward of the outer circumference of the upper mounting plate,
a diaphragm expanded in the head body,
a floating member for retaining the polishing object provided on the diaphragm so as to be able to displace toward the head axis line direction together with the diaphragm, and
a first pressure adjustment mechanism for adjusting the inner pressure of a fluid chamber formed by being divided from the outside by the diaphragm provided between the head body and the floating member,
characterized in that the floating member is provided to be approximately in concentric relation to the head body and formed into an approximate disk-shape having an outer diameter larger than the outer diameter of the head body.

16. A polishing head according to Claim 15, characterized in that the floating member comprises an approximately disk-shaped carrier disposed to be in an approximately concentric relation to the head body, and a retainer ring attached in an approximately concentric relation to the outer circumference of the carrier and contacting the polishing pad during polishing of the polishing object to engage by holding the periphery of the polishing object,
the lower face of the carrier comprising a flexible elastic membrane for forming a space between the membrane and the lower face of the carrier and receiving the polishing object on its lower face, and
a second pressure adjustment mechanism being connected to the carrier, said pressure adjustment mechanism adjusting the force for pressing the polishing object onto the polishing pad by adjusting the pressure in the space.

17. A polishing head to be used for a polishing apparatus for polishing a polishing object by allowing one face of the polishing object to contact a polishing pad adhered on a platen followed by a relative movement between the polishing pad and the polishing object, and for retaining the polishing object to allow it to contact the polishing pad, comprising:
a head body comprising an upper mounting plate and a cylindrical circumference wall provided at downward of the outer circumference of the upper mounting plate;
a diaphragm expanded in the head body;
a floating member provided on the diaphragm to be able to displace along the head axis line direction together with the diaphragm for retaining the polishing object; and
a first pressure adjustment mechanism for adjusting the inner pressure of a fluid chamber formed by being divided from outside between the head body and the floating member,
a rigid intermediate member being inserted between the diaphragm and the floating member, and
the floating member being attached to be attachable to and detachable from the intermediate member.

18. A polishing head according to Claim 17, characterized in that the floating member comprises a carrier, and a retainer ring attached to the outer circumference of the carrier and contacting the polishing pad during polishing of the polishing object for engaging by holing the periphery of the polishing object,
the lower face of the carrier comprising a flexible elastic membrane for forming a space between the membrane and the lower face of the carrier and receiving the polishing object on its lower face, and
a second pressure adjustment mechanism connected to the carrier, said pressure adjustment mechanism adjusting the force for pressing the polishing object onto the polishing pad by adjusting the pressure in the space.

19. A polishing head to be used for a polishing apparatus for polishing a polishing object by a relative movement between the polishing pad and the polishing object by allowing one face of the polishing object to contact the polishing pad adhered on a platen, and for retaining the polishing object to allow it to contact the polishing pad, comprising:
a head body comprising an upper mounting plate and a cylindrical circumference wall provided at downward of the upper mounting plate;
a diaphragm expanded in the head body;
a floating member provided on the diaphragm so as to be able to displace along the head axis line direction together with the diaphragm for retaining the polishing object; and
a pressure adjustment mechanism for adjusting the inner pressure formed by being divided from the outside with the diaphragm between the head body and the floating member,
characterized in that the head body and the floating member comprise reference faces for positioning the head body and the floating member in assembling the diaphragm by allowing one reference face to contact the other reference face provided on the head body and the floating member, respectively.

20. A polishing head according to Claim 19,
characterized in that at least one of the head body or the floating member comprises a movable member at least a part of which is made to be able to advance or retreat between the head body and the floating member,
the reference face being provided at a portion advancing between the head body and the floating member in the movable member.
